# EUROPEAN PATENT APPLICATION

(11) **EP 4 832 713 A1**
(43) Date of publication of application: **28.10.2026**
(21) Application number: 25738367.9
(22) Date of filing: 06.01.2025
(51) Int. Cl.: H10K 59/12, G09G 3/3233

(54) **DISPLAY SUBSTRATE AND MANUFACTURING METHOD THEREFOR, AND DISPLAY APPARATUS**

(30) Priority: 08.01.2024 CN 202410028796
(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Daxing District Beijing 100176 (CN)
(72) Inventor: DENG, Kaijie, Beijing 100176 (CN); TAO, Xuan, Beijing 100176 (CN); WANG, Yanli, Beijing 100176 (CN); LIU, Lang, Beijing 100176 (CN); WANG, Qiwei, Beijing 100176 (CN); DONG, Xiangdan, Beijing 100176 (CN)
(74) Representative: Durán-Corretjer, S.L.P.
(86) International application number: PCT/CN2025/070798
(87) International publication number: WO 2025/148836

(57) **Abstract**

A display substrate and a manufacturing method therefor, and a display apparatus. The display substrate comprises a plurality of circuit units, each of which comprises a pixel driving circuit, wherein the pixel driving circuit at least comprises a driving transistor, a first reset transistor, a data writing transistor, a light emission control transistor, a first capacitor, and a second capacitor, a first electrode of the first reset transistor being connected to a reference signal line, a second electrode of the first reset transistor being connected to a gate electrode of the driving transistor, a first electrode of the light emission control transistor being connected to a first power line, a second electrode of the light emission control transistor being connected to a first electrode of the driving transistor, a second electrode of the driving transistor being connected to a second electrode plate of the first capacitor, a first electrode of the data writing transistor being connected to a data signal line, and a second electrode of the data writing transistor being connected to a fourth electrode plate of the second capacitor; and the driving transistor being an oxide transistor, and the width-to-length ratio of the driving transistor being 1.25 to 2.67.

## Description

The present application claims priority to Chinese Patent Application No. 202410028796.5 filed to the CNIPA on January 08, 2024 and entitled "Display Substrate and Manufacturing method Therefor, and Display Apparatus", contents of which should be construed as being incorporated into the present application by reference.

### Technical Field

The present disclosure relates to, but is not limited to, the field of display technologies, and particularly to a display substrate and a manufacturing method therefor, and a display apparatus.

### Background

An organic light emitting diode (OLED) and a quantum dot light emitting diode (QLED) are active light emitting display devices and have advantages of self-illumination, a wide viewing angle, a high contrast ratio, low power consumption, an extremely high reaction speed, lightness and thinness, flexibility, and a low cost, etc. With constant development of display technologies, a flexible display device (Flexible Display) in which an OLED or a QLED is used as a light emitting device and signal control is performed through a thin film transistor (TFT) has become a mainstream product in the field of display at present.

### Summary

The following is a summary of subject matters described herein in detail. This summary is not intended to limit the protection scope of claims.

In one aspect, the present disclosure provides a display substrate including a plurality of circuit units, a plurality of data signal lines extending along a second direction, a plurality of first data connection lines extending along a first direction, and a plurality of second data connection lines extending along the second direction. One end of at least one first data connection line is connected to a data signal line of the plurality of data signal lines and the other end of the at least one first data connection line is connected to a second data connection line of the plurality of second data connection lines, the first direction and the second direction intersect; at least one circuit unit includes a pixel drive circuit at least including a drive transistor, a first reset transistor, a data writing transistor, a light emitting control transistor, a first capacitor including a first electrode plate and a second electrode plate, and a second capacitor including a third electrode plate and a fourth electrode plate; a first electrode of the first reset transistor is connected to a reference signal line, a second electrode of the first reset transistor is connected to a gate electrode of the drive transistor, a first electrode of the light emitting control transistor is connected to a first power supply line, a second electrode of the light emitting control transistor is connected to a first electrode of the drive transistor, a second electrode of the drive transistor is connected to the second electrode plate of the first capacitor, a first electrode of the data writing transistor is connected to the data signal line, a second electrode of the data writing transistor is connected to the fourth electrode plate of the second capacitor, the first electrode plate of the first capacitor is connected with the third electrode plate of the second capacitor; the drive transistor is an oxide transistor, and a width-to-length ratio of the drive transistor is 1.25 to 2.67.

In an exemplary embodiment, an orthographic projection of the data signal line on a base substrate is not overlapped with orthographic projections of channel regions of the drive transistor, the first reset transistor, the data writing transistor, and the light emitting control transistor on the base substrate.

In an exemplary embodiment, in the at least one circuit unit, the data signal line includes at least one straight line segment, and at least one bending segment configured to increase an extension length of the data signal line.

In an exemplary embodiment, at least one second data connection line is disposed between two first power supply lines adjacent in the first direction, or at least one second data connection line is disposed between two data signal lines adjacent in the first direction.

In an exemplary embodiment, in at least one circuit unit and a circuit unit adjacent to the at least one circuit unit in the first direction, first power supply lines of two circuit units are of an interconnected integral structure.

In an exemplary embodiment, the at least one circuit unit further includes a first power supply connection line extending along the first direction, the first power supply line is in a shape of a straight line or a bend line extending along the second direction, and the first power supply line is connected to the first power supply connection line to form a net-like structure for transmitting a first power supply signal.

In an exemplary embodiment, the at least one circuit unit further includes a second power supply line having a width larger than a width of the first power supply line, and the width is a dimension in the first direction.

In an exemplary embodiment, the display substrate further includes a plurality of auxiliary cathodes disposed on a side of the second power supply line away from a base substrate, an orthographic projection of at least one auxiliary cathode on the base substrate is at least partially overlapped with an orthographic projection of the second power supply line on the base substrate, the auxiliary cathode is connected to the second power supply line through an auxiliary via, and the auxiliary cathode is configured to be connected to a cathode of a light emitting device.

In an exemplary embodiment, an orthographic projection of the first power supply line on a base substrate is at least partially overlapped with orthographic projections of the first reset transistor and the data writing transistor on the base substrate, and an orthographic projection of the second power supply line on the base substrate is at least partially overlapped with orthographic projections of the drive transistor and the light emitting control transistor on the base substrate.

In an exemplary embodiment, wherein the at least one circuit unit further includes a data connection electrode connected to the first data connection line, the second data connection line is connected to the data connection electrode through a via; the at least one circuit unit further includes a dummy electrode to which the second data connection line is connected through a via, and a position and a shape of the dummy electrode in one circuit unit is the same as a position and a shape of the data connection electrode in another circuit unit.

In an exemplary embodiment, in a direction perpendicular to a base substrate, the display substrate at least includes a first source-drain metal layer and a second source-drain metal layer sequentially disposed along a direction away from the base substrate, the first data connection line is disposed in the first source-drain metal layer; a first fracture is provided on at least one first data connection line, the first fracture severs the at least one first data connection line, and an orthographic projection of the first fracture on the base substrate is at least partially overlapped with an orthographic projection of the second source-drain metal layer on the base substrate.

In an exemplary embodiment, in a direction perpendicular to a base substrate, the display substrate at least includes a first source-drain metal layer and a second source-drain metal layer sequentially disposed along a direction away from the base substrate, the second data connection line is disposed in the second source-drain metal layer; a second fracture is provided on at least one second data connection line, the second fracture severs the at least one second data connection line, and an orthographic projection of the second fracture on the base substrate is at least partially overlapped with an orthographic projection of the first source-drain metal layer on the base substrate.

In an exemplary embodiment, the pixel drive circuit further includes a second reset transistor, a third reset transistor, and a data control transistor; a first electrode of the second reset transistor is connected to the reference signal line, and a second electrode of the second reset transistor is connected to the first electrode plate of the first capacitor and the third electrode plate of the second capacitor; a first electrode of the third reset transistor is connected to an initial signal line, and a second electrode of the third reset transistor is connected to the second electrode of the drive transistor; a first electrode of the data control transistor is connected to the gate electrode of the drive transistor, and a second electrode of the data control transistor is connected to the second electrode of the data writing transistor; the first reset transistor, the second reset transistor, the third reset transistor, the data writing transistor, the light emitting control transistor and the data control transistor are oxide transistors.

In an exemplary embodiment, the first reset transistor at least includes a first bottom gate electrode and a first top gate electrode, in at least one circuit unit and a circuit unit adjacent to the at least one circuit unit in the first direction, first bottom gate electrodes in two circuit units are of an interconnected integral structure, and first top gate electrodes in two circuit units are of an interconnected integral structure; and/or, the data writing transistor at least includes a fourth bottom gate electrode and a fourth top gate electrode, in at least one circuit unit and a circuit unit adjacent to the at least one circuit unit in the first direction, fourth bottom gate electrodes in two circuit units are of an interconnected integral structure, and fourth top gate electrodes in two circuit units are of an interconnected integral structure; and/or the data control transistor at least includes a sixth bottom gate electrode and a sixth top gate electrode, in at least one circuit unit and a circuit unit adjacent to the at least one circuit unit in the first direction, sixth bottom gate electrodes in two circuit units are of an interconnected integral structure, and sixth top gate electrodes in two circuit units are of an interconnected integral structure.

In an exemplary embodiment, a first bottom gate connection block is provided on the first bottom gate electrode, a first top gate connection block is provided on the first top gate electrode, the first bottom gate connection block is configured to be connected to a first scan signal line through a first bottom gate connection via, and the first top gate connection block is configured to be connected to the first scan signal line through a first top gate connection via, in at least one circuit unit and a circuit unit adjacent to the at least one circuit unit in the first direction, two circuit units share the first bottom gate connection via, two circuit units share the first top gate connection via; and/or a fourth bottom gate connection block is provided on the fourth bottom gate electrode, a fourth top gate connection block is provided on the fourth top gate electrode, the fourth bottom gate connection block is configured to be connected to a third scan signal line through a fourth bottom gate connection via, the fourth top gate connection block is configured to be connected to the third scan signal line through a fourth top gate connection via, in at least one circuit unit and a circuit unit adjacent to the at least one circuit unit in the first direction, two circuit units share the fourth bottom gate connection via, and two circuit units share the fourth top gate connection via; and/or a sixth bottom gate connection block is provided on the sixth bottom gate electrode, a sixth top gate connection block is provided on the sixth top gate electrode, the sixth bottom gate connection block is configured to be connected to a fourth scan signal line through a sixth bottom gate connection via, the sixth top gate connection block is configured to be connected to the fourth scan signal line through a sixth top gate connection via, in at least one circuit unit and a circuit unit adjacent to the at least one circuit unit in the first direction, two circuit units share the sixth bottom gate connection via, and two circuit units share the sixth top gate connection via.

In an exemplary embodiment, the second reset transistor at least includes a second bottom gate electrode and a second top gate electrode, and in at least one circuit unit, a first bottom gate electrode and the second bottom gate electrode are of an interconnected integral structure, and a first top gate electrode and the second top gate electrode are of an interconnected integral structure.

In an exemplary embodiment, the first reset transistor at least includes a first active layer, and in at least one circuit unit and a circuit unit adjacent to the at least one circuit unit in the first direction, first active layers in two circuit units are of an interconnected integral structure.

In an exemplary embodiment, the reference signal line is connected to a first region of the first active layer through a first active via, and in at least one circuit unit and a circuit unit adjacent to the at least one circuit unit in the first direction, two circuit units share the first active via.

In an exemplary embodiment, the third reset transistor at least includes a seventh active layer, and in at least one circuit unit and a circuit unit adjacent to the at least one circuit unit in the first direction, seventh active layers in two circuit units are of an interconnected integral structure.

In an exemplary embodiment, the initial signal line is connected to a first region of the seventh active layer through a seventh active via, and in at least one circuit unit and a circuit unit adjacent to the at least one circuit unit in the first direction, two circuit units share the seventh active via.

In another aspect, a display apparatus is further provided in the present disclosure, and the display apparatus includes the display substrate described above.

In yet another aspect, the present disclosure also provides a manufacturing method for a display substrate. The display substrate includes a plurality of circuit units, a plurality of data signal lines extending along a second direction, a plurality of first data connection lines extending along a first direction, and a plurality of second data connection lines extending along the second direction, one end of at least one first data connection line is connected to a data signal line of the plurality of data signal lines and the other end of the at least one first data connection line is connected to a second data connection line of the plurality of second data connection lines, the first direction and the second direction intersect.

The manufacturing method includes: forming a pixel drive circuit within at least one circuit unit, wherein the pixel drive circuit at least includes a drive transistor, a first reset transistor, a data writing transistor, a light emitting control transistor, a first capacitor including a first electrode plate and a second electrode plate, and a second capacitor including a third electrode plate and a fourth electrode plate; a first electrode of the first reset transistor is connected to a reference signal line, a second electrode of the first reset transistor is connected to a gate electrode of the drive transistor, a first electrode of the light emitting control transistor is connected to a first power supply line, a second electrode of the light emitting control transistor is connected to a first electrode of the drive transistor, a second electrode of the drive transistor is connected to the second electrode plate of the first capacitor, a first electrode of the data writing transistor is connected to the data signal line, a second electrode of the data writing transistor is connected to the fourth electrode plate of the second capacitor, the first electrode plate of the first capacitor is connected with the third electrode plate of the second capacitor; the drive transistor is an oxide transistor, and a width-to-length ratio of the drive transistor is 1.25 to 2.67.

Other aspects of the present disclosure may be comprehended after the drawings and the detailed descriptions are read and understood.

### Brief Description of Drawings

Accompanying drawings are used to provide an understanding of technical solutions of the present disclosure, and form a part of the specification. The accompanying drawings and embodiments of the present disclosure are adopted to explain the technical solutions of the present disclosure, and do not form limitations on the technical solutions of the present disclosure.
FIG. 1 is a schematic diagram of a structure of a display apparatus.
FIG. 2 is a schematic diagram of a structure of a display substrate.
FIG. 3A is a schematic diagram of a planar structure of a display region in a display substrate.
FIG. 3B is a schematic diagram of a planar structure of a display region in another display substrate.
FIG. 4 is a schematic diagram of a cross-sectional structure of a display region in a display substrate.
FIG. 5 is an equivalent circuit diagram of a pixel drive circuit according to an exemplary embodiment of the present disclosure.
FIG. 6 is a drive timing diagram of the pixel drive circuit shown in FIG. 5.
FIG. 7A is a schematic diagram of a planar structure of a display substrate according to an exemplary embodiment of the present disclosure.
FIG. 7B is a schematic diagram of a structure of a data connection line according to an exemplary embodiment of the present disclosure.
FIG. 8 is a schematic diagram of a structure of a display substrate according to an exemplary embodiment of the present disclosure.
FIG. 9 is a schematic diagram obtained after a pattern of a first conductive layer is formed according to an embodiment of the present disclosure.
FIGs. 10A and 10B are schematic diagrams obtained after a pattern of a second conductive layer is formed according to an embodiment of the present disclosure.
FIGs. 11A and 11B are schematic diagrams obtained after a pattern of a semiconductor layer is formed according to an embodiment of the present disclosure.
FIGs. 12A and 12B are schematic diagrams obtained after a pattern of a third conductive layer is formed according to an embodiment of the present disclosure.
FIG. 12C is an enlarged view of the third transistor in FIG. 12A.
FIG. 13 is a schematic diagram obtained after a pattern of a fourth insulation layer is formed according to an embodiment of the present disclosure.
FIGs. 14A and 14B are schematic diagrams obtained after a pattern of a fourth conductive layer is formed according to an embodiment of the present disclosure.
FIG. 15 is a schematic diagram obtained after a pattern of a first planarization layer is formed according to an embodiment of the present disclosure.
FIGs. 16A and 16B are schematic diagrams obtained after a pattern of a fifth conductive layer is formed according to an embodiment of the present disclosure.
FIG. 17 is a schematic diagram of a structure of another display substrate according to an exemplary embodiment of the present disclosure.
FIG. 18 is a schematic diagram of a structure of another display substrate according to an exemplary embodiment of the present disclosure.
FIG. 19 is a schematic diagram of a structure of another display substrate according to an exemplary embodiment of the present disclosure.
FIGs. 20A and 20B are schematic diagrams obtained after a pattern of a fourth conductive layer is formed in the embodiment shown in FIG. 19.
FIGs. 21A and 21B are schematic diagrams obtained after a pattern of a fifth conductive layer is formed in the embodiment shown in FIG. 19.
FIG. 22 is a schematic diagram of a structure of another display substrate according to an exemplary embodiment of the present disclosure.
FIG. 23 is a schematic diagram obtained after a pattern of a first conductive layer is formed in the embodiment shown in FIG. 22.
FIG. 24 is a schematic diagram obtained after a pattern of a second conductive layer is formed in the embodiment shown in FIG. 22.
FIG. 25 is a schematic diagram obtained after a pattern of a semiconductor layer is formed in the embodiment shown in FIG. 22.
FIG. 26 is a schematic diagram obtained after a pattern of a third conductive layer is formed in embodiment shown in FIG. 22.
FIG. 27 is a schematic diagram obtained after a pattern of a fourth insulation layer is formed in the embodiment shown in FIG. 22.
FIG. 28 is a schematic diagram obtained after a pattern of a fourth conductive layer is formed in the embodiment shown in FIG. 22.
FIG. 29 is a schematic diagram of a structure of another display substrate according to an exemplary embodiment of the present disclosure.
FIG. 30 is a schematic diagram obtained after a pattern of a first conductive layer is formed in the embodiment shown in FIG. 29.
FIG. 31 is a schematic diagram obtained after a pattern of a second conductive layer is formed in the embodiment shown in FIG. 29.
FIG. 32 is a schematic diagram obtained after a pattern of a semiconductor layer is formed in the embodiment shown in FIG. 29.
FIG. 33 is a schematic diagram obtained after a pattern of a third conductive layer is formed in the embodiment shown in FIG. 29.
FIG. 34 is a schematic diagram obtained after a pattern of a fourth conductive layer is formed in the embodiment shown in FIG. 29.

Reference signs are described as follows.

| | | | | | |
|---|---|---|---|---|---|
| 11- | First electrode plate; | 12- | Second electrode plate; | 13- | Third electrode plate; |
| 14- | Fourth electrode plate; | 15- | Electrode plate connection block; | 21- | First bottom gate electrode; |
| 22- | Second bottom gate electrode; | 24- | Fourth bottom gate electrode; | 26- | Sixth bottom gate electrode; |
| 27- | First shelter line; | 28- | Second shelter line; | 31- | First active layer; |
| 32- | Second active layer; | 33- | Third active layer; | 34- | Fourth active layer; |
| 35- | Fifth active layer; | 36- | Sixth active layer; | 37- | Seventh active layer; |
| 41- | First top gate electrode; | 42- | Second top gate electrode; | 43- | Third top gate electrode; |
| 44- | Fourth top gate electrode; | 46- | Sixth top gate electrode; | 51- | First connection electrode; |
| 52- | Second connection electrode; | 53- | Third connection electrode; | 54- | Fourth connection electrode; |
| 55- | Fifth connection electrode; | 61- | First scan signal line; | 62- | Second scan signal line |
| 63- | Third scan signal line; | 64- | Fourth scan signal line; | 65- | Light emitting signal line; |
| 66- | Reference signal line; | 67- | Initial signal line; | 68- | First power supply connection line; |
| 71- | First power supply line; | 72- | Second power supply line; | 73- | Data signal line; |
| 74- | Anode connection electrode; | 81- | First data connection line; | 82- | Second data connection line; |
| 83- | Data connection block; | 84- | Data connection electrode; | 85- | Dummy electrode; |
| 90- | Auxiliary cathode; | 101- | Base substrate; | 102- | Drive circuit layer; |
| 103- | Light emitting structure layer; | | | 104- | Encapsulation structure layer. |

### Detailed Description

To make objectives, technical solutions, and advantages of the present disclosure clearer, the embodiments of the present disclosure will be described in detail below with reference to the accompanying drawings. It is to be noted that implementations may be implemented in multiple different forms. Those of ordinary skills in the art may easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagram only, and one implementation of the present disclosure is not limited to shapes, numerical values, or the like shown in the drawings.

Ordinal numerals "first", "second", "third" and the like in the specification are set not to form limits in numbers but only to avoid confusion between constituent elements.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain electrode) and the source electrode (source electrode terminal, source region, or source electrode), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

A triangle, rectangle, trapezoid, pentagon, or hexagon, or the like in the specification is not strictly defined, and it may be an approximate triangle, rectangle, trapezoid, pentagon, or hexagon, or the like. There may be some small deformations caused by tolerance, and there may be a chamfer, an arc edge, deformation, etc. In the present disclosure, "about" means that a boundary is not defined so strictly and numerical values within process and measurement error ranges are allowed.

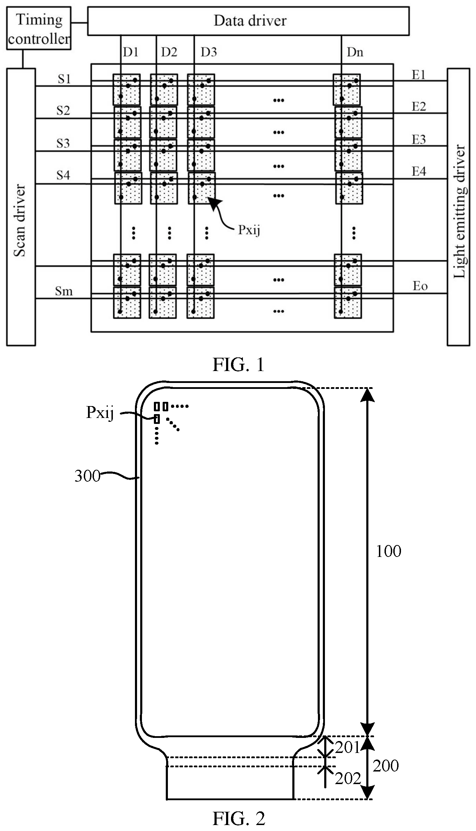

FIG. 1 is a schematic diagram of a structure of a display apparatus. As shown in FIG. 1, the display apparatus may include a timing controller, a data driver, a scan driver, a light emitting driver, and a pixel array. The timing controller is connected to the data driver, the scan driver, and the light emitting driver, respectively, the data driver is connected to a plurality of data signal lines (D1 to Dn) respectively, the scan driver is connected to a plurality of scan signal lines (S1 to Sm) respectively, and the light emitting driver is connected to a plurality of light emitting signal lines (E1 to Eo) respectively. The pixel array may include a plurality of sub-pixels Pxij, i and j may be natural numbers, at least one sub-pixel Pxij may include a circuit unit and a light emitting unit, the circuit unit may include, at least, a pixel drive circuit connected to a scan signal line, a light emitting signal line and a data signal line, respectively. The light emitting unit may include a light emitting device connected to the pixel drive circuit of the circuit unit. In an exemplary embodiment, the timing controller may provide the data driver with a grayscale value and a control signal which are suitable for a specification of the data driver, provide the scan driver with a clock signal and a scan start signal and the like which are suitable for a specification of the scan driver, and provide the light emitting driver with a clock signal and an emission stop signal and the like which are suitable for a specification of the light emitting driver. The data driver may generate data voltages to be provided to the data signal lines D1, D2, D3, ..., and Dn using the grayscale value and the control signal that are received from the timing controller. For example, the data driver may sample the grayscale value using the clock signal and apply data voltages corresponding to the grayscale value to the data signal lines D1 to Dn by taking a pixel row as a unit, wherein n may be a natural number. The scan driver may generate scan signals to be provided to the scan signal lines S1, S2, S3, ..., and Sm by receiving the clock signal and the scan start signal from the timing controller. For example, the scan driver may sequentially provide scan signals with an on-level pulse to the scan signal lines S1 to Sm. For example, the scan driver may be constructed in a form of a shift register and may generate scan signals in a manner in which a scan start signal provided in a form of an on-level pulse is transmitted to a next-stage circuit sequentially under control of the clock signal, wherein m may be a natural number. The light emitting driver may receive a clock signal, an emission stop signal, etc., from the timing controller to generate emission signals to be provided to the light emitting signal lines E1, E2, E3, ..., and Eo. For example, the light emitting driver may sequentially provide emission signals with an off-level pulse to the light emitting signal lines E1 to Eo. For example, the light emitting driver may be constructed in a form of a shift register and generate emission signals in a manner of sequentially transmitting an emission stop signal provided in a form of an off-level pulse to a next-stage circuit under control of the clock signal, wherein o may be a natural number. In an exemplary implementation, the pixel array may be arranged on a display substrate.

FIG. 2 is a schematic diagram of a structure of a display substrate. As shown in FIG. 2, the display substrate may include a display region 100, a bonding area 200 located on a side of the display region 100, and a bezel area 300 located on other sides of the display region 100. In an exemplary implementation, the display region 100 may be a flat region, including multiple sub-pixels Pxij that constitute a pixel array, wherein the multiple sub-pixels Pxij are configured to display a dynamic picture or a static image, and the display region 100 may be referred to as an Active Area (AA). In an exemplary embodiment, the display substrate may be a flexible substrate, so that the display substrate may be deformable, for example, be curled, bent, folded, or rolled.

In an exemplary implementation, the bonding region 200 may include a lead-out line region 201, a bending region 202, a drive chip region, and a bonding pin region, which are sequentially disposed along a direction away from the display region, and the lead-out line region 201 is connected to the display region 100, and at least includes a data lead-out line. The bending region 202 is connected to the lead-out line region 201 and may at least include a composite insulation layer provided with a groove, and the groove is configured to enable the bonding region to be bent to a back surface of the display region. The drive chip region may include an Integrated Circuit (IC for short), and the Integrated Circuit is configured to be connected with the plurality of data lead-out lines. The bonding pin region may include a Bonding Pad, and the Bonding Pad is configured to be bonded and connected with an external Flexible Printed Circuit (FPC for short).

In an exemplary embodiment, the bezel region 300 may include a circuit region, a power supply line region, a crack dam region, and a cutting region which are sequentially disposed in the direction away from the display region 100. The circuit region is connected to the display region100 and may at least include a gate drive circuit connected with the scan signal line and the light emitting signal line in the display region 100. The power supply line region is connected to the circuit region and may at least include a bezel power supply lead, wherein the bezel power supply lead extends in a direction parallel to an edge of the display region and is connected to a cathode in the display region 100. The crack dam region is connected to the power supply line region and may at least include a plurality of cracks provided on the composite insulation layer. The cutting region is connected to the crack dam region and may at least include a cutting groove disposed on the composite insulation layer, wherein the cutting grooves are configured for respectively cutting along the cutting grooves by a cutting device after all films of the display substrate are manufactured.

In an exemplary implementation, the lead-out line region in the bonding region 200 and the power supply line region in the bezel region 300 may be provided with a dam spacer, the dam spacer may extend along a direction parallel to an edge of the display region to form an annular structure surrounding the display region 100, wherein the edge of the display region is an edge of a side of the display region the bonding region, or the bezel region.

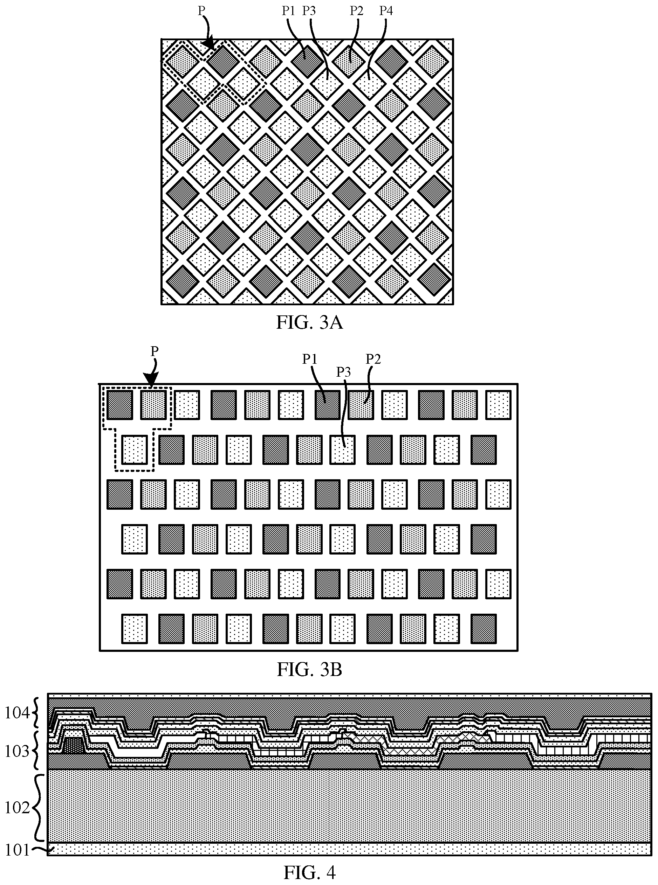

FIG. 3A is a schematic diagram of a planar structure of a display region in a display substrate. As shown in FIG. 3A, the display region may include a plurality of pixel units P arranged in a matrix, and at least one of the plurality of pixel units P may include a first sub-pixel P1, a second sub-pixel P2, a third sub-pixel P3, and a fourth sub-pixel P4. Each sub-pixel may include a circuit unit and a light emitting unit. The circuit unit may at least include a pixel drive circuit, the pixel drive circuit is connected with a scan signal line, a light emitting signal line, and a data signal line respectively, and the pixel drive circuit is configured to receive a data voltage transmitted by the data signal line and output a corresponding current to the light emitting unit under control of the scan signal line and the light emitting signal line. The light emitting unit may include a light emitting device connected with a pixel drive circuit of a sub-pixel where the light emitting device is located, and the light emitting device is configured to emit light with corresponding brightness in response to a current output by the pixel drive circuit of the sub-pixel where the light emitting device is located.

In an exemplary implementation, the first sub-pixel P1 may be a red sub-pixel (R) emitting red light, the second sub-pixel P2 and the fourth sub-pixel P4 may be green sub-pixels (G) emitting green light, and the third sub-pixel P3 may be a blue sub-pixel (B) emitting blue light. In an exemplary embodiment, a sub-pixel may be in a shape of a rectangle, a diamond, a pentagon, or a hexagon. The four sub-pixels may be arranged in an RGBG manner.

FIG. 3B is a schematic diagram of a planar structure of a display region in another display substrate. As shown in FIG. 3B, the pixel unit P may include three sub-pixels, the first sub-pixel P1 may be a red sub-pixel emitting red light, the second sub-pixel P2 may be a blue sub-pixel emitting blue light, and the third sub-pixel P3 may be a green sub-pixel emitting green light, and the three sub-pixels may be arranged in a Real RGB manner.

In another exemplary embodiment, the three sub-pixels or the four sub-pixels may be arranged side by side horizontally or side by side vertically, etc., which is not limited in the present disclosure.

FIG. 4 is a schematic diagram of cross-sectional structure of a display region in a display substrate, illustrating a structure of four sub-pixels in the display region. As shown in FIG. 4, on a plane perpendicular to the display substrate, the display region may include a drive circuit layer 102 provided on a base substrate 101, a light emitting structure layer 103 provided on a side of the drive circuit layer 102 away from the base substrate 101, and an encapsulation structure layer 104 provided on a side of the light emitting structure layer 103 away from the base substrate 101. In some possible implementations, the display region may include other film layers, such as a touch structure layer, which is not limited here in the present disclosure.

In an exemplary embodiment, the base substrate 101 may be a flexible base substrate, or may be a rigid base substrate. The drive circuit layer 102 may include a plurality of circuit units, each of which may at least include a pixel drive circuit composed of a plurality of transistors and a storage capacitor. The light emitting structure layer 103 may include a plurality of light emitting units. Each light emitting unit may include a light emitting device, and the light emitting device may at least include an anode, an organic emitting layer, and a cathode. The anode is connected with a pixel drive circuit. The organic emitting layer is connected with the anode. The cathode is connected with the organic emitting layer. The organic emitting layer emits light of a corresponding color under drive of the anode and the cathode. The encapsulation structure layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is arranged between the first encapsulation layer and the third encapsulation layer to form a stacked structure of inorganic material/organic material/inorganic material, which can ensure that external moisture cannot enter the light emitting structure layer 103.

With development of OLED display technologies, consumers have higher and higher requirements for display effects of display products. Extremely narrow bezels have become a new trend in development of display products, hence narrowing a bezel or even a borderless design has attracted more and more attention in designs of OLED display products. In a display substrate, signal lines of an integrated circuit and a bonding pad in a bonding region need to be introduced into a display region that is relatively wide, in a fanout manner through data lead-out lines, so that a lead-out line region occupies relatively large space, resulting in a relatively large width of a lower bezel. Further, as the size of the display substrate increases, the yield of the display substrate using LTPS (Low Temperature Poly-Silicon) thin film transistors decreases, resulting in high cost.

A display substrate is provided in an exemplary embodiment of the present disclosure. In an exemplary embodiment, the display substrate may include a plurality of circuit units, a plurality of data signal lines extending along a second direction, a plurality of first data connection lines extending along a first direction, and a plurality of second data connection lines extending along the second direction, one end of at least one first data connection line is connected to a data signal line of the plurality of data signal lines and the other end of the at least one first data connection line is connected to a second data connection line of the plurality of second data connection lines, wherein the first direction and the second direction intersect. At least one circuit unit includes a pixel drive circuit including, at least, a drive transistor, a first reset transistor, a data writing transistor, a light emitting control transistor, a first capacitor including a first electrode plate and a second electrode plate, and a second capacitor including a third electrode plate and a fourth electrode plate. A first electrode of the first reset transistor is connected to a reference signal line, a second electrode of the first reset transistor is connected to a gate electrode of the drive transistor, a first electrode of the light emitting control transistor is connected to a first power supply line, a second electrode of the light emitting control transistor is connected to a first electrode of the drive transistor, a second electrode of the drive transistor is connected to the second electrode plate of the first capacitor, a first electrode of the data writing transistor is connected to the data signal line, a second electrode of the data writing transistor is connected to the fourth electrode plate of the second capacitor, the first electrode plate of the first capacitor is connected with the third electrode plate of the second capacitor; the drive transistor is an oxide transistor, and a width-to-length ratio of the drive transistor is 1.25 to 2.67.

In an exemplary embodiment, an orthographic projection of the data signal line on a base substrate is not overlapped with orthographic projections of channel regions of the drive transistor, the first reset transistor, the data writing transistor, and the light emitting control transistor on the base substrate.

In an exemplary embodiment, in at least one circuit unit, the data signal line includes at least one straight line segment, and at least one bending segment that is configured to increase an extension length of the data signal line.

In an exemplary embodiment, at least one second data connection line is disposed between two first power supply lines adjacent in the first direction, or at least one second data connection line is disposed between two data signal lines adjacent in the first direction.

In an exemplary embodiment, in at least one circuit unit and a circuit unit adjacent to the at least one circuit unit in the first direction, first power supply lines of two circuit units are of an interconnected integral structure.

In an exemplary embodiment, the at least one circuit unit further includes a first power supply connection line extending along the first direction, the first power supply line is in a shape of a straight line or a bend line extending along the second direction, and the first power supply line is connected to the first power supply connection line to form a net-like structure for transmitting a first power supply signal.

In an exemplary embodiment, the at least one circuit unit further includes a second power supply line having a width larger than a width of the first power supply line, and the width is a dimension in the first direction.

In an exemplary embodiment, the display substrate further includes a plurality of auxiliary cathodes disposed on a side of the second power supply line away from the base substrate, an orthographic projection of at least one auxiliary cathode on the base substrate is at least partially overlapped with an orthographic projection of the second power supply line on the base substrate, the auxiliary cathode is connected to the second power supply line through an auxiliary via, and the auxiliary cathode is configured to be connected to a cathode of a light emitting device.

In an exemplary embodiment, an orthographic projection of the first power supply line on a base substrate is at least partially overlapped with orthographic projections of the first reset transistor and the data writing transistor on the base substrate, and an orthographic projection of the second power supply line on the base substrate is at least partially overlapped with orthographic projections of the drive transistor and the light emitting control transistor on the base substrate.

The display substrate of the present embodiment will now be described through some examples.

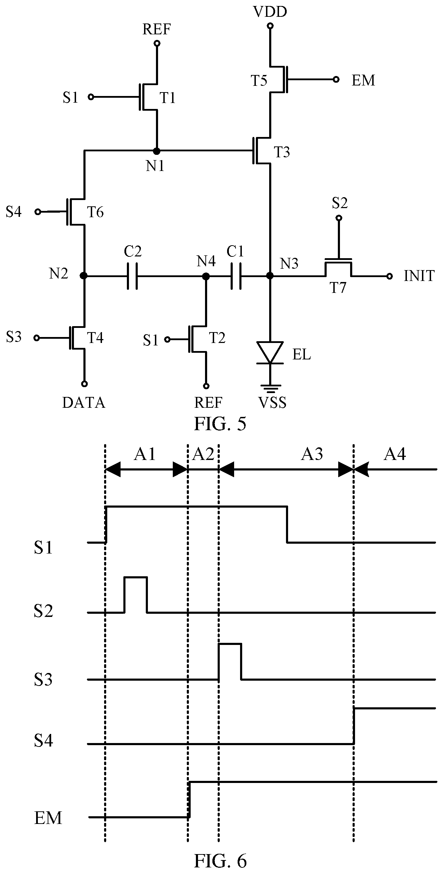

FIG. 5 is an equivalent circuit diagram of a pixel drive circuit according to an exemplary embodiment of the present disclosure. As shown in FIG. 5, in an exemplary implementation, the pixel drive circuit according to an exemplary embodiment of the present disclosure adopts a 7T2C structure, in which the pixel drive circuit may include seven transistors (a first transistor T1 to a seventh transistor T7) and two capacitors C, and the pixel drive circuit is connected to nine signal lines (a first scan signal line S1, a second scan signal line S2, a third scan signal line S3, a fourth scan signal line S4, a light emitting signal line EM, a reference signal line REF, an initial signal line INIT, a data signal line DATA and a first power supply line VDD).

In an exemplary embodiment, the pixel drive circuit may include a first node N1, a second node N2, a third node N3, and a fourth node N4. The first node N1 is respectively connected to a second electrode of the first transistor T1, a first electrode of the sixth transistor T6, and a gate electrode of the third transistor T3; the second node N2 is respectively connected to a second electrode of the fourth transistor T4, a second electrode of the sixth transistor T6, and a second end of the second capacitor C2; the third node N3 is respectively connected to a second electrode of the third transistor T3, a second electrode of the seventh transistor T7, and a second end of the first capacitor C1; and the fourth node N4 is connected to a second electrode of the second transistor T2, a first end of the first capacitor C1, and a first end of the second capacitor C2, respectively.

In an exemplary embodiment, the first transistor T1 may be referred to as a first reset transistor, a gate electrode of the first transistor T1 is connected to the first scan signal line S1, a first electrode of the first transistor T1 is connected to the reference signal line REF, and a second electrode of the first transistor T1 is connected to the first node N1.

In an exemplary embodiment, the second transistor T2 may be referred to as a second reset transistor, a gate electrode of the second transistor T2 is connected to the first scan signal line S1, a first electrode of the second transistor T2 is connected to the reference signal line REF, and a second electrode of the second transistor T2 is connected to the fourth node N4.

In an exemplary embodiment, the third transistor T3 may be referred to as a drive transistor. The gate electrode of the third transistor T3 is connected to the first node N1, the first electrode of the third transistor T3 is connected to a second electrode of the fifth transistor T5, and the second electrode of the third transistor T3 is connected to the third node N3.

In an exemplary implementation, the fourth transistor T4 may be referred to as a data writing transistor, a gate electrode of the fourth transistor T4 is connected to the third scan signal line S3, a first electrode of the fourth transistor T4 is connected to a data signal line DATA, and the second electrode of the fourth transistor T4 is connected to the second node N2.

In an exemplary embodiment, the fifth transistor T5 may be referred to as a light emitting control transistor, a gate electrode of the fifth transistor T5 is connected to the light emitting signal line EM, a first electrode of the fifth transistor T5 is connected to the first power supply line VDD, and the second electrode of the fifth transistor T5 is connected to the first electrode of the third transistor T3.

In an exemplary embodiment, the sixth transistor T6 may be referred to as a data control transistor, a gate electrode of the sixth transistor T6 is connected to the fourth scan signal line S4, the first electrode of the sixth transistor T6 is connected to the first node N1, and the second electrode of the sixth transistor T6 is connected to the second node N2.

In an exemplary embodiment, the seventh transistor T7 may be referred to as a third reset transistor, a gate electrode of the seventh transistor T7 is connected to the second scan signal line S2, a first electrode of the seventh transistor T7 is connected to the initial signal line INIT, and a second electrode of the seventh transistor T7 is connected to the third node N3.

In an exemplary implementation, the first electrode of the light emitting device EL is connected to the third node N3, and the second electrode of the light emitting device EL is connected to the second power supply line VSS. The light emitting device EL may be an OLED, including a first electrode (an anode), an organic light emitting layer, and a second electrode (an cathode) which are stacked, or may be a QLED including a first electrode (an anode), a quantum dot light emitting layer, and a second electrode (a cathode) which are stacked.

In an exemplary implementation, the seven transistors of the pixel drive circuit may be N-type transistors. Use of a same type of transistors in a pixel drive circuit may simplify a process flow, reduce process difficulties of the display substrate, and improve a yield of products.

In an exemplary implementation, the seven transistors of the pixel drive circuit may all be oxide transistors. An active layer of an oxide transistor may be made of an oxide semiconductor (Oxide). Oxide transistors have the advantages of high electron mobility, low working voltage, low leakage characteristics, etc., and the use of a display substrate equipped with oxide transistors can achieve low-frequency drive, reduce power consumption and improve display quality.

In an exemplary embodiment, the first power supply line VDD may be configured to provide a constant first voltage signal to the pixel drive circuit, the second power supply line VSS may be configured to provide a constant second voltage signal to the light emitting device, and the first voltage signal is a high-level signal and the second voltage signal is a low-level signal. The reference signal line REF and the initial voltage signal may be constant voltage signals, which is not limited here in the present disclosure.

FIG. 6 is a drive timing diagram of the pixel drive circuit shown in FIG. 5. As shown in FIG. 6, in an exemplary implementation, a working process of the pixel drive circuit may include the following stages.

The first stage A1 is referred to as an initialization stage. In the first stage A1, signals of the first scan signal line S1 and the second scan signal line S2 are high-level signals, and signals of the third scan signal line S3, the fourth scan signal line S4, and the light emitting signal line EM are low-level signals, so that the first transistor T1, the second transistor T2, and the seventh transistor T7 are turned on, and other switching transistors are turned off.

The first transistor T1 is turned on, so that a reference signal provided by the reference signal line REF is provided to the first node N1, to initialize the first node N1 (the gate electrode of the third transistor T3 is reset), and the potential of the first node N1 is Vref. The second transistor T2 is turned on, so that a reference signal provided by the reference signal line REF is provided to the fourth node N4, to initialize the fourth node N4 (the first end of the first capacitor C1 and the first end of the second capacitor C2 are reset), and the potential of the fourth node N4 is Vref. The seventh transistor T7 is turned on, so that an initial signal provided by the initial signal line INIT is provided to the third node N3, to initialize the third node N3 (the second electrode of the third transistor T3 and the second end of the second capacitor C2 are reset), and the potential of the third node N3 is Vinit. At the same time, the third transistor T3 can be turned on by the voltage difference between Vinit and Vref.

In an exemplary embodiment, Vref is the voltage of the reference signal, which may be about 2.5 V, and Vinit is the voltage of the initial signal, which may be about 1.5 V.

In an exemplary embodiment, the reset of the first node N1, the third node N3, and the fourth node N4 may be performed in different time points, or may be performed simultaneously, which is not limited here in the present disclosure.

The second stage A2 is referred to as a compensation stage. In the second stage A2, signals of the first scan signal line S1 and the light emitting signal line EM are high-level signals, and signals of the second scan signal line S2, the third scan signal line S3, and the fourth scan signal line S4 are low-level signals, so that the first transistor T1, the second transistor T2, and the fifth transistor T5 are turned on, and other switching transistors are turned off.

The first transistor T1 and the second transistor T2 are turned on, so that the potentials of the first node N1 and the fourth node N4 are continuously Vref, and since the third transistor T3 is turned on, and the fifth transistor T5 is turned on, so that a first power supply signal output from the first power supply line VDD is written to the third node N3 through the turned-on third transistor T3, and the potential of the third node N3 is gradually increased.

In an exemplary embodiment, the voltage of the first power supply signal output by the first power supply line VDD may be about 11.5 V.

The third stage A3 is referred to as a data writing stage. In the third stage A3, a signal of the light emitting signal line EM is a continuous high-level signal, signals of the second scan signal line S2 and the fourth scan signal line S4 are continuous low-level signals, signals of the first scan signal line S1 and the third scan signal line S3 are high-level signals for a period of time, and then become low-level signals, so that the fifth transistor T5 is continuously turned on, and the first transistor T1, the second transistor T2 and the fourth transistor T4 are turned on for a period of time, and then turned off.

The fourth transistor T4 is turned on, so that a data signal output from the data signal line DATA is written to the second node N2, that is, stored in the second capacitor C2. The fifth transistor T5 is continuously turned on, so that the potential of the third node N3 gradually increases until the potential increases to Vref - Vth, causing the gate-source voltage difference Vgs of the third transistor T3 to be Vth, and the third transistor T3 is turned off, thus, the threshold voltage Vth of the third transistor T3 is written to the third node N3, that is, stored in the first capacitor C1. Thus, writing of the threshold voltage Vth begins in the second stage (the compensation stage) A2, while writing of the threshold voltage is completed in the third stage (the data writing stage) A3, and writing of the threshold voltage lasts from the second stage A2 to the third stage A3. After the threshold voltage Vth is written to the third node N3, the first transistor T1 and the second transistor T2 change from being turned on to turned off.

The fourth stage A4 is referred to as a light emitting stage. In the fourth stage A4, signals of the fourth scan signal line S4 and the light emitting signal line EM are high-level signals, and signals of the first scan signal line S1, the second scan signal line S2, and the third scan signal line S3 are low-level signals, so that the fifth transistor T5 and the sixth transistor T6 are turned on.

The sixth transistor T6 is turned on, so that the first node N1 and the second node N2 are connected, the data voltage stored at the second node N2 is written to the first node N1, and the potential Vg of the first node N1 (the potential of the gate electrode of the third transistor T3) is Vd+Vld+VSS-(Vref-Vth); the potential Vs of the third node N3 (the potential of the second electrode of the third transistor T3) is Vld+VSS; then the gate-source voltage difference Vgs of the third transistor T3 is Vdata-Vref+Vth. Vld is the voltage of the light emitting device EL, VSS is the voltage of the second power supply signal, and Vd is the voltage of the data signal. The fifth transistor T5 is turned on, so that the first power supply signal output by the first power supply line VDD provides a driving voltage to the first electrode of the light emitting element EL through the turned-on third transistor T3, and drives the light emitting element EL to emit light.

The output current I of the third transistor T3 satisfies the following formula: $I = \left(μWCox/2L\right) {\left(Vgs-Vth\right)}^{2} = \left(μWCox/2L\right) {\left(Vdata-Vref\right)}^{2} .$

Where µ is carrier mobility; Cox is a gate capacitance per unit area, W is a width of the channel of the third transistor T3, and L is a length of the channel of the third transistor T3.

According to the above formula of the output current of the third transistor T3, it can be seen that the output current of the pixel drive circuit is unrelated to the threshold voltage Vth of the third transistor T3, so that the influence of the threshold voltage of the third transistor T3 on the output current is eliminated, and the control of the output current can be achieved by controlling the data voltage Vd, to control the brightness of the light emitting device EL.

In the pixel drive circuit and the drive method thereof according to the exemplary embodiment of the present disclosure, the data signal is stored in the second capacitor in the writing stage without be directly written to the gate electrode of the third transistor T3, and the threshold voltage of the third transistor T3 is stored in the first capacitor in the compensation stage, so that the data signal and the threshold voltage of the third transistor T3 are independently stored, and the stored data signal and the stored threshold voltage do not interfere with each other. The data signal is written to the gate electrode of the third transistor T3 using the second capacitor in the light emitting stage, which can not only ensure that the voltage difference between the data signal and the second electrode of the drive transistor T3 is stable, but also can prevent the actual brightness of the light emitting device from being different from the design brightness due to different degrees of interference of different data signals, thereby improving the picture quality.

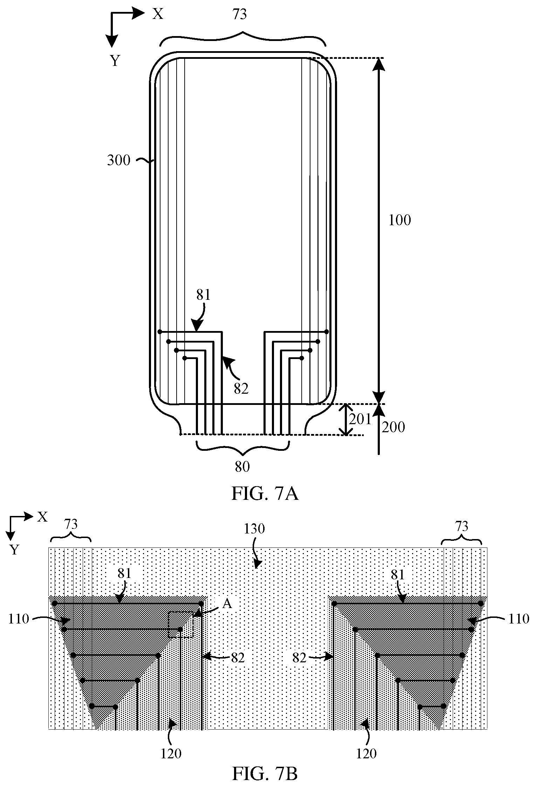

FIG. 7A is a schematic diagram of a planar structure of a display substrate according to an exemplary embodiment of the present disclosure. In a plane perpendicular to the display substrate, the display panel may include a drive structure layer disposed on a base substrate, a light emitting structure layer disposed on a side of the drive structure layer away from the base substrate, and an encapsulation structure layer disposed on a side of the light emitting structure layer away from the base substrate. As shown in FIG. 7A, in a plane parallel to the display substrate, the display substrate may at least include a display region 100, a bonding region 200 located on a side of the display region 100 in a second direction Y, and a bezel region 300 located on another side of the display region 100. In an exemplary implementation, the drive circuit layer of the display region 100 may include a plurality of circuit units constituting a plurality of unit rows and a plurality of unit columns, a plurality of data signal lines 73, a plurality of first data connection lines 81, and a plurality of second data connection lines 82, wherein at least one circuit unit may include a pixel drive circuit, and the pixel drive circuit is configured to output a corresponding current to a connected light emitting device. The light emitting structure layer of the display region 100 may include a plurality of light emitting units, at least one light emitting unit may include a light emitting device, the light emitting device is connected with a pixel drive circuit of a corresponding circuit unit, and the light emitting device is configured to emit light with corresponding brightness in response to a current outputted by the connected pixel drive circuit.

In an exemplary embodiment, circuit units mentioned in the present disclosure refer to regions divided according to pixel drive circuits, and light emitting units mentioned in the present disclosure refer to regions divided according to light emitting devices. In an exemplary embodiment, a position of an orthographic projection of a light emitting unit on the base substrate may correspond to a position of an orthographic projection of a circuit unit on the base substrate, or the position of the orthographic projection of the light emitting unit on the base substrate may not correspond to the position of the orthographic projection of the circuit unit on the base substrate.

In an exemplary embodiment, multiple circuit units sequentially disposed along a first direction X may be referred to as a unit row, and multiple circuit units sequentially disposed along a second direction Y may be referred to as a unit column. Multiple unit rows and multiple unit columns form a circuit unit array arranged in an array, and the first direction X and the second direction Y intersect.

In an exemplary embodiment, the first data connection line 81 may be in a shape of a straight line or a bend line extending along the first direction X, and the data signal line 73 and the second data connection line 82 may be in a shape of a straight line or a bend line extending along the second direction Y. At least one data signal line 73 is connected with a plurality of pixel drive circuits in a unit column, and the data signal line 73 is be configured to provide a data signal to the connected pixel drive circuits. One end of at least one first data connection line 81 is connected to a data signal line 73, the other end thereof is connected to one end of a second data connection line 82, and the other end of the second data connection line 82 is connected to a data lead-out line 80 after extending to the bonding region, so that the data signal line 73 in the display region is connected to the data lead-out line 80 in the bonding region 200 through the first data connection line 81 and the second data connection line 82, a structure (Fanout in AA, FIAA for short) in which data connection lines are located in the display region is formed. In an exemplary embodiment, the data connection line includes the first data connection line 81 and the second data connection line 82.

In an exemplary implementation, the bonding region 200 may include a lead-out line region 201, a bending region 202, a drive chip region, and a bonding pin region which are sequentially disposed along a direction away from the display region, wherein the lead-out line region 201 is connected to the display region 100, and the bending region 202 is connected to the lead-out line region 201. A plurality of data lead-out lines 80 may be disposed in the lead-out line region 201, the plurality of data lead-out lines 80 extend along a direction away from the display region, first ends of one part of the data lead-out lines 80 are connected correspondingly with second data connection lines 82 in the display region 100, first ends of another part of the data lead-out lines 80 are connected correspondingly with data signal lines 73 in the display region 100, and second ends of all data lead-out lines 80 extend along the second direction Y and then cross the bending region to be connected with an integrated circuit of the drive chip region, so that the integrated circuit applies a data signal to data signal lines through data lead-out lines and data connection lines. Since the first data connection lines 81 and the second data connection lines 82 are arranged in the display region, the length of the lead-out line region in the second direction Y can be effectively reduced, the width of the lower bezel can be greatly reduced, the screen-to-body ratio can be increased, and the full-screen display can be achieved.

FIG. 7B is a schematic diagram of a structure of a data connection line according to an exemplary embodiment of the present disclosure. As shown in FIG. 7B, since the first data connection lines 81 and the second data connection lines 82 are provided in some regions in the display region, the display region may be divided into a first region 110, a second region 120, and a third region 130, according to presence or absence of a data connection line and an extension direction of the data connection line as a division basis. The first region 110 may be a region where the first data connection line 81 is provided (which may be referred to as a connection line lateral trace region), the second region 120 may be a region where the second data connection line 82 is provided (which may be referred to as a connection line longitudinal trace region), and the third region 130 may be a region where the first data connection line 81 and the second data connection line 82 are not provided (which may be referred to as a normal region). The first region 110, the second region 120, and the third region 130 are all provided with data signal lines 73.

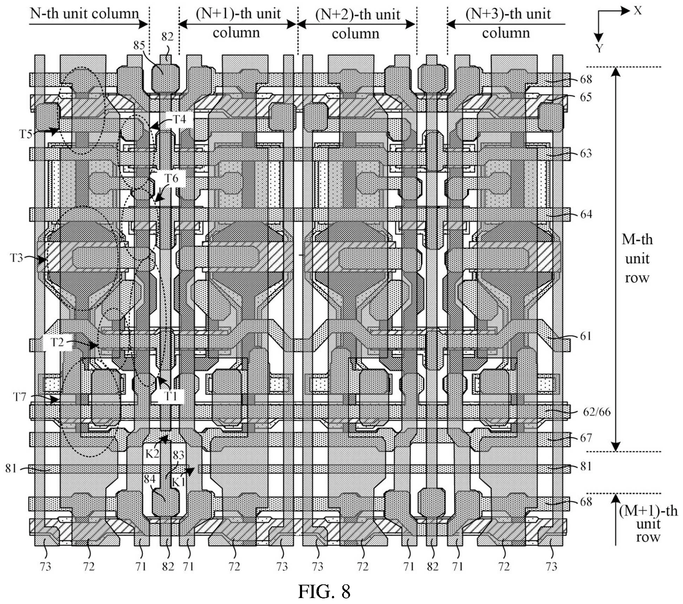

In an exemplary implementation, division of various regions shown in FIG. 8 is only exemplary illustration. Since the first region 110, the second region 120, and the third region 130 are divided according to presence or absence of the data connection line and an extension direction of the data connection line as the division basis, shapes of the three regions may be regular polygons or irregular polygons, and the display region may be divided into one or more first regions 110, one or more second regions 120, and one or more third regions 130, which is not limited here in the present disclosure.

FIG. 8 is a schematic diagram of a structure of a display substrate according to an exemplary embodiment of the present disclosure, and is an enlarged view of the region A in FIG. 7B, and schematically illustrates structures of circuit units in one circuit row and four circuit columns. As shown in FIG. 8, in a plane parallel to the display substrate, the drive structure layer may include a plurality of circuit units constituting a plurality of unit rows and a plurality of unit columns, and at least one circuit unit may include a pixel drive circuit that may be connected to a first scan signal line 61, a second scan signal line 62, a third scan signal line 63, a fourth scan signal line 64, a light emitting signal line 65, a reference signal line 66, an initial signal line 67, a first power supply line 71, and a data signal line 73, respectively. The first scan signal line 61 to the fourth scan signal line 64 are configured to provide a first scan signal to a fourth scan signal to the pixel drive circuit, respectively, and the light emitting signal line 63 is configured to provide a light emitting control signal to the pixel drive circuit, and the reference signal line 66, the initial signal line 67, the first power supply line 71, and the data signal line 73 are configured to provide a reference signal, an initial signal, a first power supply signal, and a data signal to the pixel drive circuit, respectively. A plurality of signal lines connected to the pixel drive circuit may be located in circuit units.

In an exemplary embodiment, the first scan signal line 61, the second scan signal line 62, the third scan signal line 63, the fourth scan signal line 64, the light emitting signal line 65, the reference signal line 66, and the initial signal line 67 may be in a shape of a straight line or a bend line extending along the first direction X, the first power supply line 71 may be in a shape of a bend line extending along the second direction Y, and the data signal line 73 may be in a shape of a straight line extending along the second direction Y.

In the present disclosure, "A extends in a B direction" refers to that A may include a main portion and a secondary portion connected to the main portion, wherein the main portion is a line, a line segment, or a strip-shaped body, the main portion extends in the B direction, and a length of the main portion extending in the B direction is greater than a length of the secondary portion extending in another direction. In following description, "A extends in a B direction" means "a main body portion of A extends in the B direction". In an exemplary implementation, the first direction X may be the unit row direction, and the second direction Y may be the unit column direction.

In an exemplary embodiment, the plurality of circuit units on the display substrate may be compressed to obtain a trace space in lateral compression and longitudinal compression manners, and the trace space is configured to accommodate first data connection lines 81 and second data connection lines 82. Herein, two unit columns may be set as a group to be compressed to obtain one vertical trace space in a lateral compression manner, that is, every two unit columns of circuit units are compressed to obtain one vertical trace space in which the second data connection lines 82 are provided. Four unit rows may be set as a group to be compressed to obtain one lateral trace space in a longitudinal compression manner, that is, every four unit rows of circuit units are compressed to obtain one lateral trace space in which the first data connection lines 81 are provided.

In an exemplary embodiment, the pixel drive circuit may at least include a first capacitor, a second capacitor, and a plurality of oxide transistors. The plurality of oxide transistors may include a first transistor T1 as a first reset transistor, a second transistor T2 as a second reset transistor, a third transistor T3 as a drive transistor, a fourth transistor T4 as a data writing transistor, a fifth transistor T5 as a light emitting control transistor, a sixth transistor T6 as a data control transistor, and a seventh transistor T7 as a third reset transistor, the first capacitor may include a first electrode plate and a second electrode plate that are stacked, and the second capacitor may include a third electrode plate and a fourth electrode plate that are stacked.

In an exemplary embodiment, a gate electrode of the first transistor T1 is connected to the first scan signal line 61, a first electrode of the first transistor T1 is connected to the reference signal line 66, and a second electrode of the first transistor T1 is connected to a gate electrode of the third transistor T3. A gate electrode of the second transistor T2 is connected to the first scan signal line 61, a first electrode of the second transistor T2 is connected to the reference signal line 66, and a second electrode of the second transistor T2 is connected to the first electrode plate of the first capacitor and the third electrode plate of the second capacitor, respectively. A first electrode of the third transistor T3 is connected to a second electrode of the fifth transistor T5, and a second electrode of the third transistor T3 is connected to the second electrode plate of the first capacitor. A gate electrode of the fourth transistor T4 is connected to the third scan signal line 63, a first electrode of the fourth transistor T4 is connected to the data signal line 73, and a second electrode of the fourth transistor T4 is connected to the fourth electrode plate of the second capacitor. A gate electrode of the fifth transistor T5 is connected to the light emitting signal line 65, and a first electrode of the fifth transistor T5 is connected to the first power supply line 71. A gate electrode of the sixth transistor T6 is connected to the fourth scan signal line 64, a first electrode of the sixth transistor T6 is connected to a gate electrode of the third transistor T3, and a second electrode of the sixth transistor T6 is connected to the fourth electrode plate of the second capacitor. A gate electrode of the seventh transistor T7 is connected to the second scan signal line 62, a first electrode of the seventh transistor T7 is connected to the initial signal line 67, and a second electrode of the seventh transistor T7 is connected to the second electrode plate of the first capacitor.

In an exemplary embodiment, the third transistor T3 may have a width-to-length ratio of 1.25 to 2.67.

In an exemplary embodiment, in at least one circuit unit, an orthographic projection of the data signal line 73 on the base substrate is not overlapped with orthographic projections of the channel regions of the first transistor T1 to the seventh transistor T7 on the base substrate.

In an exemplary implementation, the at least one circuit unit may further include at least one first power supply connection line 68 extending in the first direction X. The first power supply line 71 and the first power supply connection line 68 are connected to each other to form a net-like structure for transmitting the first power supply signal.

In an exemplary embodiment, an orthographic projection of the first power supply line 71 on the base substrate is at least partially overlapped with orthographic projections of the first transistor T1, the fourth transistor T4 and the sixth transistor T6 on the base substrate.

In an exemplary embodiment, the at least one circuit unit may further include a second power supply line 72, and the second power supply line 72 may be in a shape of a bend line or a bend line extending along the second direction Y.

In an exemplary embodiment, a width of the second power supply line 72 may be larger than a width of the first power supply line 71, and the width may be a dimension in the first direction X.

In an exemplary embodiment, an orthographic projection of the second power supply line 72 on the base substrate is at least partially overlapped with orthographic projections of the third transistor T3, the fifth transistor T5, and the seventh transistor T7 on the base substrate.

In an exemplary embodiment, the drive structure layer may further include at least one first data connection line 81 and at least one second data connection line 82, the first data connection line 81 may be in a shape of a straight line or a bend line extending along the first direction X and may be disposed in a lateral trace space between unit rows, and the second data connection line 82 may be in a shape of a straight line or a bend line extending along the second direction Y and may be disposed in a vertical trace space between unit columns. One end of the at least one first data connection line 81 is connected to the data signal line 73, and the other end thereof is connected to the second data connection line 82, forming a structure in which data connection lines are located in the display region.

In an exemplary embodiment, the at least one second data connection line 82 may be disposed between first power supply lines 71 adjacent in the first direction X. For example, the second data connection line 82 may be provided between the first power supply line 71 of the N-th unit column and the first power supply line 71 of the (N+1)-th unit column. For another example, the second data connection line 82 may be provided between the first power supply line 71 of the (N+2)-th unit column and the first power supply line 71 of the (N+3)-th unit column.

In an exemplary embodiment, the at least one circuit unit may further include a data connection block 83 and a data connection electrode 84, the data connection electrode 84 is connected to the first data connection line 81 through the data connection block 83, and the second data connection line 82 may be connected to the data connection electrode 84 through a via, thereby achieving a connection between the first data connection line 81 and the second data connection line 82.

In an exemplary embodiment, the first data connection line 81, the data connection block 83, and the data connection electrode 84 may be of an interconnected integral structure.

In an exemplary embodiment, the at least one circuit unit may further include a dummy electrode 85, and the second data connection line 82 may be connected to the dummy electrode 85 through a via. The position and shape of the dummy electrode 85 in one circuit unit may be substantially the same as the position and shape of the data connection electrode 84 in another circuit unit, such that the data connection electrode 84 and the dummy electrode 85 present the same morphology and via connection structure.

In an exemplary embodiment, the at least one first data connection line 81 may be provided with a first fracture K1, and the first fracture K1 severs the first data connection line 81. An orthographic projection of the first fracture K1 on the base substrate is at least partially overlapped with an orthographic projection of the first power supply line 71 or the second power supply line 72 on the base substrate.

In an exemplary embodiment, the orthographic projection of the first fracture K1 on the base substrate may be within a range of an orthographic projection of the first power supply line 71 or the second power supply line 72 on the base substrate.

In an exemplary embodiment, the at least one second data connection line 82 may be provided with a second fracture K2, and the second fracture K2 severs the second data connection line 82. An orthographic projection of the second fracture K2 on the base substrate is at least partially overlapped with an orthographic projection of the reference signal line 66 or the initial signal line 67 on the base substrate.

In an exemplary embodiment, the orthographic projection of the second fracture K2 on the base substrate may be within a range of an orthographic projection of the reference signal line 66 or the initial signal line 67 on the base substrate.

In an exemplary embodiment, in one unit row, pixel drive circuits in two adjacent circuit units may be symmetrically disposed with respect to a column centerline, and the column centerline may be a straight line located between two circuit units adjacent in the first direction X and extending along the second direction Y. For example, the pixel drive circuits of the N-th unit column and the (N+1)-th unit column may be disposed symmetrically with respect to the column centerline. As another example, the pixel drive circuits of the (N+1)-th unit column and the (N+2)-th unit column may be disposed symmetrically with respect to the column centerline.

In an exemplary embodiment, the pixel drive circuits in adjacent unit rows may be substantially the same.

In an exemplary embodiment, in a direction perpendicular to the base substrate, the drive circuit layer may at least include a first conductive layer (a first gate metal layer), a second conductive layer (a second gate metal layer), a semiconductor layer, a third conductive layer (a third gate metal layer), a fourth conductive layer (a first source-drain metal layer), and a fifth conductive layer (a second source-drain metal layer), which are sequentially disposed along a direction away from the base substrate. The first electrode plate of the first capacitor and the third electrode plate of the second capacitor may be disposed in the first conductive layer, the second electrode plate of the first capacitor and the fourth electrode plate of the second capacitor may be disposed in the second conductive layer, the second scan signal line 62 and the light emitting signal line 65 may be disposed in the third conductive layer, the first scan signal line 61, the third scan signal line 63, the fourth scan signal line 64, the reference signal line 66, the initial signal line 67 and the first data connection line 81 may be disposed in the fourth conductive layer, and the first power supply line 71, the second power supply line 72, the data signal line 73 and the second data connection line 82 may be disposed in the fifth conductive layer.

Exemplary description is made below through a manufacturing process of the display substrate according to the exemplary embodiment. A "patterning process" mentioned in the present disclosure includes treatments such as deposition of a film layer, photoresist coating on a film layer, mask exposure, development, etching, and photoresist stripping for a metal material, an inorganic material, or a transparent conductive material, and includes treatments such as organic material coating, mask exposure, and development for an organic material. Deposition may be any one or more of sputtering, evaporation, and chemical vapor deposition; coating may be any one or more of spray coating, spin coating, and inkjet printing; and etching may be any one or more of dry etching and wet etching, which is not limited in present disclosure. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" need to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B is located within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A is overlapped with the boundary of the orthographic projection of B.

In an exemplary embodiment, taking four circuit units in one unit row (the M-th unit row) and four unit columns (the N-th unit column, (N+1)-th unit column, (N+2)-th unit column, and (N+3)-th unit column) as an example, the manufacturing process of the display substrate of the present embodiment may include the following operations.

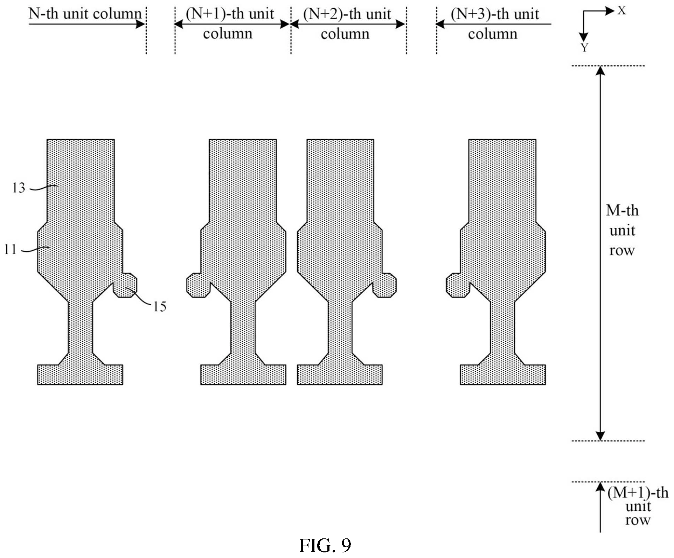

(11) A pattern of a first conductive layer is formed. In an exemplary embodiment, forming the pattern of the first conductive layer may include: depositing a first conductive thin film on a base substrate, patterning the first conductive thin film by a patterning process to form the pattern of the first conductive layer on the base substrate, as shown in FIG. 9. In an exemplary implementation, the first conductive layer may be referred to as a first gate metal (GATE1) layer.

In an exemplary embodiment, the pattern of the first conductive layer of each circuit unit in the display substrate may at least include a first electrode plate 11 of a first capacitor, a third electrode plate 13 of a second capacitor, and an electrode plate connection block 15.

In an exemplary embodiment, the first electrode plate 11 of the first capacitor may be in a shape of a wine glass, a chamfer or a groove may be provided at a corner(s) of the wine glass, and the first electrode plate 11 may serve as a lower electrode plate of the first capacitor.

In an exemplary embodiment, the third electrode plate 13 of the second capacitor may be provided on a side of the first electrode plate 11 in an opposite direction of the second direction Y, the third electrode plate 13 may be in a shape of a rectangle, a chamfer or a groove may be provided at a corner(s) of the rectangle, and the third electrode plate 13 may serve as a lower electrode plate of the second capacitor.

In an exemplary embodiment, the first electrode plate 11 and the third electrode plate 13 may be of an interconnected integral structure, that is, the lower electrode plate of the first capacitor and the lower electrode plate of the second capacitor may be an integral structure.

In an exemplary embodiment, the electrode plate connection block 15 may be in a shape of a block (such as a rectangle), may be provided on a side of the first electrode plate 11 in the first direction X or in an opposite direction of the first direction X, and may be connected to the first electrode 11, and the electrode plate connection block 15 is configured to be connected to a fourth connection electrode formed subsequently.

In an exemplary embodiment, the first electrode plate 11, the third electrode plate 13, and the electrode plate connection block 15 may be of an interconnected integral structure.

In an exemplary embodiment, in one unit row, the spacing between the first conductive layers in two adjacent circuit units may be different. For example, the spacing between the first conductive layer in the N-th unit column and the first conductive layer in the (N+1)-th unit column may be larger than the spacing between the first conductive layer in the (N+1)-th unit column and the first conductive layer in the (N+2)-th unit column.

In an exemplary embodiment, in one unit row, the first conductive layers in two adjacent circuit units may be disposed symmetrically with respect to a column centerline, which may be a straight line located between two adjacent circuit units in the first direction X and extending along the second direction Y. For example, first conductive layers of the N-th unit column and the (N+1)-th unit column may be disposed symmetrically with respect to the column centerline. As another example, the first conductive layers of the (N+1)-th unit column and the (N+2)-th unit column may be disposed symmetrically with respect to the column centerline.

In an exemplary implementation, first conductive layers in adjacent unit rows may be substantially the same.

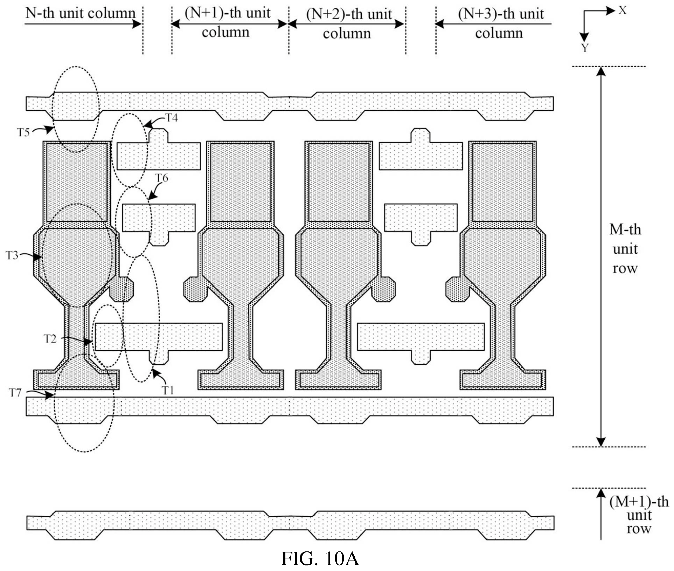

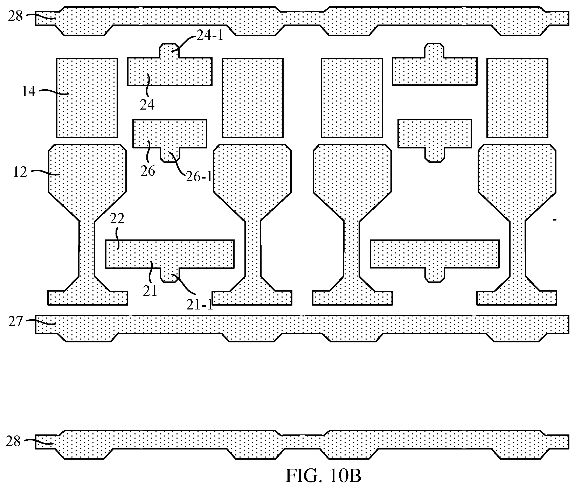

(12) A pattern of a second conductive layer is formed. In an exemplary embodiment, forming the pattern of the second conductive layer may include: depositing sequentially a first insulation thin film and a second conductive thin film on the base substrate on which the aforementioned pattern is formed, and patterning the second conductive thin film by a patterning process to form a first insulation layer that covers the pattern of the first conductive layer, and the pattern of the second conductive layer disposed on the first insulation layer, as shown in FIG. 10A and FIG. 10B. FIG. 10B is a schematic planar diagram of the second conductive layer in FIG. 10A. In an exemplary implementation, the second conductive layer may be referred to as a second gate metal (GATE2) layer.

In an exemplary embodiment, the pattern of the second conductive layer of each circuit unit in the display substrate includes, at least, a second electrode plate 12 of the first capacitor, a fourth electrode plate 14 of the second capacitor, a first bottom gate electrode 21, a second bottom gate electrode 22, a fourth bottom gate electrode 24, a sixth bottom gate electrode 26, a first shelter line 27, and a second shelter line 28.

In an exemplary embodiment, the second electrode plate 12 of the first capacitor may be in a shape of a wine glass, and an orthographic projection of the second electrode plate 12 on the base substrate is at least partially overlapped with an orthographic projection of the first electrode plate 11 on the base substrate. In an exemplary embodiment, the second electrode plate 12 may serve as an upper electrode plate of the first capacitor, and the first electrode plate 11 and the second electrode plate 12 form the first capacitor.

In an exemplary embodiment, the orthographic projection of the second electrode plate 12 on the base substrate is within a range of the orthographic projection of the first electrode plate 11 on the base substrate.

In an exemplary embodiment, the fourth electrode plate 14 of the second capacitor may be disposed on a side of the second electrode plate 12 in the opposite direction of the second direction Y, the fourth electrode plate 14 may be in a shape of a rectangle, a chamfer or a groove may be provided at a corner(s) of the rectangle, and an orthographic projection of the fourth electrode plate 14 on the base substrate is at least partially overlapped with an orthographic projection of the third electrode plate 13 on the base substrate. In an exemplary embodiment, the third electrode plate 13 and the fourth electrode plate 14 form the second capacitor.

In an exemplary embodiment, the orthographic projection of the fourth electrode plate 14 on the base substrate is within a range of the orthographic projection of the third electrode plate 13 on the base substrate.

In an exemplary embodiment, the first bottom gate electrode 21 may be in a shape of a block (such as a rectangle), and may be provided at a side of the second electrode plate 12 in the first direction X or in the opposite direction of the first direction X. The first bottom gate electrode 21 may serve as the bottom gate electrode of the first transistor T1, and may also serve as a shelter layer of the first transistor T1 to shelter the channel region of the first transistor T1, ensuring the electrical performance of the oxide first transistor T1.

In an exemplary embodiment, the second bottom gate electrode 22 may be in a shape of a block (such as a rectangle), and may be disposed between the second electrode plate 12 and the first bottom gate electrode 21, and the second bottom gate electrode 22 may serve as the bottom gate electrode of the second transistor T2, and may also serve as a shelter layer of the second transistor T2 to shelter the channel region of the second transistor T2, ensuring the electrical performance of the oxide second transistor T2.

In an exemplary embodiment, in at least one circuit unit, the first bottom gate electrode 21 and the second bottom gate electrode 22 are of an interconnected integral structure.

In an exemplary implementation, the first bottom gate electrodes 21 of some two circuit units adjacent in the first direction X may be of an interconnected integral structure. For example, the first bottom gate electrode 21 of the N-th unit column and the first bottom gate electrode 21 of the (N+1)-th unit column may be of an interconnected integral structure. As another example, the first bottom gate electrode 21 of the (N+2)-th unit column and the first bottom gate electrode 21 of the (N+3)-th unit column may be of an interconnected integral structure.

In an exemplary embodiment, since the first bottom gate electrode 21 and the second bottom gate electrode 22 in one circuit unit are of an interconnected integral structure, the first bottom gate electrodes 21 and the second bottom gate electrodes 22 of some two circuit units adjacent in the first direction X are of an interconnected integral structure. For example, the first bottom gate electrodes 21 and the second bottom gate electrodes 22 in the N-th unit column and the (N+1)-th unit column in one unit row may be of an interconnected integral structure. As another example, the first bottom gate electrodes 21 and the second bottom gate electrodes 22 in the (N+2)-th unit column and the (N+3)-th unit column in one unit row may be of an interconnected integral structure.

In an exemplary embodiment, a first bottom gate connection block 21-1 may be provided on the first bottom gate electrode 21. The first bottom gate connection block 21-1 may be in a shape of a block (such as a rectangle), may be provided on a side of the first bottom gate electrode 21 away from the sixth bottom gate electrode 26, and connected to the first bottom gate electrode 21, and the first bottom gate connection block 21-1 is configured to be connected to the first scan signal line formed subsequently.

In an exemplary embodiment, the first bottom gate connection block 21-1 may be disposed at a middle position of the first bottom gate electrode 21 of the integral structure, that is, between two circuit units adjacent in the first direction X, so that the first bottom gate electrodes 21 of the two circuit units share a same first bottom gate connection block 21-1.

In the present disclosure, by arranging the first bottom gate electrodes of adjacent circuit units to be an interconnected integral structure the first transistors T1 of two adjacent pixel drive circuits share a same bottom gate electrode and a same bottom gate connection block, which can effectively reduce the occupied space of the pixel drive circuits, and is conducive to the compression of the circuit units under the premise of ensuring the display resolution (PPI).

In an exemplary embodiment, the fourth bottom gate electrode 24 may be in a shape of a block (such as a rectangle), and may be provided on a side of the fourth electrode plate 14 in the first direction X or in the opposite direction of the first direction X. The fourth bottom gate electrode 24 may serve as the bottom gate electrode of the fourth transistor T4, and may also serve as a shelter layer of the fourth transistor T4 to shelter the channel region of the fourth transistor T4, ensuring the electrical performance of the oxide fourth transistor T4.

In an exemplary implementation, the fourth bottom gate electrodes 24 of some two circuit units adjacent in the first direction X may be of an interconnected integral structure. For example, the fourth bottom gate electrode 24 of the N-th unit column and the fourth bottom gate electrode 24 of the (N+1)-th unit column may be of an interconnected integral structure. As another example, the fourth bottom gate electrode 24 of the (N+2)-th unit column and the fourth bottom gate electrode 24 of the (N+3)-th unit column may be of an interconnected integral structure.

In an exemplary embodiment, a fourth bottom gate connection block 24-1 may be provided on the fourth bottom gate electrode 24. The fourth bottom gate connection block 24-1 may be in a shape of a block (such as a rectangle), may be provided on a side of the fourth bottom gate electrode 24 away from the sixth bottom gate electrode 26, and may be connected to the fourth bottom gate electrode 24, and the fourth bottom gate connection block 24-1 is configured to be connected to the third scan signal line formed subsequently.

In an exemplary embodiment, the fourth bottom gate connection block 24-1 may be disposed at a middle position of the fourth bottom gate electrode 24 of the integral structure, that is, between two circuit units adjacent in the first direction X, so that the fourth bottom gate electrodes 24 of the two circuit units share the same fourth bottom gate connection block 24-1.

In the present disclosure, by arranging the fourth bottom gate electrodes of adjacent circuit units to be an interconnected integral structure the fourth transistors T4 of two adjacent pixel drive circuits share a same bottom gate electrode and a same bottom gate connection block, which can effectively reduce the occupied space of the pixel drive circuits, and is conducive to the compression of the circuit units under the premise of ensuring the display resolution (PPI).

In an exemplary embodiment, the sixth bottom gate electrode 26 may be in a shape of a block (such as a rectangle), may be disposed on a side of the fourth electrode plate 14 in the first direction X or in the opposite direction of the first direction X, and is located on a side of the fourth bottom gate electrode 24 in the second direction Y. The sixth bottom gate electrode 26 may serve as the bottom gate electrode of the sixth transistor T6, and may also serve as a shelter layer of the sixth transistor T6 to shelter the channel region of the sixth transistor T6, ensuring the electrical performance of the oxide sixth transistor T6.

In an exemplary implementation, the sixth bottom gate electrodes 26 of some two circuit units adjacent in the first direction X may be of an interconnected integral structure. For example, the sixth bottom gate electrode 26 of the N-th unit column and the sixth bottom gate electrode 26 of the (N+1)-th unit column may be of an interconnected integral structure. As another example, the sixth bottom gate electrode 26 of the (N+2)-th unit column and the sixth bottom gate electrode 26 of the (N+3)-th unit column may be of an interconnected integral structure.

In an exemplary embodiment, a sixth bottom gate connection block 26-1 may be provided on the sixth bottom gate electrode 26. The sixth bottom gate connection block 26-1 may be in a shape of a block (such as a rectangle), may be provided on a side of the sixth bottom gate electrode 26 close to the first bottom gate electrode 21, and may be connected to the sixth bottom gate electrode 26, and the sixth bottom gate connection block 26-1 is configured to be connected to the fourth scan signal line formed subsequently.

In an exemplary embodiment, the sixth bottom gate connection block 26-1 may be disposed at the middle position of the sixth bottom gate electrode 26 of the integral structure, that is, between two circuit units adjacent in the first direction X, so that the sixth bottom gate electrodes 26 of the two circuit units share the same sixth bottom gate connection block 26-1.

In the present disclosure, by arranging the sixth bottom gate electrodes of adjacent circuit units to be an interconnected integral structure the sixth transistors T6 of two adjacent pixel drive circuits share a same bottom gate electrode and a same bottom gate connection block, which can effectively reduce the occupied space of the pixel drive circuits, and is conducive to the compression of the circuit units under the premise of ensuring the display resolution (PPI).

In an exemplary embodiment, the first shelter line 27 may be in a shape of a straight line or a bend line extending along the first direction X, and may be provided on a side of the second electrode plate 12 away from the fourth electrode plate 14. In an exemplary implementation, the first shelter line 27 may be a straight line of unequal widths, a width of a position where the first shelter line 27 is overlapped with a seventh active layer formed subsequently may be greater than widths of other positions, and the first shelter line 27 at a wider position may serve as a shelter layer of the seventh transistor T7 to shelter the channel area of the seventh transistor T7, ensuring the electrical performance of the oxide seventh transistor T7. In an exemplary implementation, the first shelter line 27 may serve as a bottom gate electrode of the seventh transistor T7 at the same time.

In an exemplary embodiment, the second shelter line 28 may be in a shape of a straight line or a bend line extending along the first direction X, and may be provided on a side of the fourth electrode plate 14 away from the second electrode plate 12. In an exemplary embodiment, the second shelter line 28 may be a straight line of unequal widths, a width of a position where the second shelter line 28 is overlapped with a fifth active layer subsequently formed may be greater than widths of other positions, and the second shelter line 28 at a wider position may serve as a shelter layer of the fifth transistor T5 to shelter the channel region of the fifth transistor T5, ensuring the electrical performance of the oxide fifth transistor T5. In an exemplary implementation, the second shelter line 28 may serve as the bottom gate electrode of the fifth transistor T5 at the same time.

In an exemplary implementation, in a unit row, second conductive layers in two adjacent circuit units may be arranged symmetrically with respect to the column centerline. For example, second conductive layers of the N-th unit column and the (N+1)-th unit column may be disposed symmetrically with respect to the column centerline. As another example, the second conductive layers of the (N+1)-th unit column and the (N+2)-th unit column may be disposed symmetrically with respect to the column centerline.

In an exemplary implementation, second conductive layers in adjacent unit rows may be substantially the same.

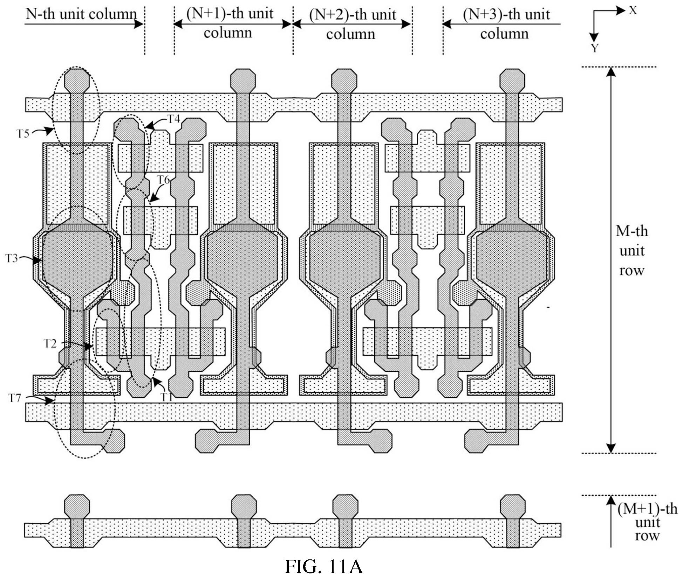

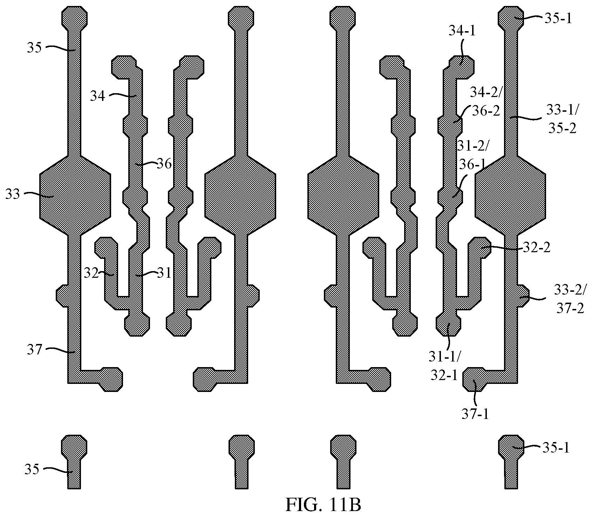

(13) A pattern of a semiconductor layer is formed. In an exemplary implementation, forming the pattern of the semiconductor layer may include: depositing sequentially a second insulation thin film and a semiconductor thin film on the base substrate on which the aforementioned patterns are formed, and patterning the semiconductor thin film through a patterning process to form a second insulation layer covering the second conductive layer, and a pattern of a semiconductor layer disposed on the second insulation layer, as shown in FIG. 11A and FIG. 11B, herein FIG. 11B is a schematic planar diagram of the semiconductor layer in FIG. 11A.

In an exemplary embodiment, the pattern of the semiconductor layer of each circuit unit in the display substrate may include a first active layer 31 of the first transistor T1 to a seventh active layer 37 of the seventh transistor T7, and the first active layer 31, the second active layer 32, the fourth active layer 34, and the sixth active layer 36 may be of an interconnected integral structure, and the third active layer 33, the fifth active layer 35, and the seventh active layer 37 may be of an interconnected integral structure.

In an exemplary embodiment, in the first direction X, the first active layer 31, the second active layer 32, the fourth active layer 34, and the sixth active layer 36 may be located on the same side of the third active layer 33 in the first direction X. In the second direction Y, the fourth active layer 34 and the fifth active layer 35 may be located on a side of the third active layer 33 in the opposite direction of the second direction Y, and the first active layer 31, the second active layer 32, and the seventh active layer 37 may be located on a side of the third active layer 33 in the second direction Y.

In an exemplary embodiment, the third active layer 33 may be in a shape of a hexagon, the first active layer 31, the second active layer 32, the fourth active layer 34, the fifth active layer 35, and the sixth active layer 36 may be in a shape of a strip extending along the second direction Y, and the seventh active layer 37 may be in a shape of "L".

In an exemplary implementation, in an exemplary implementation, an active layer of each transistor may include a first region, a second region, and a channel region located between the first region and the second region. An orthographic projection of the first active layer 31 on the base substrate is at least partially overlapped with an orthographic projection of the first bottom gate electrode 21 on the base substrate, and the overlapping region may serve as a channel region of the first transistor T1. An orthographic projection of the second active layer 32 on the base substrate is at least partially overlapped with an orthographic projection of the second bottom gate electrode 22 on the base substrate, and the overlapping region may serve as a channel region of the second transistor T2. An orthographic projection of the third active layer 33 on the base substrate is at least partially overlapped with an orthographic projection of the second electrode plate 12 (a bottom gate electrode of the third transistor T3) on the base substrate, and the overlapping region may serve as a channel region of the third transistor T3. An orthographic projection of the fourth active layer 34 on the base substrate is at least partially overlapped with an orthographic projection of the fourth bottom gate electrode 24 on the base substrate, and the overlapping region may serve as a channel region of the fourth transistor T4. An orthographic projection of the fifth active layer 35 on the base substrate is at least partially overlapped with an orthographic projection of the second shelter line 28 on the base substrate, and the overlapping region serves as a channel region of the fifth transistor T5. An orthographic projection of the sixth active layer 36 on the base substrate is at least partially overlapped with an orthographic projection of the sixth bottom gate electrode 26 on the base substrate, and the overlapping region serves as a channel region of the sixth transistor T6. An orthographic projection of the seventh active layer 37 on the base substrate is at least partially overlapped with an orthographic projection of the first shelter line 27 on the base substrate, and the overlapping region serves as a channel region of the seventh transistor T7.

In an exemplary implementation, a first region 31-1 of the first active layer and a first region 32-1 of the second active layer may be connected to each other, so that the first region 31-1 of the first active layer may serve as the first region 32-1 of the second active layer. A second region 31-2 of the first active layer and a first region 36-1 of the sixth active layer may be connected with each other, and the second region 13-2 of the first active layer may serve as the first region 36-1 of the sixth active layer. A first region 33-1 of the third active layer and a second region 35-2 of the fifth active layer may be connected to each other, and the first region 33-1 of the third active layer may serve as the second region 35-2 of the fifth active layer. A second region 33-2 of the third active layer and a second region 37-2 of the seventh active layer may be connected with each other, and the second region 33-2 of the third active layer may serve as the second region 37-2 of the seventh active layer. A second region 34-2 of the fourth active layer and a second region 36-2 of the sixth active layer may be connected with each other, that is, the second region 34-2 of the fourth active layer may serve as the second region 36-2 of the sixth active layer. A second region 32-2 of the second active layer, a first region 34-1 of the fourth active layer 34, a first region of the fifth active layer 35, and a first region 37-1 of the seventh active layer may be separately provided.

In an exemplary implementation, in a unit row, semiconductor layers in two adjacent circuit units may be arranged symmetrically with respect to the column centerline. For example, semiconductor layers of the N-th unit column and the (N+1)-th unit column may be disposed symmetrically with respect to the column centerline. As another example, the semiconductor layer layers of the (N+1)-th unit column and the (N+2)-th unit column may be arranged symmetrically with respect to the column centerline.

In an exemplary implementation, semiconductor layers in adjacent unit rows may be substantially the same.

In an exemplary implementation, the semiconductor layer may be made of an oxide, i.e., the first transistor T1 to the seventh transistor T7 are oxide transistors. Oxide transistors have advantages of high electron mobility, low working voltage, low leakage characteristics, etc. In an exemplary implementation, the oxide may be any one or more of following: Indium Gallium Zinc Oxide (InGaZnO), Indium Gallium Zinc Oxynitride (InGaZnON), Zinc Oxide (ZnO), Zinc Oxynitride (ZnON), Zinc Tin Oxide (ZnSnO), Cadmium Tin Oxide (CdSnO), Gallium Tin Oxide (GaSnO), Titanium Tin Oxide (TiSnO), Copper Aluminum Oxide (CuAlO), Strontium Copper Oxide (SrCuO), Lanthanum Copper Oxysulfide (LaCuOS), Gallium Nitride (GaN), Indium Gallium Nitride (InGaN), Aluminum Gallium Nitride (AlGaN), and Indium Gallium Aluminum Nitride (InGaAlN). In some possible implementations, the semiconductor thin film may be made of Indium Gallium Zinc Oxide (IGZO), an electron mobility of Indium Gallium Zinc Oxide (IGZO) is higher than an electron mobility of amorphous silicon.

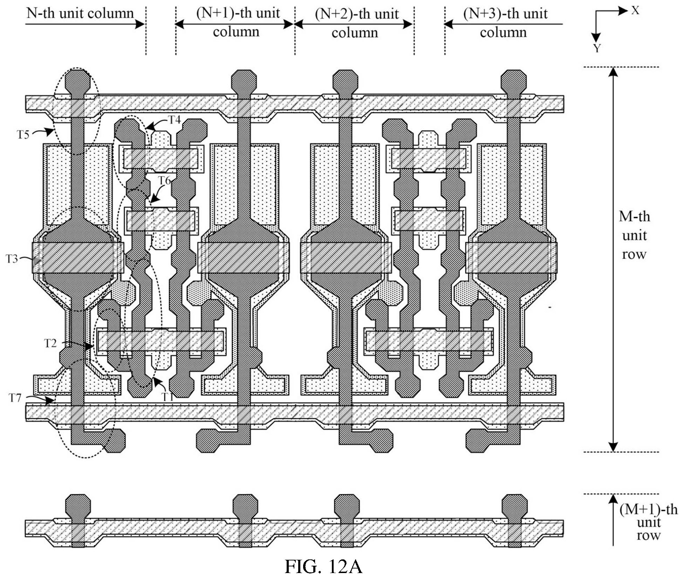

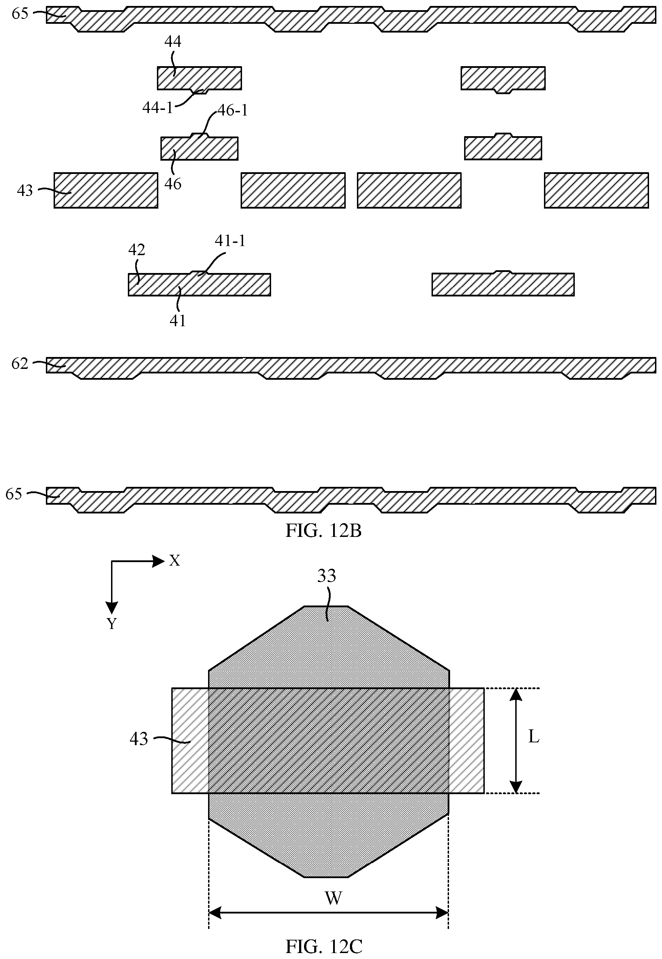

(14) A pattern of a third conductive layer is formed. In an exemplary embodiment, forming the pattern of the third conductive layer may include: depositing sequentially a third insulation thin film and a third conductive thin film on the base substrate on which the aforementioned patterns are formed, patterning the third conductive thin film through a patterning process to form a third insulation layer covering the pattern of the semiconductor layer, and a pattern of a third conductive layer disposed on the third insulation layer, as shown in FIGs. 12A and 12B. FIG. 12B is a schematic diagram of the third conductive layer in FIG. 12A. In an exemplary embodiment, the third conductive layer may be referred to as a third gate metal (GATE3) layer.

In an exemplary embodiment, the pattern of the third conductive layer of each circuit unit in the display substrate at least includes a first top gate electrode 41, a second top gate electrode 42, a third top gate electrode 43, a fourth top gate electrode 44, a sixth top gate electrode 46, a second scan signal line 62, and a light emitting signal line 65.

In an exemplary embodiment, the first top gate electrode 41 may be in a shape of a block (such as a rectangle), an orthographic projection of the first top gate electrode 41 on the base substrate is at least partially overlapped with an orthographic projection of the first active layer on the base substrate, and the first top gate electrode 41 may serve as the top gate electrode of the first transistor T1. In an exemplary embodiment, the orthographic projection of the first top gate electrode 41 on the base substrate is at least partially overlapped with the orthographic projection of the first bottom gate electrode 21 on the base substrate, and the first top gate electrode 41 and the first bottom gate electrode 21 form the first transistor T1 of a top-gate bottom-gate structure.

In an exemplary embodiment, the second top gate electrode 42 may be in a shape of a block (such as a rectangle), an orthographic projection of the second top gate electrode 42 on the base substrate is at least partially overlapped with an orthographic projection of the second active layer on the base substrate, and the second top gate electrode 42 may serve as the top gate electrode of the second transistor T2. In an exemplary implementation, the orthographic projection of the second top gate electrode 42 on the substrate overlaps at least partially with the orthographic projection of the second bottom gate electrode 22 on the substrate, and the second top gate electrode 42 and the second bottom gate electrode 22 form the second transistor T2 of a top-gate bottom-gate structure.

In an exemplary embodiment, in at least one circuit unit, the first top gate electrode 41 and the second top gate electrode 42 are of an interconnected integral structure.

In an exemplary embodiment, the first top gate electrodes 41 of some two circuit units adjacent in the first direction X may be of an interconnected integral structure. For example, the first top gate electrode 41 of the N-th unit column and the first top gate electrode 41 of the (N+1)-th unit column may be of an interconnected integral structure. As another example, the first top gate electrode 41 of the (N+2)-th unit column and the first top gate electrode 41 of the (N+3)-th unit column may be of an interconnected integral structure.

In an exemplary embodiment, since the first top gate electrode 41 and the second top gate electrode 42 in one circuit unit are of an interconnected integral structure, the first top gate electrodes 41 and the second top gate electrodes 42 of some two circuit units adjacent in the first direction X are of an interconnected integral structure. For example, the first top gate electrodes 41 and the second top gate electrodes 42 in the N-th unit column and the (N+1)-th unit column in one unit row may be of an interconnected integral structure. As another example, the first top gate electrodes 41 and the second top gate electrodes 42 in the (N+2)-th unit column and the (N+3)-th unit column in one unit row may be of an interconnected integral structure.

In an exemplary embodiment, a first top gate connection block 41-1 may be provided on the first top gate electrode 41. The first top gate connection block 41-1 may be in a shape of a block (such as a rectangle), may be provided on a side of the first top gate electrode 41 close to the sixth top gate electrode 46, and connected to the first top gate electrode 41, and the first top gate connection block 41-1 is configured to be connected to the first scan signal line formed subsequently.

In an exemplary embodiment, the first top gate connection block 41-1 may be disposed at a middle position of the first top gate electrode 41 of the integral structure, that is, between two circuit units adjacent in the first direction X, so that the first top gate electrodes 41 of the two circuit units share the same first top gate connection block 41-1.

In the present disclosure, by arranging the first top gate electrodes of adjacent circuit units to be an interconnected integral structure, the first transistors T1 of two adjacent pixel drive circuits share a same top gate electrode and a top gate connection block, which can effectively reduce the occupied space of the pixel drive circuits, and is conducive to the compression of the circuit units under the premise of ensuring the display resolution (PPI).

In an exemplary embodiment, the third top gate electrode 43 may be in a shape of a strip extending along the first direction X, an orthographic projection of the third top gate electrode 43 on the base substrate is at least partially overlapped with an orthographic projection of the third active layer on the base substrate, the third top gate electrode 43 may serve as the gate electrode of the third transistor T3, and the third transistor T3 is a transistor of a top gate structure.

In an exemplary embodiment, the fourth top gate electrode 44 may be in a shape of a block (such as a rectangle), an orthographic projection of the fourth top gate electrode 44 on the base substrate is at least partially overlapped with an orthographic projection of the fourth active layer on the base substrate, and the fourth top gate electrode 44 may serve as the top gate electrode of the fourth transistor T4. In an exemplary embodiment, an orthographic projection of the fourth top gate electrode 44 on the base substrate is at least partially overlapped with an orthographic projection of the fourth bottom gate electrode 24 on the base substrate, and the fourth top gate electrode 44 and the fourth bottom gate electrode 24 form the fourth transistor T4 of a top-gate bottom-gate structure.

In an exemplary embodiment, the fourth top gate electrodes 44 of some two circuit units adjacent in the first direction X may be of an interconnected integral structure. For example, the fourth top gate electrode 44 of the N-th unit column and the fourth top gate electrode 44 of the (N+1)-th unit column may be of an interconnected integral structure. For another example, a fourth top gate electrode 44 of the (N+2)-th unit column and a fourth top gate electrode 44 of the (N+3)-th unit column may be of an interconnected integral structure.

In an exemplary embodiment, a fourth top gate connection block 44-1 may be provided on the fourth top gate electrode 44. The fourth top gate connection block 44-1 may be in a shape of a block (such as a rectangle), may be provided on a side of the fourth top gate electrode 44 close to the sixth top gate electrode 46, and may be connected to the fourth top gate electrode 44, and the fourth top gate connection block 44-1 is configured to be connected to the third scan signal line formed subsequently.

In an exemplary embodiment, the fourth top gate connection block 44-1 may be disposed at a middle position of the fourth top gate electrode 44 of the integral structure, that is, between two circuit units adjacent in the first direction X, so that the fourth top gate electrodes 44 of the two circuit units share the same fourth top gate connection block 44-1.

In the present disclosure, by arranging the fourth top gate electrodes of adjacent circuit units to be an interconnected integral structure the fourth transistors T4 of two adjacent pixel drive circuits share a same top gate electrode and a top gate connection block, which can effectively reduce the occupied space of the pixel drive circuits, and is conducive to the compression of the circuit units under the premise of ensuring the display resolution (PPI).

In an exemplary embodiment, the sixth top gate electrode 46 may be in a shape of a block (such as a rectangle), an orthographic projection of the sixth top gate electrode 46 on the base substrate is at least partially overlapped with an orthographic projection of the sixth active layer on the base substrate, and the sixth top gate electrode 46 may serve as the top gate electrode of the sixth transistor T6. In an exemplary embodiment, an orthographic projection of the sixth top gate electrode 46 on the base substrate is at least partially overlapped with an orthographic projection of the sixth bottom gate electrode 26 on the base substrate, the sixth top gate electrode 46 and the sixth bottom gate electrode 26 form the sixth transistor T6 of a top-gate bottom-gate structure.

In an exemplary embodiment, the sixth top gate electrodes 46 of some two circuit units adjacent in the first direction X may be of an interconnected integral structure. For example, the sixth top gate electrode 46 of the N-th unit column and the sixth top gate electrode 46 of the (N+1)-th unit column may be of an interconnected integral structure. As another example, the sixth top gate electrode 46 of the (N+2)-th unit column and the sixth top gate electrode 46 of the (N+3)-th unit column may be of an interconnected integral structure.

In an exemplary embodiment, a sixth top gate connection block 46-1 may be provided on the sixth top gate electrode 46. The sixth top gate connection block 46-1 may be in a shape of a block (such as a rectangle), may be provided on a side of the sixth top gate electrode 46 away from the first top gate electrode 41, and may be connected to the sixth top gate electrode 46, and the sixth top gate connection block 46-1 is configured to be connected to the fourth scan signal line formed subsequently.

In an exemplary embodiment, the sixth top gate connection block 46-1 may be disposed at the middle position of the sixth top gate electrode 46 of the integral structure, that is, between two circuit units adjacent in the first direction X, so that the sixth top gate electrodes 46 of the two circuit units share the same sixth top gate connection block 46-1.

In the present disclosure, by arranging the sixth top gate electrodes of adjacent circuit units to be an interconnected integral structure the sixth transistors T6 of two adjacent pixel drive circuits share the same top gate electrode and top gate connection block, which can effectively reduce the occupied space of the pixel drive circuits, and is conducive to the compression of the circuit units under the premise of ensuring the display resolution (PPI).

In an exemplary embodiment, the second scan signal line 62 may be in a shape of a straight line or a bend line extending along the first direction X, and may be provided on a side of the second electrode plate 12 away from the fourth electrode plate 14, and a region where the second scan signal line 62 is overlapped with the seventh active layer serves as a top gate electrode of the seventh transistor T7.

In an exemplary embodiment, the second scan signal line 62 may be a straight line of unequal widths, and a width of a position where the second scan signal line 62 is overlapped with the seventh active layer may be greater than widths of other positions. An orthographic projection of the second scan signal line 62 on the base substrate is at least partially overlapped with an orthographic projection of the first shelter line 27 on the base substrate, and the second scan signal line 62 and the first shelter line 27 may be connected with a same signal source, so that the first shelter line 27 may serve as a bottom gate electrode of the seventh transistor T7, and the second scan signal line 62 may serve as a top gate electrode of the seventh transistor T7, to form the seventh transistor T7 of a top-gate bottom-gate structure.

In an exemplary embodiment, the light emitting signal line 65 may be in a shape of a straight line or a bend line extending along the first direction X, and may be provided on a side of the fourth electrode plate 14 away from the second electrode plate 12, and a region where the light emitting signal line 65 is overlapped with the fifth active layer serves as a top gate electrode of the fifth transistor T5.

In an exemplary embodiment, the light emitting signal line 65 may be a straight line of unequal widths, and a width of a position where the light emitting signal line 65 is overlapped with the fifth active layer may be larger than widths of other positions. An orthographic projection of the light emitting signal line 65 on the base substrate is at least partially overlapped with an orthographic projection of the second shelter line 28 on the base substrate, and the light emitting signal line 65 and the second shelter line 28 may be connected to a same signal source, so that the second shelter line 28 may serve as the bottom gate electrode of the fifth transistor T5, and the light emitting signal line 65 may serve as the top gate electrode of the fifth transistor T5, to form the fifth transistor T5 of a top-gate bottom-gate structure.

In an exemplary implementation, in a unit row, third conductive layers in two adjacent circuit units may be arranged symmetrically with respect to the column centerline. For example, third conductive layers of the N-th unit column and the (N+1)-th unit column may be disposed symmetrically with respect to the column centerline. As another example, the third conductive layers of the (N+1)-th unit column and the (N+2)-th unit column may be disposed symmetrically with respect to the column centerline.

In an exemplary implementation, third conductive layers in adjacent unit rows may be substantially the same.

In an exemplary implementation, after the pattern of the third conductive layer is formed, a conductive treatment may be performed on the semiconductor layer by using the third conductive layer as a shelter, a region of the semiconductor layer sheltered by the second conductive layer forms channel regions of the first transistor T1 to the seventh transistor T7, and a region of the semiconductor layer not sheltered by the third conductive layer is made to be conductive, i.e., all of the first regions and the second regions of the first active layer to the seventh active layer are made to be conductive.

FIG. 12C is an enlarged view of the third transistor in FIG. 12A. As shown in FIGs. 12A, 12B, and 12C, an overlapping region of an orthographic projection of the third top gate electrode 43 on the base substrate and an orthographic projection of the third active layer on the base substrate is a channel region of the third transistor T3, and the channel region has a channel length L which is a dimension in the second direction Y and a channel width W which is a dimension in the first direction X.

In an exemplary embodiment, the width-to-length ratio of the third transistor T3 as the drive transistor is a ratio of the channel width W to the channel length L, that is, W/L.

In an exemplary embodiment, the width-to-length ratio W/L of the third transistor T3 may be less than 1. Here, the width-to-length ratio W/L of the third transistor T3 may be about 0.27 to 0.8. For example, the aspect ratio W/L may be about 6/10, or may be about 6/14, or may be about 6/18, or may be about 6/22. As another example, the width-to-length ratio W/L may be about 8/10, or may be about 8/14, or may be about 8/18, or may be about 8/22.

In a preferred embodiment, the width-to-length ratio W/L of the third transistor T3 may be about 0.44 to 0.8. For example, the width-to-length ratio W/L may be about 8/10. As another example, the width-to-length ratio W/L may be about 8/14. As another example, the aspect ratio W/L may be about 8/18.

In another exemplary embodiment, the width-to-length ratio W/L of the third transistor T3 may be greater than 1. Here, the width-to-length ratio W/L of the third transistor T3 may be about 1.25 to 2.67. For example, the width-to-length ratio W/L may be about 10/6, or may be about 12/6, or may be about 14/6, or may be about 16/6. As another example, the width-to-length ratio W/L may be about 10/8, or may be about 12/8, or may be about 14/8, or may be about 16/8.

In a preferred embodiment, the width-to-length ratio W/L of the third transistor T3 may be about 1.67 to 2.67. For example, the width-to-length ratio W/L may be about 10/6. As another example, the width-to-length ratio W/L may be about 12/6. As another example, the width-to-length ratio W/L may be about 14/6 or about 16/6.

In the present disclosure, by setting the width-to-length ratio of the third transistor T3, the driving performance of the pixel drive circuit can be effectively improved and the display quality can be improved.

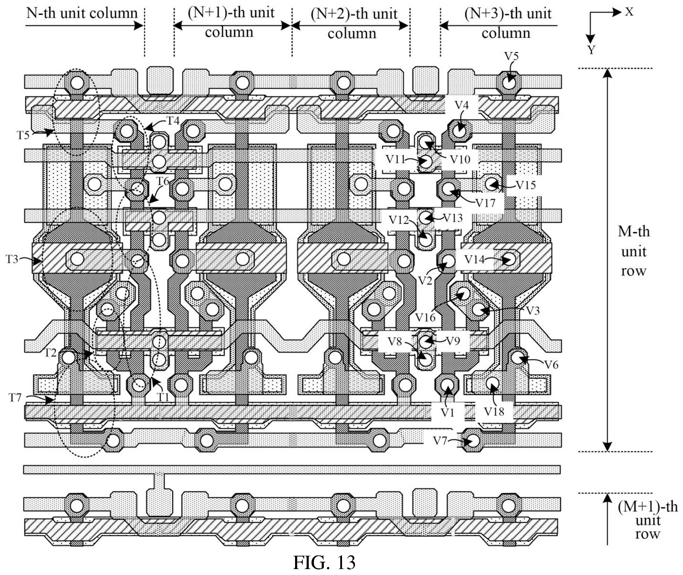

(15) A pattern of a fourth insulation layer is formed. In an exemplary implementation, forming the pattern of the fourth insulation layer may include: depositing a fourth insulation thin film on the base substrate on which the aforementioned patterns are formed, and patterning the fourth insulation thin film by a patterning process, to form a fourth insulation layer covering the third conductive layer, wherein a plurality of vias are provided on the fourth insulation layer, as shown in FIG. 13.

In an exemplary implementation, a plurality of vias of each circuit unit in the display substrate at least include: a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, a fourteenth via V14, a fifteenth via V15, a sixteenth via V16, a seventeenth via V17 and an eighteenth via V18.

In an exemplary embodiment, an orthographic projection of the first via V1 on the base substrate is within a range of an orthographic projection of the first region of the first active layer (also the first region of the second active layer) on the base substrate, the third insulation layer and the fourth insulation layer within the first via V1 are etched away to expose a surface of the first region of the first active layer (also the first region of the second active layer), and the first via V1 is configured such that a subsequently formed reference signal line is connected with the first region of the first active layer (also the first region of the second active layer) through this via. In an exemplary embodiment, the first via V1 may be referred to as a first active via.

In an exemplary embodiment, an orthographic projection of the second via V2 on the base substrate is within a range of an orthographic projection of a second region of the first active layer (also a first region of the sixth active layer) on the base substrate, the third insulation layer and the fourth insulation layer within the second via V2 are etched away to expose a surface of the second region of the first active layer (also the first region of the sixth active layer), and the second via V2 is configured such that a subsequently formed first connection electrode is connected with the second region of the first active layer (also the first region of the sixth active layer) through this via.

In an exemplary embodiment, an orthographic projection of the third via V3 on the base substrate is within a range of an orthographic projection of a second region of the second active layer on the base substrate, the third insulation layer and the fourth insulation layer within the third via V3 are etched away to expose a surface of the second region of the second active layer, and the third via V3 is configured such that a fourth connection electrode formed subsequently is connected with the second region of the second active layer through this via.

In an exemplary embodiment, an orthographic projection of the fourth via V4 on the base substrate is within a range of an orthographic projection of a first region of the fourth active layer on the base substrate, the third insulation layer and the fourth insulation layer within the fourth via V4 are etched away to expose a surface of the first region of the fourth active layer, and the fourth via V4 is configured such that a subsequently formed fifth connection electrode is connected with the first region of the fourth active layer through this via.

In an exemplary embodiment, an orthographic projection of the fifth via V5 on the base substrate is within a range of an orthographic projection of a first region of the fifth active layer on the base substrate, the third insulation layer and the fourth insulation layer in the fifth via V5 are etched away to expose a surface of the first region of the fifth active layer, and the fifth via V5 is configured such that a subsequently formed first power supply connection line is connected with the first region of the fifth active layer through this via.

In an exemplary embodiment, an orthographic projection of the sixth via V6 on the base substrate is within a range of an orthographic projection of a second region of the third active layer (also a second region of the seventh active layer) on the base substrate, the third insulation layer and the fourth insulation layer within the sixth via V6 are etched away to expose a surface of the second region of the third active layer (also the second region of the seventh active layer), and the sixth via V6 is configured such that a subsequently formed third connection electrode is connected with the first region of the second region of the third active layer (also the second region of the seventh active layer) through this via.

In an exemplary embodiment, an orthographic projection of the seventh via V7 on the base substrate is within a range of an orthographic projection of a first region of the seventh active layer on the base substrate, the third insulation layer and the fourth insulation layer within the seventh via V7 are etched away to expose a surface of the first region of the seventh active layer, and the seventh via V7 is configured such that a subsequently formed initial signal line is connected with the first region of the seventh active layer through this via. In an exemplary embodiment, the seventh via V7 may be referred to as a seventh active via.

In an exemplary embodiment, an orthographic projection of the eighth via V8 on the base substrate is within a range of an orthographic projection of the first bottom gate connection block 21-1 on the base substrate, the fourth insulation layer, the third insulation layer, and the second insulation layer in the eighth via V8 are etched away to expose a surface of the first bottom gate connection block 21-1, and the eighth via V8 is configured such that a subsequently formed first scan signal line is connected with the first bottom gate connection block 21-1 through this via.

In an exemplary embodiment, since the first bottom gate electrodes 21 of two circuit units share the same first bottom gate connection block 21-1, the two circuit units may share the same eighth via V8, which can effectively reduce the occupied space of the pixel drive circuits, and is beneficial to the compression of the circuit units. In an exemplary embodiment, the eighth via V8 may be referred to as a first bottom gate connection via.

In an exemplary embodiment, an orthographic projection of the ninth via V9 on the base substrate is within a range of an orthographic projection of the first top gate connection block 41-1 on the base substrate, the fourth insulation layer in the ninth via V9 is etched away to expose a surface of the first top gate connection block 41-1, and the ninth via V9 is configured such that a subsequently formed first scan signal line is connected with the first top gate connection block 41-1 through this via.

In an exemplary embodiment, since the first top gate electrodes 41 of two circuit units share a same first top gate connection block 41-1, the two circuit units may share a same ninth via V9, which can effectively reduce the occupied space of the pixel drive circuits, and is beneficial to the compression of the circuit units. In an exemplary embodiment, the ninth via V9 may be referred to as a first top gate connection via.

In an exemplary embodiment, an orthographic projection of the tenth via V10 on the base substrate is within a range of an orthographic projection of the fourth bottom gate connection block 24-1 on the base substrate, the fourth insulation layer, the third insulation layer, and the second insulation layer in the tenth via V10 are etched away to expose a surface of the fourth bottom gate connection block 24-1, and the tenth via V10 is configured such that a third scan signal line formed subsequently is connected with the fourth bottom gate connection block 24-1 through this via.

In an exemplary embodiment, since the fourth bottom gate electrodes 24 of two circuit units share a same fourth bottom gate connection block 24-1, the two circuit units may share a same tenth via V10, which can effectively reduce the occupied space of the pixel drive circuits, and is beneficial to the compression of the circuit units. In an exemplary embodiment, the tenth via V10 may be referred to as a fourth bottom gate connection via.

In an exemplary embodiment, an orthographic projection of the eleventh via V11 on the base substrate is within a range of an orthographic projection of the fourth top gate connection block 44-1 on the base substrate, the fourth insulation layer in the eleventh via V11 is etched away to expose a surface of the fourth top gate connection block 44-1, and the eleventh via V11 is configured such that a third scan signal line formed subsequently is connected with the fourth top gate connection block 44-1 through this via.

In an exemplary embodiment, since the fourth top gate electrodes 44 of two circuit units share a same fourth top gate connection block 44-1, the two circuit units may share a same eleventh via V11, which can effectively reduce the occupied space of the pixel drive circuit and facilitate the compression of the circuit units. In an exemplary embodiment, the eleventh via V11 may be referred to as a fourth top gate connection via.

In an exemplary embodiment, an orthographic projection of the twelfth via V12 on the base substrate is within a range of an orthographic projection of the sixth bottom gate connection block 26-1 on the base substrate, the fourth insulation layer, the third insulation layer, and the second insulation layer in the twelfth via V12 are etched away to expose a surface of the sixth bottom gate connection block 26-1, and the twelfth via V12 is configured such that a fourth scan signal line formed subsequently is connected with the sixth bottom gate connection block 26-1 through this via.

In an exemplary embodiment, since the sixth bottom gate electrodes 26 of two circuit units share a same sixth bottom gate connection block 26-1, the two circuit units may share a same twelfth via V12, which can effectively reduce the occupied space of the pixel drive circuits, and is beneficial to the compression of the circuit units. In an exemplary embodiment, the twelfth via V12 may be referred to as a sixth bottom gate connection via.

In an exemplary embodiment, an orthographic projection of the thirteenth via V13 on the base substrate is within a range of an orthographic projection of the sixth top gate connection block 46-1 on the base substrate, the fourth insulation layer in the thirteenth via V13 is etched away to expose a surface of the sixth top gate connection block 46-1, and the thirteenth via V13 is configured such that a fourth scan signal line formed subsequently is connected with the sixth top gate connection block 46-1 through this via.

In an exemplary embodiment, since the sixth top gate electrodes 46 of two circuit units share a same sixth top gate connection block 46-1, the two circuit units may share a same thirteenth via V13, which can effectively reduce the occupied space of the pixel drive circuits, and is beneficial to the compression of the circuit units. In an exemplary embodiment, the thirteenth via V13 may be referred to as a sixth top gate connection via.

In an exemplary embodiment, an orthographic projection of the fourteenth via V14 on the base substrate is within a range of an orthographic projection of the third top gate electrode 43 on the base substrate, the fourth insulation layer in the fourteenth via V14 is etched away to expose a surface of the third top gate electrode 43, and the fourteenth via V14 is configured such that a subsequently formed first connection electrode 51 is connected with the third top gate electrode 43 through this via.

In an exemplary embodiment, an orthographic projection of the fifteenth via V15 on the base substrate is within a range of an orthographic projection of the fourth electrode plate 14 on the base substrate, the fourth insulation layer, the third insulation layer, and the second insulation layer within the fifteenth via V15 are etched away to expose a surface of the fourth electrode plate 14, and the fifteenth via V15 is configured such that a subsequently formed second connection electrode is connected with the fourth electrode plate 14 through this via.

In an exemplary embodiment, an orthographic projection of the sixteenth via V16 on the base substrate is within a range of an orthographic projection of the electrode plate connection block 15 on the base substrate, the fourth insulation layer, the third insulation layer, the second insulation layer, and the first insulation layer within the sixteenth via V16 are etched away to expose a surface of the electrode plate connection block 15, and the sixteenth via V16 is configured such that a subsequently formed fourth connection electrode is connected with the electrode plate connection block 15 through this via.

In an exemplary embodiment, an orthographic projection of the seventeenth via V17 on the base substrate is within a range of an orthographic projection of a second region of the fourth active layer (also a second region of the sixth active layer) on the base substrate, the third insulation layer and the fourth insulation layer within the seventeenth via V17 are etched away to expose a surface of the second region of the fourth active layer (also the second region of the sixth active layer), and the seventeenth via V17 is configured such that a subsequently formed second connection electrode is connected with the second region of the fourth active layer (also the second region of the sixth active layer) through this via.

In an exemplary embodiment, an orthographic projection of the eighteenth via V18 on the base substrate is within a range of an orthographic projection of the second electrode plate 12 on the base substrate, the fourth insulation layer, the third insulation layer, and the second insulation layer within the eighteenth via V18 are etched away to expose a surface of the second electrode plate 12, and the eighteenth via V18 is configured such that a third connection electrode formed subsequently is connected with the second electrode plate 12 through this via.

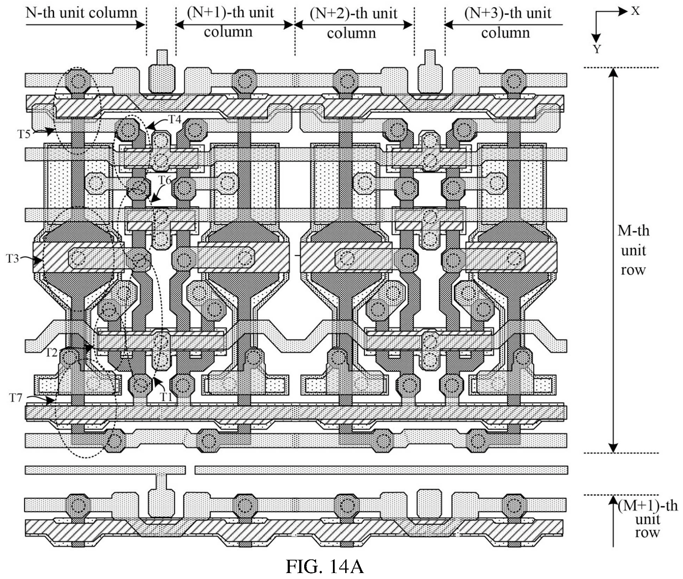

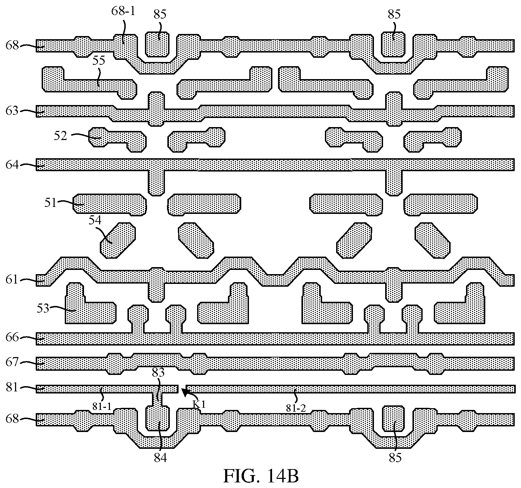

(16) A pattern of a fourth conductive layer is formed. In an exemplary embodiment, forming the pattern of the fourth conductive layer may include: depositing a fourth conductive thin film on the base substrate on which the aforementioned patterns are formed, and patterning the fourth conductive thin film through a patterning process to form the fourth conductive layer disposed on the fourth insulation layer, as shown in FIG. 14A and FIG. 14B. FIG. 14B is a schematic planar diagram of the fourth conductive layer in FIG. 14A. In an exemplary embodiment, the fourth conductive layer may be referred to as a first source drain metal (SD1) layer.

In an exemplary embodiment, the fourth conductive layer of each circuit unit at least includes a first connection electrode 51, a second connection electrode 52, a third connection electrode 53, a fourth connection electrode 54, a fifth connection electrode 55, a first scan signal line 61, a third scan signal line 63, a fourth scan signal line 64, a reference signal line 66, an initial signal line 67, and a first power supply connection line 68.

In an exemplary embodiment, the first scan signal line 61, the third scan signal line 63, the fourth scan signal line 64, the reference signal line 66, the initial signal line 67, and the first power supply connection line 68 may be in a shape of a straight line or a bend line extending along the first direction X, and are continuously provided in an unit row. The third scan signal line 63, the fourth scan signal line 64, and the first power supply connection line 68 may be located on a side of the third top gate electrode 43 in the opposite direction of the second direction Y, and the first scan signal line 61, the reference signal line 66, and the initial signal line 67 may be located on a side of the third top gate electrode 43 in the second direction Y.

In an exemplary embodiment, the fourth scan signal line 64 may be located on a side of the third top gate electrode 43 in the opposite direction of the second direction Y, the third scan signal line 63 may be located on a side of the fourth scan signal line 64 away from the third top gate electrode 43, and the first power supply connection line 68 may be located on a side of the third scan signal line 63 away from the third top gate electrode 43.

In an exemplary embodiment, the first scan signal line 61 may be located on a side of the third top gate electrode 43 in the second direction Y, the reference signal line 66 may be located on a side of the first scan signal line 61 away from the third top gate electrode 43, and the initial signal line 67 may be located on a side of the reference signal line 66 away from the third top gate electrode 43.

In an exemplary embodiment, an orthographic projection of the first scan signal line 61 on the base substrate is at least partially overlapped with orthographic projections of the first bottom gate electrode 21, the second bottom gate electrode 22, the first top gate electrode 41, and the second top gate electrode 42 on the base substrate, and the first scan signal line 61 is connected to the first bottom gate connection block 21-1 through the eighth via V8 on the one hand, and to the first top gate connection block 41-1 through the ninth via V9 on the other hand. Since the first bottom gate connection block 21-1 is connected to the first bottom gate electrode 21 and the second bottom gate electrode 22, respectively, and the first top gate connection block 41-1 is connected to the first top gate electrode 41 and the second top gate electrode 42, respectively, it is achieved that the first scan signal line 61 is simultaneously connected to the bottom gate electrode of the first transistor T1, the top gate electrode of the first transistor T1, the bottom gate electrode of the second transistor T2 and the top gate electrode of the second transistor T2, and the first scan signal line 61 may simultaneously control the turn-on or turn-off of the first transistor T1 and the second transistor T2.

In an exemplary embodiment, an orthographic projection of the third scan signal line 63 on the base substrate is at least partially overlapped with orthographic projections of the fourth bottom gate electrode 24 and the fourth top gate electrode 44 on the base substrate, and the third scan signal line 63 is connected to the fourth bottom gate connection block 24-1 through the tenth via V10 on the one hand, and to the fourth top gate connection block 44-1 through the eleventh via V11 on the other hand. Since the fourth bottom gate connection block 24-1 is connected to the fourth bottom gate electrode 24, and the fourth top gate connection block 44-1 is connected to the fourth top gate electrode 44, it is achieved that the third scan signal line 63 is simultaneously connected to the bottom gate electrode of the fourth transistor T4 and the top gate electrode of the fourth transistor T4, and the third scan signal line 63 may control the turn-on or turn-off of the fourth transistor T4.

In an exemplary embodiment, an orthographic projection of the fourth scan signal line 64 on the base substrate is at least partially overlapped with orthographic projections of the sixth bottom gate electrode 26 and the sixth top gate electrode 46 on the base substrate, and the fourth scan signal line 64 is connected to the sixth bottom gate connection block 26-1 through the twelfth via V12 on the one hand, and to the sixth top gate connection block 46-1 through the thirteenth via V13 on the other hand. Since the sixth bottom gate connection block 26-1 is connected to the sixth bottom gate electrode 26, and the sixth top gate connection block 46-1 is connected to the sixth top gate electrode 46, it is achieved that the fourth scan signal line 64 is simultaneously connected to the bottom gate electrode of the sixth transistor T6 and the top gate electrode of the sixth transistor T6, and the fourth scan signal line 64 can control the turn-on or turn-off of the sixth transistor T6.

In an exemplary embodiment, by disposing the first scan signal line 61, the third scan signal line 63, and the fourth scan signal line 64 in the first source-drain metal (SD1) layer, the present disclosure effectively reduces the resistances of the scan signal lines, reduces the voltage drops of the scan signals, and can improve the compensation speed and the display quality.

In an exemplary embodiment, the reference signal line 66 is connected to the first region of the first active layer (also the first region of the second active layer) in each circuit unit through the first via V1, thus it is achieved the reference signal line 66 may write a reference signal to the first electrode of the first transistor T1 and the first electrode of the second transistor T2 at the same time.

In an exemplary embodiment, an orthographic projection of the reference signal line 66 on the base substrate is at least partially overlapped with an orthographic projection of the second scan signal line 62 on the base substrate, and the reference signal line 66 having the constant voltage signal can effectively shield the interference of other signals in the pixel drive circuits on the second scan signal line 62, and improve the transmission quality of the second scan signal.

In an exemplary implementation, the initial signal line 67 is connected to the first region of the seventh active layer in each circuit unit through the seventh via V7, thus it is achieved that an initial signal may be written by the initial signal line 67 to the first electrode of the seventh transistor T7.

In an exemplary embodiment, the first power supply connection line 68 is connected to the first region of the fifth active layer through the fifth via V5. Since the first power supply connection line 68 is connected to the first power supply line formed subsequently, it is achieved that the first power supply line may write the first power supply signal to the first electrode of the fifth transistor T5.

In an exemplary embodiment, a first power supply connection block 68-1 may be connected to the first power supply connection line 68, and the first power supply connection block 68-1 is configured to be connected to a subsequently formed first power supply line. In an exemplary implementation, the first power supply connection line 68 may be provided in each circuit unit, respectively.

In an exemplary embodiment, the first connection electrode 51 may have a main body portion with a shape of a strip extending along the first direction X, a first end of the first connection electrode 51 is connected to the second region of the first active layer (also the first region of the sixth active layer) through the second via V2, and a second end of the first connection electrode 51 is connected to the third top gate electrode 43 through the fourteenth via V14. In an exemplary embodiment, interconnection between the second electrode of the first transistor T1, the gate electrode of the third transistor T3, and the first electrode of the sixth transistor T6 is achieved by the first connection electrode 51, to form the first node N1 of the pixel drive circuit.

In an exemplary embodiment, the second connection electrode 52 may be in a shape of a strip extending along the first direction X, a first end of the second connection electrode 52 is connected to the second region of the fourth active layer (also the second region of the sixth active layer) through the seventeenth via V17, and a second end of the second connection electrode 52 is connected to the fourth electrode plate 14 through the fifteenth via V15. In an exemplary embodiment, interconnection between the second electrode of the fourth transistor T4, the second electrode of the sixth transistor T6, and the fourth electrode plate 14 of the second capacitor is achieved by the second connection electrode 52, to form the second node N2 of the pixel drive circuit.

In an exemplary embodiment, the third connection electrode 53 may be in a shape of "L", a first end of the third connection electrode 53 is connected to the second region of the third active layer (also the second region of the seventh active layer) through the sixth via V6, and a second end of the third connection electrode 53 is connected to the second electrode plate 12 through the eighteenth via V18. In an exemplary embodiment, interconnection between the second electrode of the third transistor T3, the second electrode of the seventh transistor T7, and the second electrode plate 12 (an upper electrode plate) of the first capacitor is achieved by the third connection electrode 53, to form the third node N3 of the pixel drive circuit. In an exemplary implementation, the third connection electrode 53 is configured to be connected to an anode connection electrode formed subsequently.

In an exemplary embodiment, the fourth connection electrode 54 may be in a shape of a block (such as a rectangle), a first end of the fourth connection electrode 54 is connected to the second region of the second active layer through the third via V3, and a second end of the fourth connection electrode 54 is connected to the electrode plate connection block 15 through the sixteenth via V16. Since the electrode plate connection block 15 is connected to the first electrode plate 11 and the third electrode plate 13, interconnection between the second electrode of the second transistor T2, the first electrode plate 11 (a lower electrode plate) of the first capacitor, and the third electrode plate 13 (a lower electrode plate) of the second capacitor is achieved by the fourth connection electrode 54, to form the fourth node N4 of the pixel drive circuit.

In an exemplary embodiment, since the first electrode plate 11 and the third electrode plate 13 are connected to each other and are connected to the second electrode of the second transistor T2 through the fourth connection electrode 54, the first electrode plate 11 and the third electrode plate 13 have a potential of the fourth node N4 in the pixel drive circuit. Since the second electrode plate 12 is connected to the second electrode of the third transistor T3 and the second electrode of the seventh transistor T7 through the third connection electrode 53, the second electrode plate 12 has a potential of the third node N3 in the pixel drive circuit. Since the fourth electrode plate 14 is connected to the second electrode of the fourth transistor T4 and the second electrode of the sixth transistor T6 through the second connection electrode 52, the fourth electrode plate 14 has a potential of the second node N2 in the pixel drive circuit. Thus, the first electrode plate 11 having the potential of the fourth node N4 and the second electrode plate 12 having the potential of the third node N3 form the first capacitor, and the third electrode plate 13 having the potential of the fourth node N4 and the fourth electrode plate 14 having the potential of the second node N2 form the second capacitor.

In an exemplary embodiment, the fifth connection electrode 55 may have a main body portion with a shape of a strip extending along the first direction X, a first end of the fifth connection electrode 55 is connected to the first region of the fourth active layer through the fourth via V4, a second end of the fifth connection electrode 55 extends in a direction away from the fourth transistor T4, and a second end of the fifth connection electrode 55 is configured to be connected to a data signal line formed subsequently.

In an exemplary implementation, the fourth conductive layer of at least one circuit unit may further include a first data connection line 81. The first data connection line 81 may be in a shape of a straight line or a bend line extending along the first direction X, and may be provided in a lateral trace space between some adjacent unit rows.

In an exemplary embodiment, at least one first data connection line 81 may be provided with a first fracture K1, and the first fracture K1 may sever the first data connection line 81, so that the first data connection lines 81 on two sides of the first fracture K1 are insulated from each other.

In an exemplary embodiment, the first data connection line 81 may include a first connection sub-line 81-1 and a second connection sub-line 81-2 located on two sides of the first fracture K1 in the first direction X, respectively, the first connection sub-line 81-1 is configured to be connected to a data signal line in the display region, and the second connection sub-line 81-2 is configured as a first dummy line.

In an exemplary embodiment, the first connection sub-line 81-1 may be located on a side of the first fracture K1 in the first direction X, and the second connection sub-line 81-2 may be located on a side of the first fracture K1 in the opposite direction of the first direction X. In another exemplary embodiment, the first connection sub-line 81-1 may be located on a side of the first fracture K1 in the opposite direction of the first direction X, and the second connection sub-line 81-2 may be located on a side of the first fracture K1 in the first direction X.

In an exemplary embodiment, at least one first connection sub-line 81-1 may be provided with a data connection block 83 and a data connection electrode 84, the data connection block 83 may be in a shape of a strip extending along the second direction Y, the data connection electrode 84 may be in a shape of a block (such as a rectangle), the data connection block 83 and the data connection electrode 84 may be provided on a side of the first connection sub-line 81-1 in the second direction Y, the data connection block 83 is provided between the first connection sub-line 81-1 and the data connection electrode 84, a first end of the data connection block 83 is connected to the first connection sub-line 81-1, a second end of the data connection block 83 is connected to the data connection electrode 84, the data connection electrode 84 is configured to be connected to the second data connection line formed subsequently.

In an exemplary embodiment, the data connection block 83 and the data connection electrode 84 may be disposed in a vertical trace space between some adjacent unit columns. For example, the data connection block 83 and the data connection electrode 84 may be located in the vertical trace space between the N-th unit column and the (N+1)-th unit column. As another example, the data connection block 83 and the data connection electrode 84 may be located in the vertical trace space between the (N+1)-th unit column and the (N+2)-th unit column.

In an exemplary embodiment, the first connection sub-line 81-1, the data connection block 83, and the data connection electrode 84 may be of an interconnected integral structure.

In an exemplary embodiment, the fourth conductive layer may further include at least one dummy electrode 85. The dummy electrode 85 may be in a shape of a block (such as a rectangle), may be disposed in a vertical trace space between some adjacent unit columns, and the dummy electrode 85 is configured to be connected to a second data connection line formed subsequently. For example, the dummy electrode 85 may be located in the vertical trace space between the N-th unit column and the (N+1)-th unit column. As another example, the dummy electrode 85 may be located in the vertical trace space between the (N+1)-th unit column and the (N+2)-th unit column.

In an exemplary embodiment, the position and shape of the dummy electrode 85 in the circuit unit may be substantially the same as the position and shape of the data connection electrode 84 in the circuit unit, except that the dummy electrode 85 is an isolation structure, and is neither connected to the first data connection line 81 nor to other electrodes. In an exemplary embodiment, the dummy electrode 85 and the data connection electrode 84 present the same morphology and via connection structure. Using the same design of a transfer region, not only can the uniformity of the subsequent etching process be improved, but also the same display effect can be achieved in different regions under transmitted and reflected light, the elimination of shadow is effectively realized, the appearance defect of the display substrate is effectively avoided, and the display quality is improved.

In an exemplary embodiment, in the first direction X, the data connection electrode 84 and the dummy electrode 85 may be disposed between two first power supply connection blocks 68-1 adjacent in the first direction X. In the second direction Y, the positions of the data connection electrode 84 and the dummy electrode 85 may be substantially flush with the position of the first power supply connection block 68-1.

In an exemplary embodiment, in one unit row, fourth conductive layers (except for the first data connection lines and the data connection blocks) in two adjacent circuit units may be disposed symmetrically with respect to the column centerline. For example, fourth conductive layers of the N-th unit column and the (N+1)-th unit column may be disposed symmetrically with respect to the column centerline. As another example, the fourth conductive layers of the (N+1)-th unit column and the (N+2)-th unit column may be disposed symmetrically with respect to the column centerline.

In an exemplary embodiment, fourth conductive layers (except for the first data connection lines and the data connection blocks) in adjacent unit rows may be substantially the same.

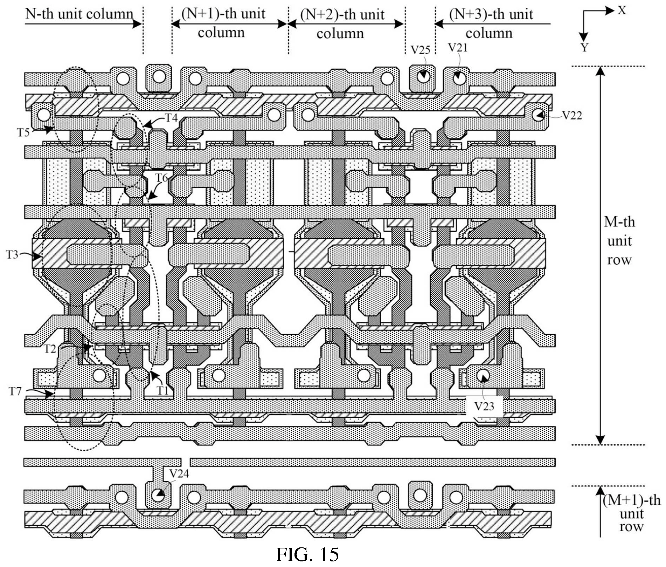

(17) A pattern of a first planarization layer is formed. In an exemplary implementation, forming the pattern of the first planarization layer may include: coating a first planarization thin film on the base substrate on which the aforementioned patterns are formed, patterning the first planarization thin film using a patterning process to form the first planarization layer covering the pattern of the fourth conductive layer, wherein the first planarization layer is provided with a plurality of vias, as shown in FIG. 15.

In an exemplary implementation, a plurality of vias in each circuit unit at least includes a twenty-first via V21, a twenty-second via V22, and a twenty-third via V23.

In an exemplary implementation, an orthographic projection of the twenty-first via V21 on the base substrate is located within a range of an orthographic projection of the first power supply connection block 68-1 on the base substrate, the first planarization layer within the twenty-first via V21 is removed to expose a surface of the first power supply connection block 68-1, and the twenty-first via V21 is configured such that the subsequently formed first power supply line is connected to the first power supply connection block 68-1 through this via.

In an exemplary embodiment, an orthographic projection of the twenty-second via V22 on the base substrate is within a range of an orthographic projection of the second end of the fifth connection electrode 55 on the base substrate, the first planarization layer within the twenty-second via V22 is removed to expose a surface of the second end of the fifth connection electrode 55, and the twenty-second via V22 is configured such that a subsequently formed data signal line is connected with the second end of the fifth connection electrode 55 through this via.

In an exemplary implementation, an orthographic projection of the twenty-third via V23 on the base substrate is within a range of an orthographic projection of the third connection electrode 53 on the base substrate, the first planarization layer within the twenty-third via V23 is removed to expose a surface of the third connection electrode 53, and the twenty-third via V23 is configured such that an anode connection electrode formed subsequently is connected with the third connection electrode 53 through this via.

In an exemplary embodiment, the plurality of vias on the first planarization layer may further include a twenty-fourth via V24 and a twenty-fifth via V25.

In an exemplary embodiment, an orthographic projection of the twenty-fourth via V24 on the base substrate is within a range of an orthographic projection of the data connection electrode 84 on the base substrate, the first planarization layer within the twenty-fourth via V24 is removed to expose a surface of the data connection electrode 84, and the twenty-fourth via V24 is configured such that a third connection sub-line in the subsequently formed second data connection line is connected with the data connection electrode 84 through this via. In an exemplary embodiment, the twenty-fourth via V24 may be referred to as a data transfer via.

In an exemplary embodiment, an orthographic projection of the twenty-fifth via V25 on the base substrate is within a range of an orthographic projection of the dummy electrode 85 on the base substrate, the first planarization layer in the twenty-fifth via V25 is removed to expose a surface of the dummy electrode 85, and the twenty-fifth via V25 is configured such that a fourth connection sub-line in the subsequently formed second data connection line is connected with the dummy electrode 85 through this via.

In an exemplary embodiment, in the first direction X, the twenty-fourth via V24 and the twenty-fifth via V25 may be provided between two twenty-first vias V21 adjacent in the first direction X. In the second direction Y, the positions of the twenty-fourth via V24 and the twenty-fifth via V25 may be substantially flush with the positions of the twenty-first vias V21, that is, the twenty-fourth via V24 and the twenty-fifth via V25 are both disposed within a range of the circuit units. According to the present disclosure, the data transfer via is designed to be hidden in the circuit unit, so that the shadow elimination can be effectively realized, the poor appearance of the display substrate is effectively avoided, and the display quality is improved.

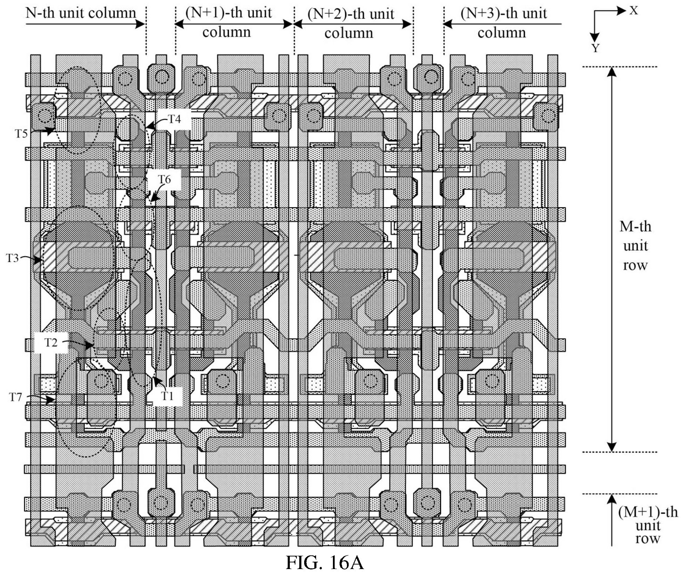

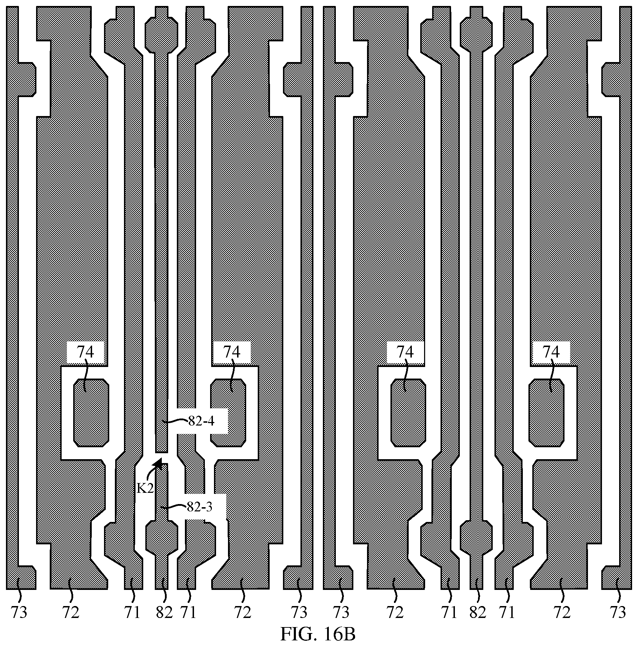

(18) A pattern of a fifth conductive layer is formed. In an exemplary implementation, forming the pattern of the fifth conductive layer may include: depositing a fifth conductive thin film on the base substrate on which the above-mentioned patterns are formed, and patterning the fifth conductive thin film using a patterning process to form the fifth conductive layer arranged on the first planarization layer, as shown in FIG. 16A and FIG. 16B. FIG. 16B is a schematic planar view of the fifth conductive layer in FIG. 16A. In an exemplary implementation, the fifth conductive layer may be referred to as a second source-drain metal (SD2) layer.

In an exemplary implementation, a fifth conductive layer of each circuit unit at least includes a first power supply line 71, a second power supply line 72, a data signal line 73 and an anode connection electrode 74.

In an exemplary implementation, a main body portion of the first power supply line 71 may be in a shape of a straight line or a polyline extending in the second direction Y, and the first power supply line 71 is connected to the first power supply connection block 68-1 through the twenty-first via V21. Since the first power supply connection block 68-1 is connected to the first power supply connection line 68, and the first power supply connection line 68 is connected to the first region of the fifth active layer, the connection between the first power supply line 71 and the first electrode of the fifth transistor T5 is realized, and the first power supply line 71 can write the first power supply signal to the first electrode of the fifth transistor T5.

In an exemplary embodiment, since the first power supply line 71 is connected to the first power supply connection line 68, the interconnection between the first power supply connection line 68 with the main body portion extending along the first direction X and the first power supply connection line 71 with the main body portion extending along the second direction Y is achieved, and the first power supply connection line 71 and the first power supply connection line 68 form a grid structure of a net-like communication structure for transmitting the first power supply signal on the display substrate, which can not only effectively reduce a resistance of the first power supply line and reduce a voltage drop of the first power supply signal, but also effectively improve uniformity of the first power supply signal in the display substrate, effectively improve uniformity of display and display quality.

In an exemplary implementation, the first power supply connection line 68 in the fourth conductive layer may be disposed in each unit row, the first power supply line 71 of the fifth conductive layer may be disposed in each unit column, and a plurality of first power supply lines 71 are connected, respectively, to a plurality of first power supply connection lines 68 to form a net-like structure for transmitting the first power supply signal.

In an exemplary embodiment, an orthographic projection of the first power supply line 71 on the base substrate is at least partially overlapped with orthographic projections of the first active layer, the fourth active layer, and the sixth active layer on the base substrate, i.e., the orthographic projection of the first power supply line 71 on the base substrate is at least partially overlapped with orthographic projections of the first transistor T1, the fourth transistor T4, and the sixth transistor T6 on the base substrate, the first power supply line 71 may block light emitted by a light emitting device and light reflected by a film layer from irradiating the first transistor T1, the fourth transistor T4, and the sixth transistor T6 which are oxide, and can prevent characteristic drifting of the oxide transistors due to illumination, thus improving electrical performance of the oxide transistors.

In an exemplary embodiment, the second power supply line 72 may have a main body portion with a shape of a straight line or a bend line extending along the second direction Y, and may be provided between the first power supply line 71 and the data signal line 73.

In an exemplary embodiment, an orthographic projection of the second power supply line 72 on the base substrate is at least partially overlapped with orthographic projections of the third, fifth and seventh active layers on the base substrate, i.e., the orthographic projection of the second power supply line 72 on the base substrate is at least partially overlapped with orthographic projections of the third transistor T3, the fifth transistor T5 and the seventh transistor T7 on the base substrate, the second power supply line 72 can block light emitted by a light emitting device and light reflected by a film layer from irradiating the third transistor T3, the fifth transistor T5, and the seventh transistor T7 which are oxide, and can prevent characteristic drifting of the oxide transistors due to illumination, thereby improving electrical characteristics of the oxide transistors.

In an exemplary embodiment, a width of the second power supply line 72 may be larger than a width of the first power supply line 71, and the width may be a dimension in the first direction X. By providing the wider second power supply line 72, the present disclosure not only effectively reduces the resistance of the second power supply line 72 and reduces the voltage drop for transmitting the second power supply signal, but also effectively improves the uniformity of the second power supply signal in the display substrate, effectively improves the display uniformity and the display effect and the display quality.

In an exemplary embodiment, the data signal line 73 may have a main body portion with a shape of a straight line or a bend line extending along the second direction Y, and the data signal line 73 is connected to the second end of the fifth connection electrode 55 through the twenty-second via V22. Since a first end of the fifth connection electrode 55 is connected with the first region of the fourth active layer through a via, it is achieved that the data signal line 73 cam write a data signal into the first electrode of the fourth transistor T4.

In an exemplary embodiment, an orthographic projection of the data signal line 73 on the base substrate is not overlapped with orthographic projections of the channel region of the first transistor T1 to the channel region of the seventh transistor T7 on the base substrate, so that signal crosstalk caused by the data voltage jump of the data signal line 73 can be avoided, the influence of the data voltage jump on the first transistor T1 to the seventh transistor T7 can be avoided, the operation stability of the pixel drive circuits can be improved, and the display effect can be improved.

In an exemplary implementation, the anode connection electrode 74 may be in a shape of a block (e.g., a rectangle), the anode connection electrode 74 is connected to the third connection electrode 53 through the twenty-third via V23, and the anode connection electrode 74 is configured to be connected to an anode formed subsequently. Since the third connection electrode 53 is connected to the second region of the third active layer (also the second region of the seventh active layer) through a via, it can be achieved that the pixel drive circuit outputs a driving current to the light emitting device.

In an exemplary embodiment, the fifth conductive layer of at least one circuit unit may further include a second data connection line 82.

In an exemplary embodiment, the second data connection line 82 may have a main body portion with a shape of a straight line or a bend line extending along the second direction Y, and may be disposed in a vertical trace space between some adjacent unit columns.

In an exemplary embodiment, the second data connection line 82 may be disposed between the first power supply lines 71 of adjacent unit columns. For example, the second data connection line 82 may be provided between the first power supply line 71 of the N-th unit column and the first power supply line 71 of the (N+1)-th unit column. As another example, the second data connection line 82 may be provided between the first power supply line 71 of the (N+2)-th unit column and the first power supply line 71 of the (N+3)-th unit column. In the present disclosure, the second data connection line 82 is disposed between two first power supply lines 71, so that the first power supply line 71 having a constant voltage signal may be used as a shielding line to avoid data voltage jumps from affecting the pixel drive circuits, which improves the operation stability of the pixel drive circuits and the display effect.

In an exemplary embodiment, the at least one second data connection line 82 may be provided with a second fracture K2, and the second fracture K2 may sever the second data connection line 82 so that the second data connection lines 82 on two sides of the second fracture K2 are insulated from each other.

In an exemplary embodiment, the second data connection line 82 may include a third connection sub-line 82-3 and a fourth connection sub-line 82-4 respectively located on two sides of the second fracture K2 in the second direction Y, the third connection sub-line 82-3 is configured to be connected to the data lead in the bonding region, and the fourth connection sub-line 82-4 configured as a second dummy line.

In an exemplary embodiment, the third connection sub-line 82-3 may be located on a side of the second fracture K2 in the second direction Y (a side close to the bonding region), and the fourth connection sub-line 82-4 may be located on a side of the second fracture K2 in the opposite direction of the second direction Y (a side away from the bonding region).

In an exemplary embodiment, an orthographic projection of at least one second fracture K2 on the base substrate is at least partially overlapped with an orthographic projection of at least one reference signal line 66 on the base substrate, or an orthographic projection of at least one second fracture K2 on the base substrate is at least partially overlapped with an orthographic projection of at least one initial signal line 67 on the base substrate.

In an exemplary implementation, the orthographic projection of at least one second fracture K2 on the base substrate may be located within a range of the orthographic projection of at least one reference signal line 66 on the base substrate, and the second fracture K2 may be padded by using the reference signal line 66, effectively eliminating difference of film layers of different regions, which can avoid poor appearance of the display substrate. Alternatively, the orthographic projection of at least one second fracture K2 on the base substrate may be located within a range of the orthographic projection of at least one initial signal line 67 on the base substrate, and the second fracture K2 may be padded by using the initial signal line 67, effectively eliminating difference of film layers of different regions, which can avoid poor appearance of the display substrate.

In an exemplary embodiment, the third connection sub-line 82-3 may be connected to the data connection electrode 84 through the twenty-fourth via V24. Since the data connection electrode 84 is connected to the first connection sub-line 81-1 in the first data connection line 81 through the data connection block 83, the interconnection between the first data connection line 81 with a main body portion extending along the first direction X and the second data connection line 82 with a main body portion extending along the second direction Y is achieved. Since the first connection sub-line 81-1 in the first data connection line 81 is configured to be connected to the data signal line in the display region, the third connection sub-line 82-3 is configured to be connected to the data lead in the bonding region, and the interconnection between the first connection sub-line 81-1 and the third connection sub-line 82-3 enables the data lead in the bonding region to be connected to the data signal line in the display region through the first data connection line 81 and the second data connection line 82.

In an exemplary embodiment, the fourth connection sub-line 82-4 may be connected to the dummy electrode 85 through the twenty-fifth via V25. In an exemplary embodiment, since the dummy electrode presents substantially the same morphology as that of the data connection electrode 84, and the twenty-fifth via V25 presents substantially the same morphology as that of the twenty-fourth via V24, the connection structure between the third connection sub-line 82-3 and the data connection electrode 84 through a via is substantially the same as the connection structure between the fourth connection sub-line 82-4 and the dummy electrode 85 through a via, not only can the uniformity of the subsequent etching process be improved, but also different regions can achieve the same display effect under transmitted and reflected light, the elimination of shadow is effectively realized, the poor appearance of the display substrate is effectively avoided, and the display quality is improved.

In an exemplary embodiment, an orthographic projection of at least one first power supply line 71 on the base substrate is at least partially overlapped with an orthographic projection of the first fracture K1 on the base substrate, or an orthographic projection of at least one second power supply line 72 on the base substrate may include an orthographic projection of the first fracture K1 on the base substrate.

In an exemplary embodiment, an orthographic projection of at least one first fracture K1 on the base substrate may be located within a range of an orthographic projection of at least one first power supply line 71 on the base substrate, that is, the first fracture K1 is covered by the first power supply line 71, and the first fracture K1 is sheltered by the first power supply line 71, which can effectively eliminate the difference of film layers of different regions, and can avoid poor appearance of the display substrate. Alternatively, the orthographic projection of at least one first fracture K1 on the base substrate may be located within a range of an orthographic projection of at least one second power supply line 72 on the base substrate, that is, the first fracture K1 is covered by the second power supply line 72, and the first fracture K1 is sheltered by the second power supply line 72, which can effectively eliminate the difference of film layers of different regions, and can avoid poor appearance of the display substrate.

The subsequent manufacturing process may include forming a second planarization layer, wherein the second planarization layer is provided with an anode via, the anode via exposes a surface of the anode connection electrode 74, and is configured such that an anode formed subsequently is connected to the anode connection electrode 74 through the anode via.

So far, a drive circuit layer of the embodiment is manufactured on the base substrate. In a plane parallel to the display substrate, the drive circuit layer may include a plurality of circuit units, and each circuit unit may include a pixel drive circuit, and a first scan signal line, a second scan signal line, a third scan signal line, a fourth scan signal line, a light emitting signal line, a reference signal line, an initial signal line, a first power supply line, a second power supply line, and a data signal line which are connected with the pixel drive circuit.

In a plane perpendicular to the display substrate, the drive circuit layer may include a first conductive layer, a first insulation layer, a second conductive layer, a second insulation layer, a semiconductor layer, a third insulation layer, a third conductive layer, a fourth insulation layer, a fourth conductive layer, a first planarization layer, a fifth conductive layer, and a second planarization layer disposed sequentially on the base substrate. The first conductive layer may at least include the first electrode plate of the first capacitor and the third electrode plate of the second capacitor, the second conductive layer may at least include the second electrode plate of the first capacitor, the fourth electrode plate of the second capacitor, the first shelter line, the second shelter line, and a plurality of bottom gate electrodes, the semiconductor layer may at least include active layers of a plurality of transistors, the third conductive layer may at least include the second scan signal line, the light emitting signal line, and a plurality of top gate electrodes, the fourth conductive layer may at least include the first scan signal line, the third scan signal line, the fourth scan signal line, the reference signal line, the initial signal line, the first power supply connection line, and a plurality of connection electrodes, the fifth conductive layer may at least include the first power supply line, the second power supply line, and the data signal line.

In an exemplary embodiment, the fourth conductive layer may further include a first data connection line, and the fifth conductive layer may further include a second data connection line.

In an exemplary embodiment, the base substrate may be a flexible base substrate, or a rigid base substrate. The rigid base substrate may include, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation, the flexible base substrate may include a first flexible material layer, a first inorganic material layer, a semiconductor layer, a second flexible material layer and a second inorganic material layer stacked on the glass carrier plate. Materials of the first flexible material layer and the second flexible material layer may be Polyimide (PI), Polyethylene Terephthalate (PET), or a surface-treated polymer soft film, etc., and materials of the first inorganic material layer and the second inorganic material layer may be Silicon Nitride (SiNx), Silicon Oxide (SiOx), or the like, for improving water and oxygen resistance of the base substrate. The first inorganic material layer and the second inorganic material layer may also be referred to as barrier layers, and a material of the semiconductor layer may be amorphous silicon (a-si).

In an exemplary implementation, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first conductive layer, the second conductive layer, the third conductive layer, the fourth conductive layer, and the fifth conductive layer may be made of a metal material such as silver (Ag), copper (Cu), aluminum (Al), titanium (Ti), molybdenum (Mo), etc., or may be made of an alloy material composed of metals, such as an aluminum-neodymium alloy (AlNd) or a molybdenum-niobium alloy (MoNb), etc., and may be of a single-layer structure or a multi-layer composite structure, such as Ti/Al/Ti or the like. The first planarization layer and the second planarization layer may be made of an organic material such as resin or polyimide.

In an exemplary implementation, after the drive circuit layer has been manufactured, a light emitting structure layer may be manufactured on the drive circuit layer, and an encapsulation structure layer may be manufactured on the light emitting structure layer, which will not be described further here.

An exemplary embodiment of the present disclosure provides a display substrate that inventively combines an oxide pixel drive circuit technology and a technology of arranging data connection lines in a display region, so that the display substrate has the advantages of both a narrow bezel and a novel circuit architecture. The present disclosure uses the novel pixel drive circuit with oxide transistors, thereby the leakage current can be effectively reduced, which is beneficial for achieving low-frequency display. By providing first data connection lines and second data connection lines in the display region, the data lead-out lines in the bonding region are connected to the data signal lines through the first data connection lines and the second data connection lines, so that there is no need to provide fan-shaped oblique lines in the lead-out line region, which reduces a length of the lead-out line region effectively, reduces a width of a lower bezel greatly, increases a screen-to-body ratio, and is conducive to achieving full-screen display.

In the embodiment of the present disclosure, by setting a width-to-length ratio of the oxide drive transistor in the pixel drive circuit, the driving performance of the pixel drive circuit can be effectively improved under the corresponding process and pixel architecture, and the display quality can be effectively improved.

In the embodiment of the present disclosure, by providing the data signal lines to not overlap with the channel regions of the first transistor T1 to the seventh transistor T7 in orthographic projections, signal crosstalk caused by the data voltage jump of the data signal line 73 can be avoided, the influence of the data voltage jump on the first transistor T1 to the seventh transistor T7 can be avoided, the operation stability of the pixel drive circuits can be improved, and the display effect can be improved.

In the embodiment of the present disclosure, the first transistor T1, the fourth transistor T4, and the sixth transistor T6 are sheltered using the first power supply line, and the third transistor T3, the fifth transistor T5, and the seventh transistor T7 are sheltered using the second power supply line, which can block light emitted by a light emitting device and light reflected by a film layer from irradiating the oxide transistors, and can prevent characteristic drifting of the oxide transistors due to illumination, thereby improving electrical characteristics of the oxide transistors.

In the present disclosure, the second data connection line is disposed between two first power supply lines, so that the first power supply line having a constant voltage signal can be used as a shielding line to avoid data voltage jumps from affecting the pixel drive circuits, which improves the operation stability of the pixel drive circuits, and improves the display effect.

In the embodiment of the present disclosure, the data transfer via connecting the first data connection line and the second data connection line is designed to be hidden in the circuit unit, so that the shadow elimination can be effectively realized, the poor appearance of the display substrate is effectively avoided, and the display quality is improved.

In the embodiment of the present disclosure, the first fracture and the second source-drain metal layer (such as the first power supply line or the second power supply line) are overlapped in orthographic projections, so that the second source-drain metal layer can be used to shelter the first fracture, which can effectively eliminate the difference of film layers of different regions, and can avoid poor appearance of the display substrate.

In the embodiment of the present disclosure, the second fracture and the first source-drain metal layer (such as the reference signal line or the initial signal line) are overlapped in orthographic projections, so that the first source-drain metal layer can be used to pad the second fracture, thus effectively eliminating the difference of film layers of different regions, which may avoid poor appearance of the display substrate.

In the embodiment of the present disclosure, the dummy electrode is provided in the circuit unit, and the morphology and connection structure presented by the dummy electrode are substantially the same as those of the data connection electrode, so that different circuit units have substantially the same transfer connection structure, the shadow elimination can be effectively realized, the poor appearance of the display substrate is effectively avoided, and the display quality is improved.

In an embodiment of the present disclosure, by providing the first power supply connection line with the main portion extends along the first direction X and the first power supply line with the main portion extends along the second direction Y, and the first power supply connection line and the first power supply connection line connected to each other, the first power supply line and the first power supply connection line form a net-like structure for transmitting the first power supply signal in the display substrate, which can not only effectively reduce the resistance of the first power supply line and reduce the voltage drop of the first power supply signal, but also effectively improve the uniformity of the first power supply signal in the display substrate, effectively improve the display uniformity and the display quality.

In the embodiment of the present disclosure, a structure of VSS in pixel is achieved by disposing a second power supply line in a display region, which can greatly reduce a width of a bezel power supply lead, greatly reduces widths of left and right bezels, and increases a screen-to-body ratio, and is beneficial to achieve full-screen display. By providing the wider second power supply line, the present disclosure not only effectively reduces the resistance of the second power supply line and reduces the voltage drop for transmitting the second power supply signal, but also effectively improves the uniformity of the second power supply signal in the display substrate, the display uniformity, and the display effect and the display quality.

In the embodiment of the present disclosure, the first scan signal line, the third scan signal line, and the fourth scan signal line are disposed in the first source-drain metal layer, so that the resistance of the scan signal line is effectively reduced, the voltage drop of the scan signal is reduced, the compensation speed cab be improved, and the display quality is improved.

In the pixel drive circuit according to the embodiment of the present disclosure, seven oxide transistors are used, and through a mirror symmetry design, the bottom gate electrodes and the top gate electrodes of the transistors in adjacent circuit units are of an interconnected integral structure, and share the same gate connection block and gate connection via, which can not only effectively reduce the occupied space of the pixel drive circuits, facilitate the achievement of a high-resolution (PPI) display, but also facilitate the compression of the circuit units, in which two unit columns are compressed to obtain one vertical trace space in which the second data connection line is provided, and four unit rows are compressed to obtain one lateral trace space in which the first data connection line is provided. The circuit unit compression structure according to the present disclosure can realize a large transmittance, and can be applied to sensor identification.

The manufacturing process in the embodiment of the present disclosure may be compatible well with an existing manufacturing process, is simple in process implementation, is easy to implement, and has a high production efficiency, a low production cost, and a high yield.

In some other embodiments, the driver circuit layer of the display substrate may further include a third source-drain metal (SD3) layer, the third source-drain metal layer may be disposed on a side of the second planarization layer away from the base substrate, and a third planarization layer may be disposed on a side of the third source-drain metal (SD3) layer away from the base substrate. In an exemplary embodiment, the data signal line and the second data connection line may be provided in the third source-drain metal layer, or the data signal line, the second data connection line, and the second power supply line may be provided in the third source-drain metal layer, which is not limited here in the present disclosure.

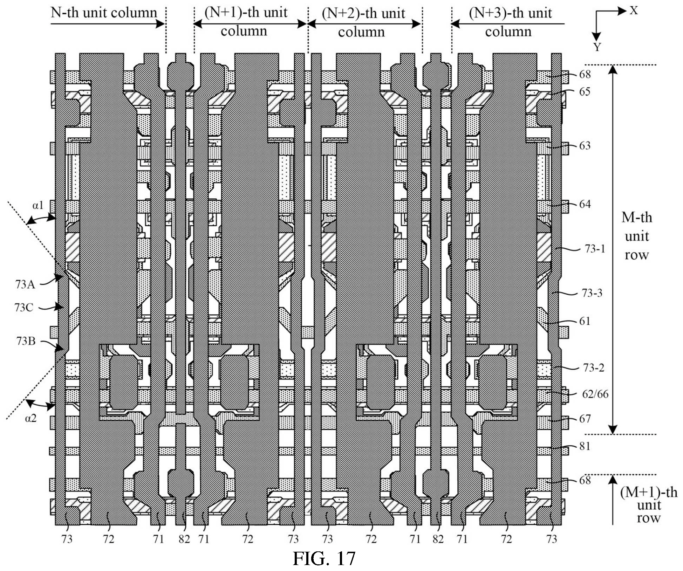

FIG. 17 is a schematic diagram of a structure of another display substrate according to an exemplary embodiment of the present disclosure, and is an enlarged view of the region A in FIG. 7B, and schematically illustrates the structure of circuit units in one circuit row and four circuit columns. The structure of the display substrate according to the present embodiment is substantially the same as that shown in FIG. 8, except that the data signal line 73 may be in a shape of a bend line extending along the second direction Y.

In an exemplary embodiment, in at least one circuit unit, the data signal line 73 may include at least one straight line segment and at least one bending segment connected to each other, and the bending segment is configured to increase the extension length of the data signal line.

As shown in FIG. 17, the at least one data signal line 73 may include a first straight line segment 73-1, a second straight line segment 73-2, and a bending segment 73-3, wherein a first end of the bending segment 73-3 is connected to the first straight line segment 73-1, and a second end of the bending segment 73-3 is connected to the second straight line segment 73-2.

In an exemplary embodiment, the bending segment 73-3 may include a first bending portion 73A, a second bending portion 73B, and an extension portion 73C. A first end of the first bending portion 73A is connected to the first straight line segment 73-1, and a second end of the first bending portion 73A extends in a direction close to the second power supply line 72, and then is connected to a first end of the extension portion 73C. A second end of the extension portion 73C extends in the second direction Y and then is connected to a first end of the second bending portion 73B. A second end of the second bending portion 73B extends in a direction away from the second power supply line 72, and is connected to the second straight line segment 73-2.

In an exemplary embodiment, the first bending portion 73A has a first included angle α1 with the second direction Y, and the first included angle α1 may be about 20 degrees to 60 degrees. The second bending portion 73B has a second included angle α2 with the second direction Y, and the second included angle α2 may be about 20 degrees to 60 degrees.

In an exemplary embodiment, the extension lengths of the first bending portion 73A, the second bending portion 73B, and the extension portion 73C may be set according to actual needs, which is not limited here in the present disclosure.

In an exemplary embodiment, since a part of the data signal lines (which may be referred to as FIP traces) in the display region are connected to the data lead-out lines in the bonding region through the first data connection lines and the second data connection lines, and another part of the data signal lines (which may be referred to as normal traces) are directly connected to the data lead-out lines in the bonding region, the data signal transmission distance of the FIP traces is larger than the data signal transmission distance of the normal traces. In the present disclosure, by providing a bending segment on a data signal line of a normal trace and performing data signal transmission distance compensation by a trace bending process, the data signal transmission distance of the FIP traces can be substantially the same as that of the normal traces, and the driving performance of the pixel drive circuit can be improved, and the display effect can be improved.

The display substrate provided in the present embodiment not only has the technical effect of the display substrate shown in FIG. 8, but also can make the data signal transmission distance of the FIP traces substantially the same as the data signal transmission distance of the normal traces by providing the bending segment on the data signal lines of the normal traces and performing the data signal transmission distance compensation by the trace bending process, thereby improving the driving performance of the pixel drive circuit and improving the display effect.

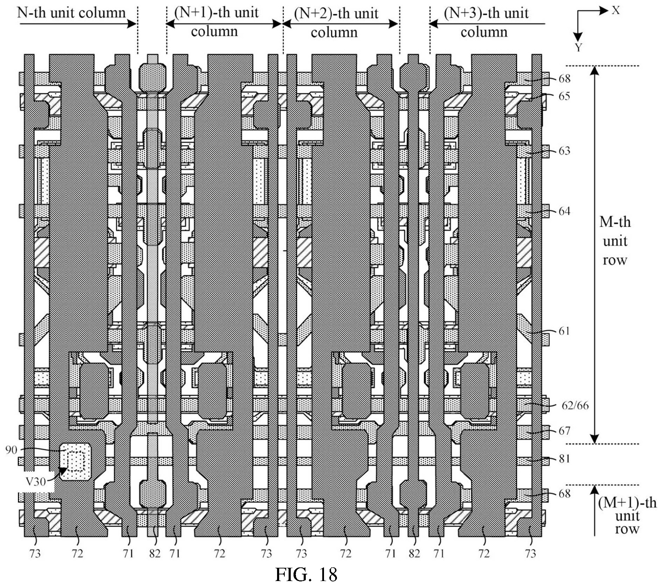

FIG. 18 is a schematic diagram of a structure of another display substrate according to an exemplary embodiment of the present disclosure, and is an enlarged view of the region A in FIG. 7B, and schematically illustrates the structure of circuit units in one circuit row and four circuit columns. The structure of the display substrate according to the present embodiment is substantially the same as that shown in FIG. 8, except that a side of the second power supply line away from the base substrate is also provided with an auxiliary cathode.

In an exemplary embodiment, in a plane perpendicular to the display substrate, the display substrate may at least include a drive structure layer disposed on the base substrate and a light emitting structure layer disposed on a side of the drive structure layer away from the base substrate. The drive structure layer may include a plurality of circuit units, at least one circuit unit may include a pixel drive circuit, the light emitting structure layer may include a plurality of light emitting units, at least one light emitting unit may include a light emitting device, and at least one light emitting device may at least include an anode, an organic light emitting layer, and a cathode, and the anode is connected to the pixel drive circuit of a corresponding circuit unit.

As shown in FIG. 18, the light emitting structure layer of the present embodiment may further include at least one auxiliary cathode 90, and the auxiliary cathode 90 and the anode may be disposed in a same layer, so the auxiliary cathode 90 is disposed on a side of the second power supply line 72 away from the base substrate. An orthographic projection of the auxiliary cathode 90 on the base substrate is at least partially overlapped with an orthographic projection of the second power supply line 72 on the base substrate, the auxiliary cathode 90 is connected to the second power supply line 72 through the auxiliary via V30, and the auxiliary cathode 90 is configured to be connected to a subsequently formed cathode.

In an exemplary embodiment, after the organic light emitting layer is formed, a connection hole exposing the auxiliary cathode 90 may be formed in a laser punching manner, so that the cathode is connected to the auxiliary cathode 90 through the connection hole.

In an exemplary embodiment, a plurality of auxiliary cathodes 90 may be periodically provided along the first direction X and the second direction Y, to form a grid structure of a net-like communication structure for transmitting the second power supply signal on the display substrate, which can not only effectively reduce a resistance of the second power supply line and reduce a voltage drop of the second power supply signal, but also effectively improve uniformity of the second power supply signal in the display substrate, uniformity of display, and display quality.

In an exemplary embodiment, since the width of the second power supply line 72 of the embodiment of the present disclosure is wider, it is advantageous to arrange the provision position of the auxiliary cathode 90, and the voltage drop of the second power supply signal can be minimized. For example, one auxiliary cathode 90 may be provided every three circuit units in the first direction X. As another example, in the second direction Y, one auxiliary cathode 90 may be provided every other circuit unit.

In an exemplary embodiment, a plurality of anodes in the light emitting structure layer may be arranged in an RGBG manner or may be arranged in a real RGB manner, which is not limited here in the present disclosure.

In some other embodiments, the display substrate may not be provided with auxiliary cathodes 90, and the cathode in the light emitting structure layer is directly connected to the second power supply line 72 by a connection hole, which is not limited here in the present disclosure.

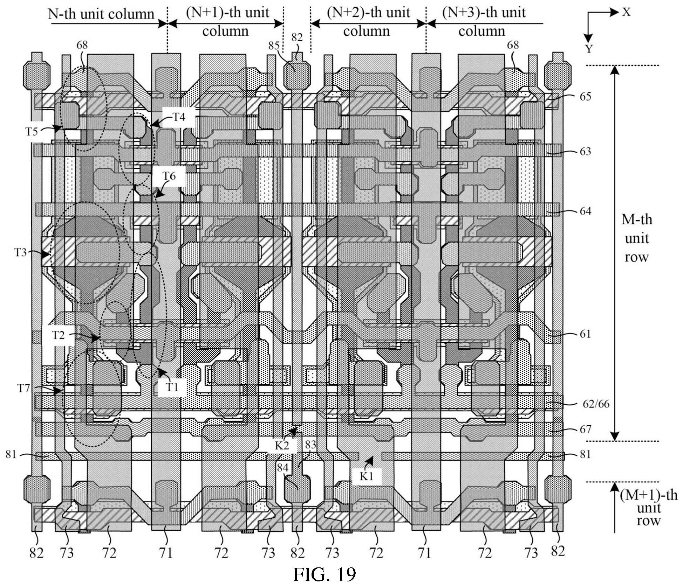

FIG. 19 is a schematic diagram of a structure of another display substrate according to an exemplary embodiment of the present disclosure, and is an enlarged view of the region A in FIG. 7B, and schematically illustrates the structure of circuit units in one circuit row and four circuit columns. The structure of the display substrate according to the present embodiment is substantially the same as that shown in FIG. 8, except that the second data connection line is provided between two data signal lines.

As shown in FIG. 19, the second data connection line 82 of the present embodiment may be provided between data signal lines 73 adjacent in the first direction X. For example, the second data connection line 82 may be provided between the data signal line 73 of the (N+1)-th unit column and the data signal line 73 of the (N+2)-th unit column.

In an exemplary embodiment, the first power supply connection line 68 may be in a shape of a straight line or a bend line extending along the first direction X, may be disposed discontinuously in one unit row, and the first power supply connection lines 68 of some two circuit units adjacent in the first direction X may be of an interconnected integral structure.

In an exemplary embodiment, a first power supply connection block 68-1 may be provided on and connected to the first power supply connection line 68, and the first power supply connection block 68-1 may be provided at the middle position of the first power supply connection line 68 of the integral structure, so that the first power supply connection lines 68 of two circuit units share the same first power supply connection block 68-1.

In an exemplary embodiment, the first power supply lines 71 of some two adjacent circuit units may be of an interconnected integral structure, and thus the width of the first power supply line 71 in the present embodiment may be larger than the width of the first power supply line 71 in the embodiment shown in FIG. 8.

In an exemplary implementation, the manufacturing process of the display substrate according to this embodiment may include the following operations.

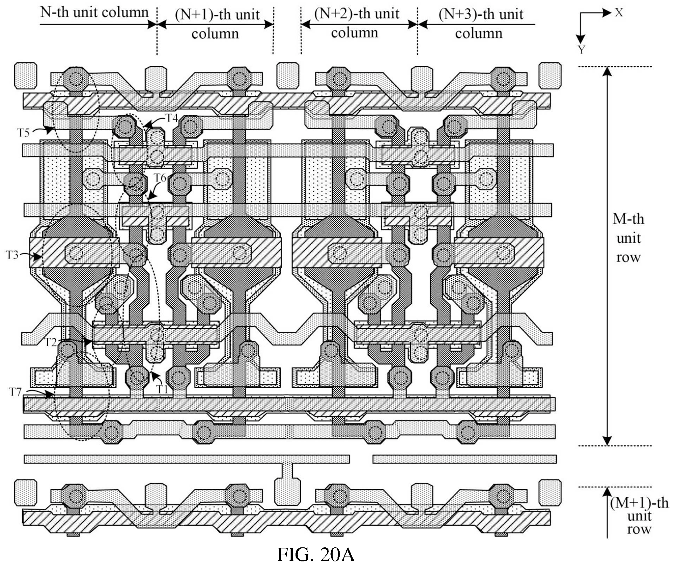

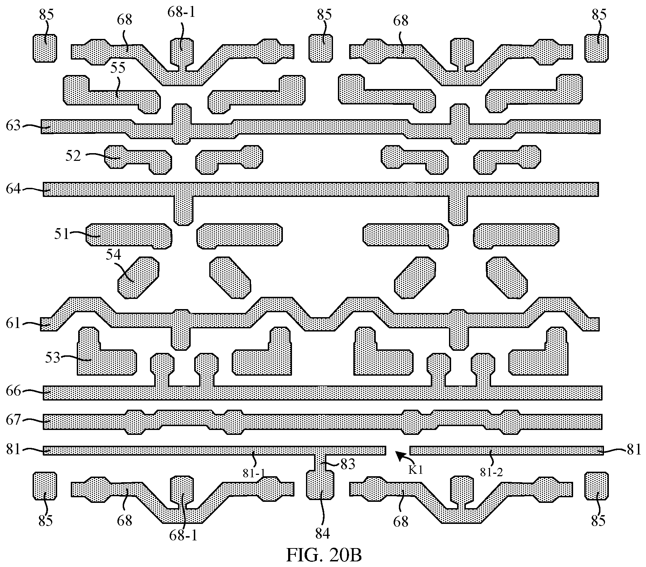

(21) Patterns of a first conductive layer, a second conductive layer, a semiconductor layer, a third conductive layer, a fourth insulation layer, and a fourth conductive layer are sequentially formed, as shown in FIGs. 20A and 20B, and FIG. 20B is a schematic planar view of the fourth conductive layer in FIG. 20A. In an exemplary embodiment, the patterns of the first conductive layer, the second conductive layer, the semiconductor layer, the third conductive layer, and the fourth insulation layer are substantially the same as those of the embodiment shown in FIG. 8, which will not be described further here.

In an exemplary embodiment, the fourth conductive layer of each circuit unit at least includes a first connection electrode 51, a second connection electrode 52, a third connection electrode 53, a fourth connection electrode 54, a fifth connection electrode 55, a first scan signal line 61, a third scan signal line 63, a fourth scan signal line 64, a reference signal line 66, and an initial signal line 67, and the above structures are substantially the same as those of the embodiment shown in FIG. 8.

In an exemplary embodiment, the fourth conductive layer of each circuit unit may further include a first power supply connection line 68. The first power supply connection line 68 may be in a shape of a straight line or a bend line extending along the first direction X, and may be disposed discontinuously in one unit row, and the first power supply connection line 68 is connected to the first region of the fifth active layer through the fifth via V5.

In an exemplary implementation, the first power supply connection lines 68 of some two circuit units adjacent in the first direction X may be of an interconnected integral structure. For example, the first power supply connection lines 68 of the N-th unit column and the (N+1)-th unit column may be of an interconnected integral structure, and the first power supply connection lines 68 of the (N+2)-th unit column and the (N+3)-th unit column may be of an interconnected integral structure, but there is a spacing between the first power supply connection line 68 of the N-th unit column and the (N+1)-th unit column and the first power supply connection line 68 of the (N+2)-th unit column and the (N+3)-th unit column.

In an exemplary embodiment, a first power supply connection block 68-1 may be provided on and connected to the first power supply connection line 68, and the first power supply connection block 68-1 is configured to be connected to a subsequently formed first power supply line.

In an exemplary embodiment, the first power supply connection block 68-1 may be disposed at the middle position of the first power supply connection line 68 of the integral structure, that is, between two circuit units adjacent in the first direction X, so that the first power supply connection lines 68 of the two circuit units share the same first power supply connection block 68-1, which can effectively reduce the occupied space of the pixel drive circuits, and is conducive to the compression of the circuit units under the premise of ensuring the display resolution (PPI).

In an exemplary embodiment, the fourth conductive layer of at least one circuit unit may further include a first data connection line 81, the first data connection line 81 may be in a shape of a straight line or a bend line extending along the first direction X, and may be provided between some adjacent unit rows, the first data connection line 81 may be provided with a first fracture K1, and a first connection sub-line 81-1 and a second connection sub-line 81-2 are formed on two sides of the first fracture K1.

In an exemplary embodiment, a data connection block 83 and a data connection electrode 84 may be provided on at least one first connection sub-line 81-1, a first end of the data connection block 83 is connected to the first connection sub-line 81-1, a second end of the data connection block 83 is connected to the data connection electrode 84, and the first connection sub-line 81-1, the data connection block 83, and the data connection electrode 84 may be of an interconnected integral structure.

In an exemplary embodiment, different from the embodiment shown in FIG. 8, the data connection block 83 and the data connection electrode 84 of the present embodiment may be disposed between the (N+1)-th unit column and the (N+2)-th unit column, and may be disposed between the first power supply connection lines 68 disposed discontinuously.

In an exemplary embodiment, the fourth conductive layer may further include at least one dummy electrode 85, and the dummy electrode 85 may be located between the first power supply connection lines 68 disposed discontinuously. The position and shape of the dummy electrode 85 in the circuit unit may be substantially the same as the position and shape of the data connection electrode 84 in the circuit unit.

In an exemplary embodiment, in one unit row, fourth conductive layers (except for the first data connection lines and the data connection blocks) in two adjacent circuit units may be disposed symmetrically with respect to the column centerline. For example, fourth conductive layers of the N-th unit column and the (N+1)-th unit column may be disposed symmetrically with respect to the column centerline. As another example, the fourth conductive layers of the (N+1)-th unit column and the (N+2)-th unit column may be disposed symmetrically with respect to the column centerline.

In an exemplary embodiment, the fourth conductive layers (except for the first data connection lines and the data connection blocks) in adjacent unit rows may be substantially the same.

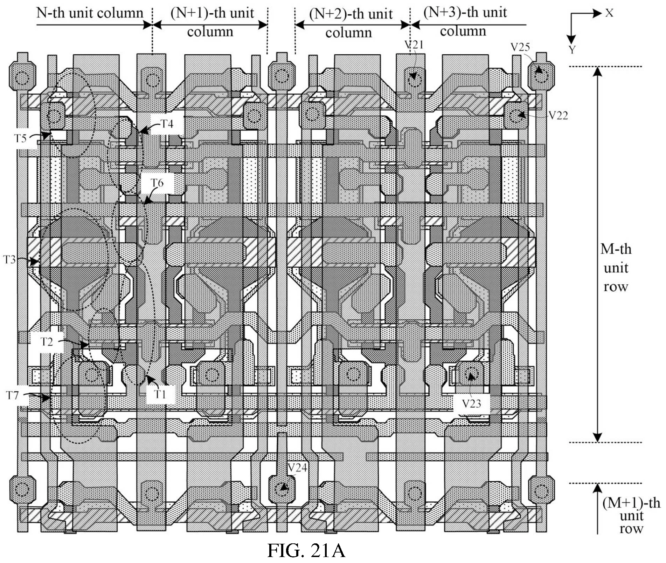

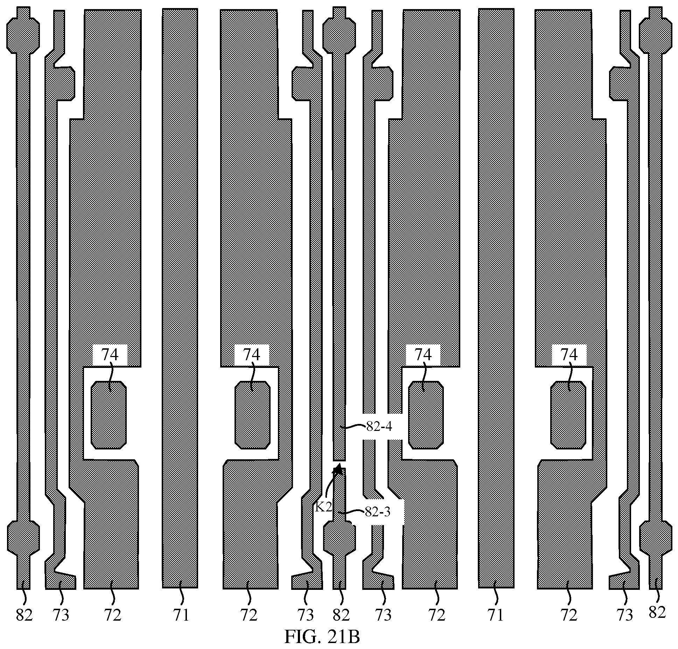

(22) A pattern of a first planarization layer and a pattern of a fifth conductive layer are sequentially formed. In an exemplary embodiment, sequentially forming the pattern of the first planarization layer and the pattern of the fifth conductive layer may include: first forming the first planarization layer covering the pattern of the fourth conductive layer, wherein the first planarization layer is provided with a twenty-first via V21 to a twenty-fifth via V25, and then forming the fifth conductive layer on the first planarization layer, as shown in FIGs. 21A and 21B, and FIG. 21B is a schematic planar view of the fifth conductive layer in FIG. 21A.

In an exemplary embodiment, the positions of the twenty-first via V21 to the twenty-fifth via V25 are substantially the same as those of the embodiment shown in FIG. 8, except that since the first power supply connection lines 68 of two circuit units adjacent in the first direction X share a same first power supply connection block 68-1, the two circuit units share the same twenty-first via V21.

In an exemplary embodiment, the fifth conductive layer of each circuit unit may at least include a first power supply line 71, a second power supply line 72, a data signal line 73, and an anode connection electrode 74, and the above structure is substantially the same as the embodiment shown in FIG. 8, except that the first power supply lines 71 of some two adjacent circuit units may be of an interconnected integral structure. For example, the first power supply lines 71 of the N-th unit column and the (N+1)-th unit column may be of an interconnected integral structure, and the first power supply lines 71 of the (N+2)-th unit column and the (N+3)-th unit column may be of an interconnected integral structure.

In an exemplary embodiment, since the first power supply lines 71 of two adjacent circuit units are of an interconnected integral structure, the width of the first power supply line 71 in the present embodiment may be larger than the width of the first power supply line 71 in the embodiment shown in FIG. 8.

In an exemplary embodiment, the fifth conductive layer of at least one circuit unit may further include a second data connection line 82, the second data connection line 82 may have a main body portion with a shape of a straight line or a bend line extending along the second direction Y, and may be provided between some adjacent unit columns, the second data connection line 82 may be provided with a second fracture K2, and a third connection sub-line 82-3 and a fourth connection sub-line 82-4 are formed on two sides of the second fracture K2.

In an exemplary embodiment, different from the embodiment shown in FIG. 8, the second data connection line 82 of the present embodiment may be provided between the data signal lines 73 adjacent in the partial first direction X. For example, the second data connection line 82 may be provided between the data signal line 73 of the (N+1)-th unit column and the data signal line 73 of the (N+2)-th unit column. According to the present disclosure, the second data connection line 82 is provided between the two data signal lines 73, so that the first power supply lines 71 of two adjacent circuit units are of an interconnected integral structure, and the width of the first power supply line 71 can be increased. By providing the wider first power supply line 71, the present disclosure not only effectively reduces the resistance of the first power supply line 71 and the voltage drop for transmitting the first power supply signal, but also effectively improves the uniformity of the first power supply signal in the display substrate, the display uniformity, and the display effect and the display quality.

In an exemplary embodiment, an orthographic projection of the at least one first power supply line 71 on the base substrate is at least partially overlapped with an orthographic projection of the first fracture K1 on the base substrate, or an orthographic projection of the at least one second power supply line 72 on the base substrate may include an orthographic projection of the first fracture K1 on the base substrate.

In an exemplary embodiment, an orthographic projection of the at least one second fracture K2 on the base substrate is at least partially overlapped with an orthographic projection of the at least one reference signal line 66 on the base substrate, or an orthographic projection of the at least one second fracture K2 on the base substrate is at least partially overlapped with an orthographic projection of the at least one initial signal line 67 on the base substrate.

The display substrate provided by the present embodiment not only has the technical effect of the display substrate shown in FIG. 8, but also can make the first power supply lines of two adjacent circuit units be an interconnected integral structure by arranging the second data connection line between two data signal lines, increase the width of the first power supply line, which not only effectively reduces the resistance of the first power supply line, reduces the voltage drop for transmitting the first power supply signal, but also effectively improves the uniformity of the first power supply signal in the display substrate, the display uniformity, and the display quality.

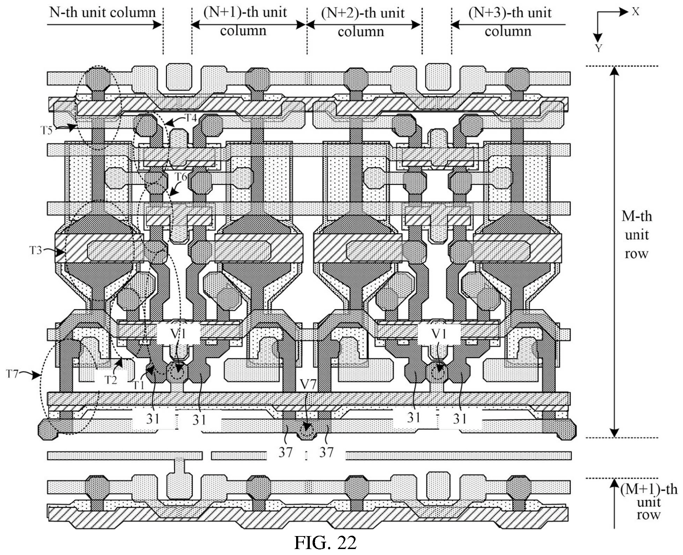

FIG. 22 is a schematic diagram of a structure of another display substrate according to an exemplary embodiment of the present disclosure, and is an enlarged view of the region A in FIG. 7B, and schematically illustrates the structure of circuit units in one circuit row and four circuit columns. The structure of the display substrate according to the present embodiment is substantially the same as that shown in FIG. 8, except that some adjacent circuit units can share active vias.

As shown in FIG. 22, in the present embodiment, the first active layers 31 of some circuit units adjacent in the first direction X are of an interconnected integral structure, and the seventh active layers 37 of some circuit units adjacent in the first direction X are of an interconnected integral structure.

In an exemplary embodiment, since the first active layers 31 of two circuit units adjacent in the first direction X are of an interconnected integral structure, the two circuit units share a same first via V1 as a first active via. For example, the first active layers 31 of the N-th unit column and the (N+1)-th unit column may be of an interconnected integral structure, and the circuit units of the N-th unit column and the (N+1)-th unit column share the same first via V1. As another example, the first active layers 31 of the (N+2)-th unit column and the (N+3)-th unit column may be of an interconnected integral structure, and the circuit units of the (N+2)-th unit column and the (N+3)-th unit column share the same first via V1.

In an exemplary embodiment, since the seventh active layers 27 of two circuit units adjacent in the first direction X are of an interconnected integral structure, the two circuit units share the same seventh via V7 as the seventh active via. For example, the seventh active layers 37 of the (N+1)-th unit column and the (N+2)-th unit column may be of an interconnected integral structure, and the circuit units of the (N+1)-th unit column and the (N+2)-th unit column share the same seventh via V7.

In an exemplary implementation, the manufacturing process of the display substrate according to this embodiment may include the following operations.

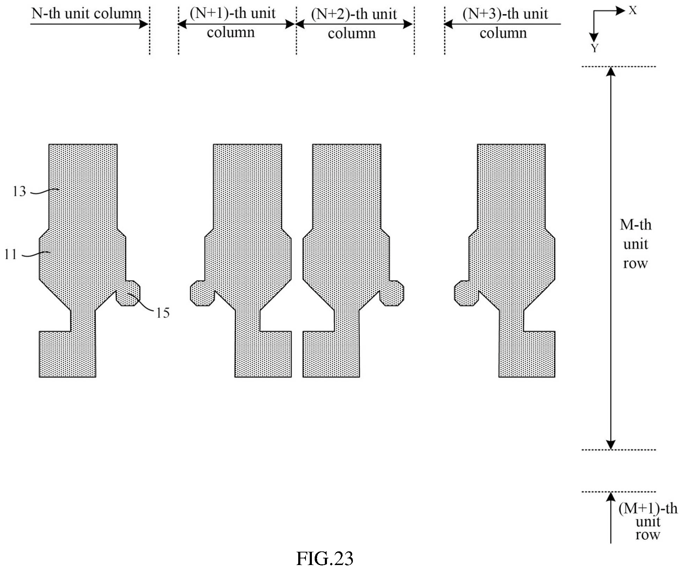

(31) A pattern of a first conductive layer is formed. In an exemplary embodiment, the pattern of the first conductive layer of each circuit unit may at least include the first electrode plate 11 of the first capacitor, the third electrode plate 13 of the second capacitor, and the electrode plate connection block 15, and the above structures are substantially the same as those of the embodiment shown in FIG. 8, except that the shape of the first electrode plate 11 is different, as shown in FIG. 23.

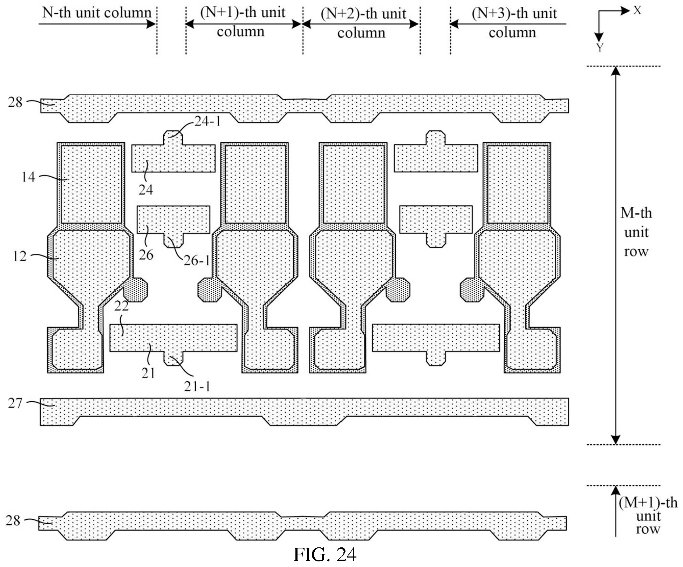

(32) A pattern of a second conductive layer is formed. In an exemplary embodiment, the pattern of the second conductive layer of each circuit unit at least includes a second electrode plate 12 of the first capacitor, a fourth electrode plate 14 of the second capacitor, a first bottom gate electrode 21, a second bottom gate electrode 22, a fourth bottom gate electrode 24, a sixth bottom gate electrode 26, a first shelter line 27, and a second shelter line 28. the above structures are substantially the same as those of the embodiment shown in FIG. 8, except that the shape of the second electrode plate 12 is different, as shown in FIG. 24.

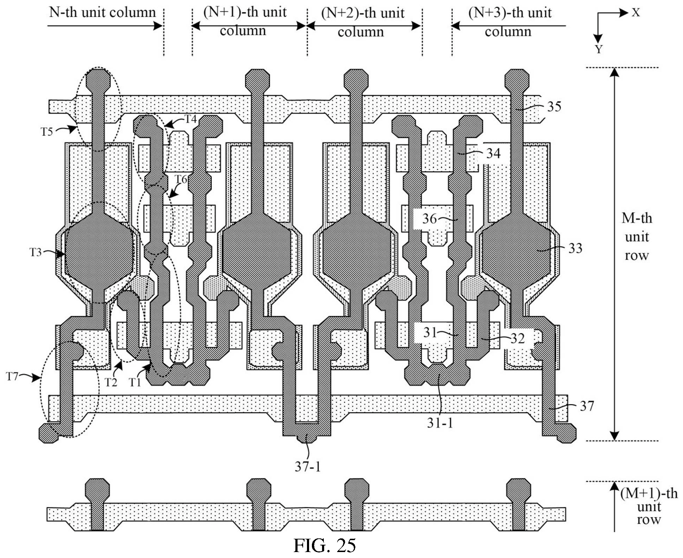

(33) A pattern of a semiconductor layer is formed. In an exemplary embodiment, the pattern of the semiconductor layer of each circuit unit may include a first active layer 31, a second active layer 32, a third active layer 33, a fourth active layer 34, a fifth active layer 35, a sixth active layer 36, and a seventh active layer 37, and the above structures are substantially the same as those of the embodiment shown in FIG. 8, except that active layers of some adjacent circuit units are of an interconnected integral structure, as shown in FIG. 25.

In an exemplary embodiment, the first regions 31-1 of the first active layers of some circuit units adjacent in the first direction X may be connected to each other, so that the first active layers 31 of some circuit units adjacent in the first direction X are of an interconnected integral structure. For example, first active layers 31 of the N-th unit column and the (N+1)-th unit column may be formed into an interconnected integral structure. For another example, first active layer 31 of the (N+2)-th unit column and the (N+3)-th unit column may be formed into an interconnected integral structure.

In an exemplary embodiment, since the first active layer 31, the second active layer 32, the fourth active layer 34, and the sixth active layer 36 in the circuit unit are of an interconnected integral structure, the first active layers 31, the second active layers 32, the fourth active layers 34, and the sixth active layers 36 of some circuit units adjacent in the first direction X are of an interconnected integral structure.

In an exemplary embodiment, the first regions 37-1 of the seventh active layers of some circuit units adjacent in the first direction X may be connected to each other, so that the seventh active layers 37 of some circuit units adjacent in the first direction X are of an interconnected integral structure. For example, seventh active layers 37 of the (N+1)-th unit column and the (N+2)-th unit column may be of an interconnected integral structure.

In an exemplary embodiment, since the third active layer 33, the fifth active layer 35, and the seventh active layer 37 in the circuit unit are of an interconnected integral structure, the third active layers 33, the fifth active layers 35, and the seventh active layers 37 of some circuit units adjacent in the first direction X are of an interconnected integral structure.

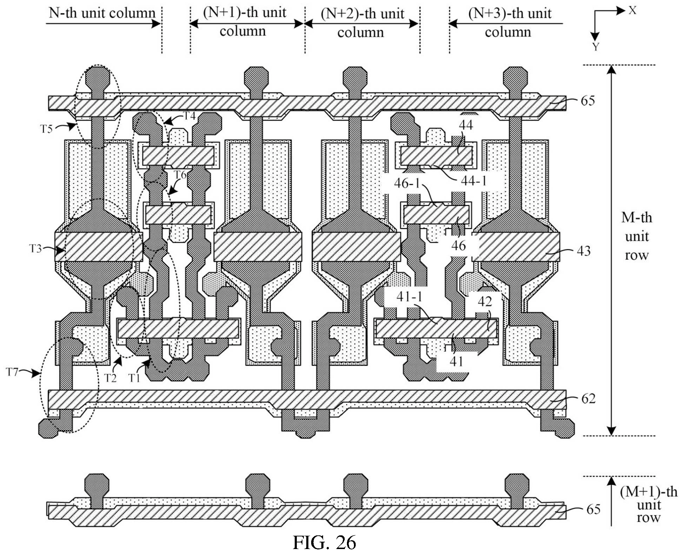

(34) A pattern of a third conductive layer is formed. In an exemplary embodiment, the pattern of the third conductive layer of each circuit unit at least includes a first top gate electrode 41, a second top gate electrode 42, a third top gate electrode 43, a fourth top gate electrode 44, a sixth top gate electrode 46, a second scan signal line 62, and a light emitting signal line 65, and the above structures are substantially the same as those of the embodiment shown in FIG. 8, as shown in FIG. 26.

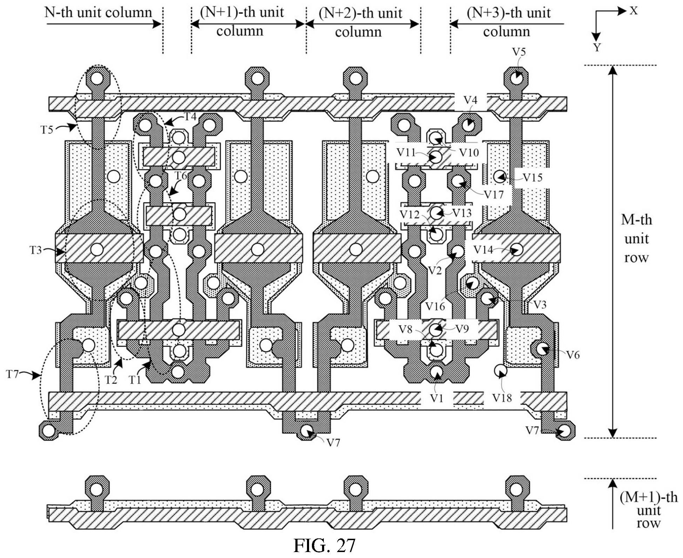

(35) A pattern of a fourth insulation layer is formed. In an exemplary embodiment, a plurality of vias on the fourth insulation layer covering the third conductive layer may at least include a first via V1 to an eighteenth via V18, and the above-described via structure is substantially the same as that of the embodiment shown in FIG. 8, except that some adjacent circuit units share a same active via, as shown in FIG. 27.

In an exemplary embodiment, since the first active layers of two circuit units adjacent in the first direction X are of an interconnected integral structure, the two circuit units share the same first via V1 as the first active via, which can effectively reduce the occupied space of the pixel drive circuits, and is beneficial to the compression of the circuit units. For example, the circuit units of the N-th unit column and the (N+1)-th unit column share the same first via V1. As another example, the circuit units of the (N+2)-th unit column and the (N+3)-th unit column share the same first via V1.

In an exemplary embodiment, since the seventh active layers of two circuit units adjacent in the first direction X are of an interconnected integral structure, the two circuit units share the same seventh via V7 as the seventh active via, which can effectively reduce the occupied space of the pixel drive circuits, and is beneficial to compression of the circuit units. For example, the circuit units of the (N+1)-th unit column and the (N+2)-th unit column share the same seventh via V7.

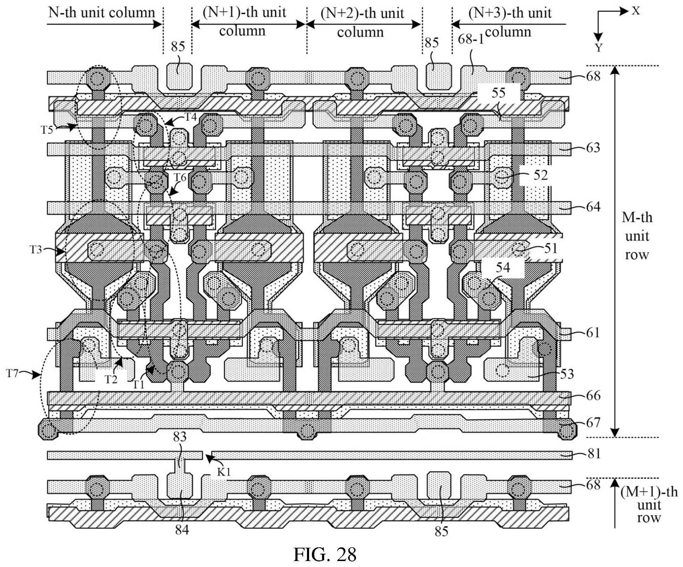

(36) A pattern of a fourth conductive layer is formed. In an exemplary embodiment, the fourth conductive layer of each circuit unit at least includes a first connection electrode 51, a second connection electrode 52, a third connection electrode 53, a fourth connection electrode 54, a fifth connection electrode 55, a first scan signal line 61, a third scan signal line 63, a fourth scan signal line 64, a reference signal line 66, an initial signal line 67, and a first power supply connection line 68, and the above structures are substantially the same as those of the embodiment shown in FIG. 8, as shown in FIG. 28.

In an exemplary embodiment, the reference signal line 66 is connected to first regions of the first active layers of two circuit units through the first via V1 shared by the two circuit units, thus, it is achieved that the reference signal line 66 can write a reference signal to the first electrodes of the first transistors T1 and the first electrodes of the second transistors T2 of the two circuit units at the same time.

In an exemplary embodiment, the initial signal line 67 is connected to the first regions of the seventh active layers in two circuit units through the seventh via V7 shared by the two circuit units, thus, it is achieved that the initial signal line 67 can write an initial signal to the first electrodes of the seventh transistors T7 of the two circuit units.

In an exemplary embodiment, structures such as the first data connection line 81, the first fracture K1, the data connection block 83, the data connection electrode 84, and the dummy electrode 85 are substantially the same as those of the embodiment shown in FIG. 8.

(37) A pattern of a first planarization layer and a pattern of a fifth conductive layer are sequentially formed, and the via structure on the first planarization layer and the structure of the fifth conductive layer are substantially the same as those of the embodiment shown in FIG. 8, which will not be described further here.

The display substrate provided by the present embodiment, not only has the technical effect of the display substrate shown in FIG. 8, but also make two circuit units share the same active via by providing the active layers of some adjacent circuit units as an interconnected integral structure, which can effectively reduce the occupied space of the pixel drive circuits, and is beneficial to compression of the circuit units.

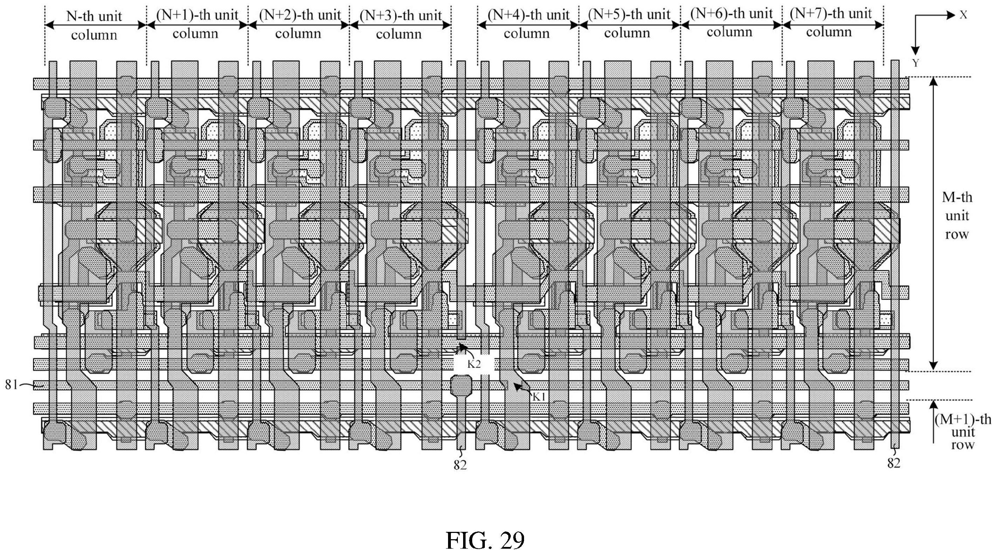

FIG. 29 is a schematic diagram of a structure of another display substrate according to an exemplary embodiment of the present disclosure, is an enlarged view of the region A in FIG. 7B, and schematically illustrates the structure of circuit units in one circuit row and eight circuit columns, wherein pixel drive circuits in the circuit unit are a non-mirror structure.

As shown in FIG. 29, in an exemplary embodiment, a plurality of circuit units on the display substrate may be compressed to obtain a trace space in lateral compression and longitudinal compression manners, and the trace space is configured to accommodate the first data connection line 81 and the second data connection line 82. Herein, four unit columns may be set as a group to be compressed to obtain one vertical trace space in a lateral compression manner, that is, a second data connection line 82 is provided every four unit columns. Two unit rows may be set as a group to be compressed to obtain one lateral trace space in a longitudinal compression manner, that is, a first data connection line 81 is provided every two unit rows.

In an exemplary implementation, the manufacturing process of the display substrate according to this embodiment may include the following operations.

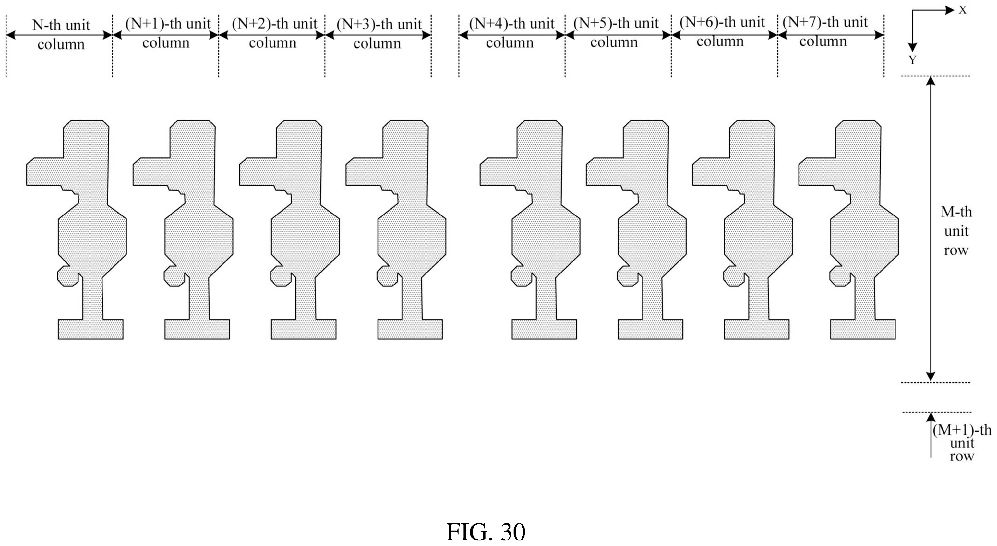

(41) A pattern of a first conductive layer is formed. The pattern of the first conductive layer of each circuit unit may at least include a first electrode plate of a first capacitor, a third electrode plate of a second capacitor, and an electrode plate connection block, as shown in FIG. 30.

In an exemplary embodiment, first conductive layers in adjacent unit columns may be substantially the same, and first conductive layers in adjacent unit rows may be substantially the same.

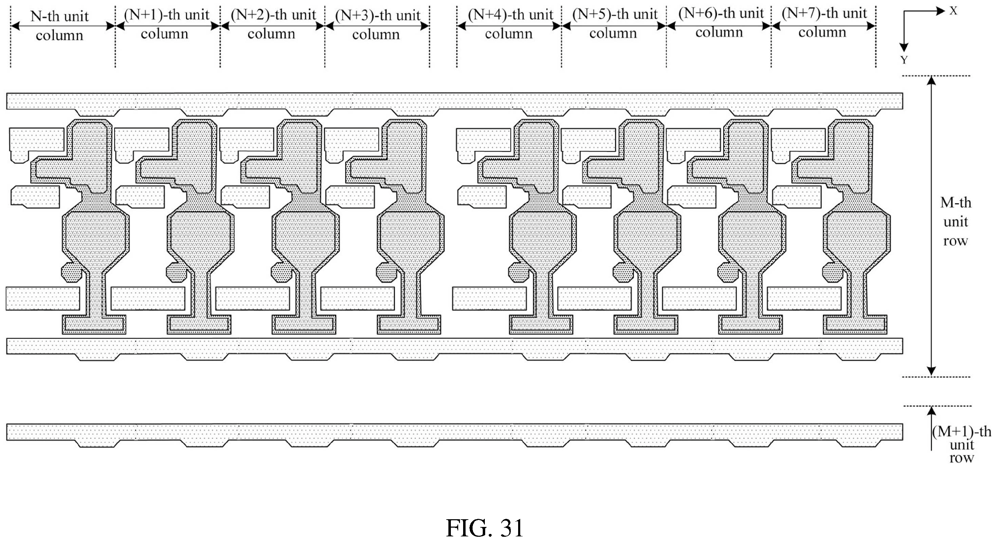

(42) A pattern of a second conductive layer is formed. The pattern of the second conductive layer of each circuit unit may at least include a second electrode plate of the first capacitor, a fourth electrode plate of the second capacitor, a first bottom gate electrode, a second bottom gate electrode, a fourth bottom gate electrode, a sixth bottom gate electrode, a first shelter line, and a second shelter line, as shown in FIG. 31.

In an exemplary embodiment, second conductive layers in adjacent unit columns may be substantially the same, and second conductive layers in adjacent unit rows may be substantially the same.

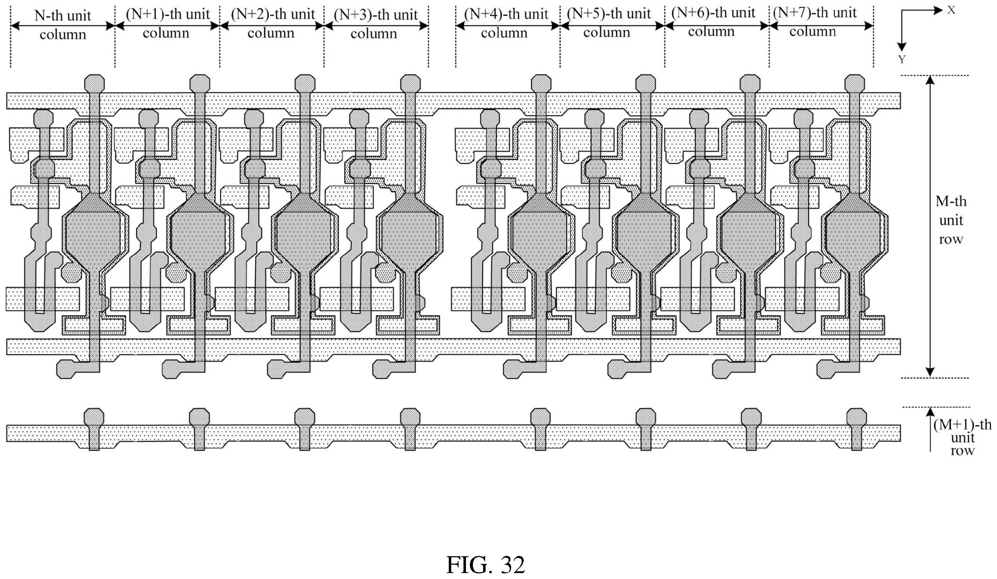

(43) A pattern of a semiconductor layer is formed. The pattern of the semiconductor layer of each circuit unit may at least include a first active layer, a second active layer, a third active layer, a fourth active layer, a fifth active layer, a sixth active layer, and a seventh active layer, as shown in FIG. 32.

In an exemplary embodiment, semiconductor layers in adjacent unit columns may be substantially the same, and semiconductor layers in adjacent unit rows may be substantially the same.

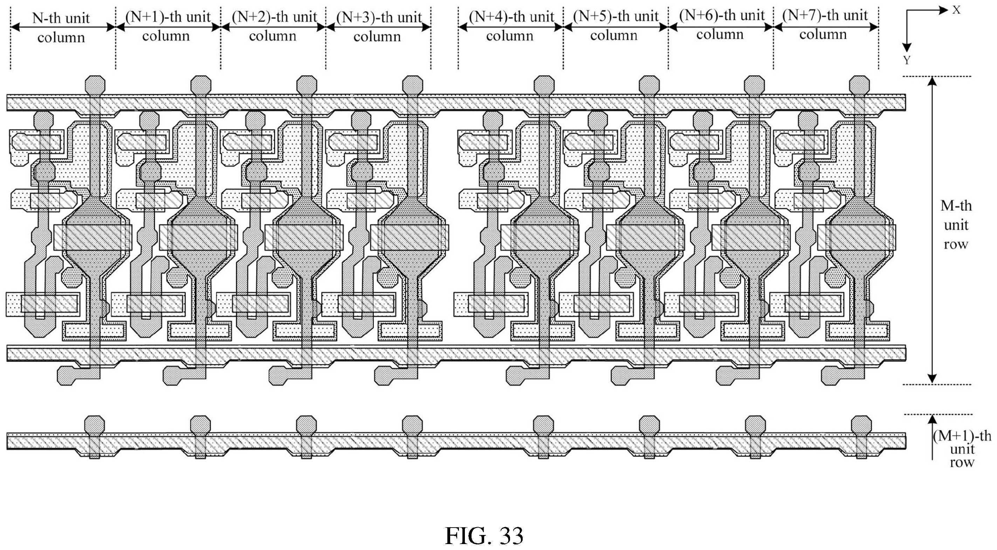

(34) A pattern of a third conductive layer is formed. The pattern of the third conductive layer of each circuit unit may at least include a first top gate electrode, a second top gate electrode, a third top gate electrode, a fourth top gate electrode, a sixth top gate electrode, a second scan signal line, and a light emitting signal line, as shown in FIG. 33.

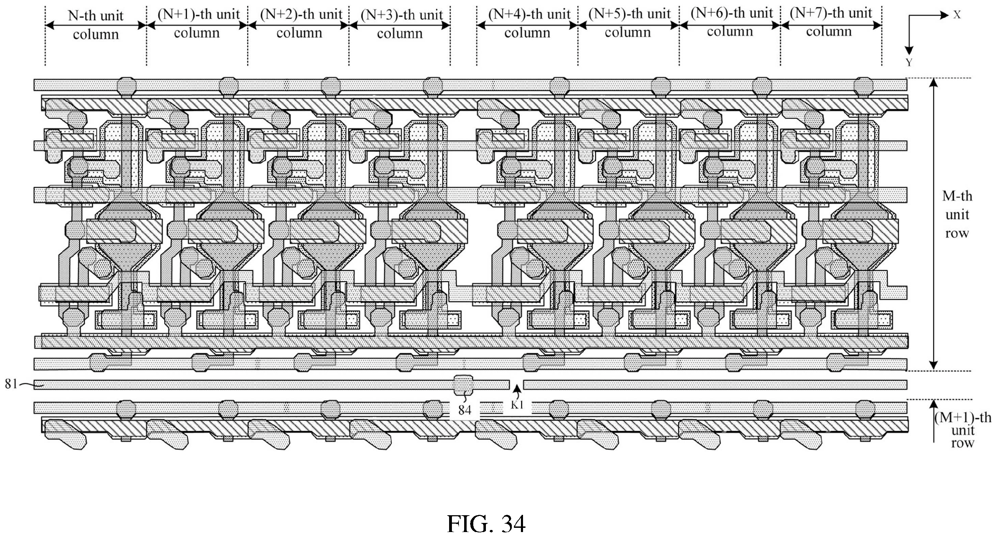

(35) A pattern of a fourth insulation layer and a pattern of a fourth conductive layer are formed. The fourth insulation layer of each circuit unit includes a plurality of vias, and the fourth conductive layer of each circuit unit at least includes a first connection electrode, a second connection electrode, a third connection electrode, a fourth connection electrode, a fifth connection electrode, a first scan signal line, a third scan signal line, a fourth scan signal line, a reference signal line, an initial signal line, and a first power supply connection line, as shown in FIG. 34.

In an exemplary embodiment, the fourth conductive layer of the at least one circuit unit may further include a first data connection line 81, and a data connection electrode 84 and a first fracture K1 may be provided on the first data connection line 81.

In an exemplary embodiment, the fourth conductive layers (except for the first data connection lines and the data connection electrodes) in adjacent unit columns may be substantially the same, and the fourth conductive layers (except for the first data connection lines and the data connection electrodes) in adjacent unit rows may be substantially the same.

(36) A pattern of a first planarization layer and a pattern of a fifth conductive layer are formed. The first planarization layer of each circuit unit includes a plurality of vias, and the fifth conductive layer may include at least: a first power supply line, a second power supply line, a data signal line, and an anode connection electrode, as shown in FIG. 29.

In an exemplary embodiment, the fifth conductive layer of at least one circuit unit may further include a second data connection line 82, the second data connection line 82 may be disposed between the first power supply line and the data signal line adjacent in the first direction X, and the second data connection line 82 may be connected to the data connection electrode through a via.

In an exemplary embodiment, at least one second data connection line 82 may be provided with a second fracture K2, and the second fracture K2 may sever the second data connection line 82.

In an exemplary embodiment, an orthographic projection of the at least one second fracture K2 on the base substrate is at least partially overlapped with an orthographic projection of the at least one reference signal line on the base substrate, or an orthographic projection of the at least one second fracture K2 on the base substrate is at least partially overlapped with an orthographic projection of the at least one initial signal line on the base substrate.

In an exemplary embodiment, an orthographic projection of the at least one first power supply line on the base substrate is at least partially overlapped with an orthographic projection of the first fracture K1 on the base substrate, or an orthographic projection of the at least one second power supply line on the base substrate may include an orthographic projection of the first fracture K1 on the base substrate.

The present embodiment provides a display substrate employing a pixel drive circuit in a non-mirror structure, and the display substrate also has the technical effect of the display substrate shown in FIG. 8.

The structure shown and mentioned above in the present disclosure and the manufacturing process therefor are merely an exemplary description. In an exemplary implementation, the corresponding structures may be altered and the patterning processes may be added or reduced according to actual needs. For example, the first fracture on the first data connection line may be disposed below the anode, and an orthographic projection of the first fracture on the base substrate may be located within a range of an orthographic projection of the anode on the base substrate, and the anode is used to shelter the first fracture to eliminate the difference of film layers of different regions. For another example, the second fracture on the second data connection line may be disposed below the anode, and an orthographic projection of the second fracture on the base substrate may be located within a range of an orthographic projection of the anode on the base substrate, and the anode is used to shelter the second fracture to eliminate the difference of film layers of different regions. For another example, the first fracture and the second fracture are both disposed below the anode, which is not limited here in the present disclosure.

In an exemplary embodiment, the display substrate according to the present disclosure may be applied to a display apparatus with a pixel drive circuit, such as an OLED, quantum dot display (QLED), light emitting diode display (Micro LED or Mini LED), or Quantum Dot Light Emitting Diode display (QDLED), which is not limited here in the present disclosure.

The present disclosure further provides a manufacturing method for a display substrate, for manufacturing the display substrate according to the foregoing embodiments. In an exemplary embodiment, the display substrate includes a plurality of circuit units, a plurality of data signal lines extending along a second direction, a plurality of first data connection lines extending along a first direction, and a plurality of second data connection lines extending along the second direction, one end of at least one first data connection line is connected to a data signal line of the plurality of data signal lines, and the other end of the at least one first data connection line is connected to a second data connection line of the plurality of second data connection lines, the first direction and the second direction intersect.

The manufacturing method may include: forming a pixel drive circuit within at least one circuit unit, wherein the pixel drive circuit at least includes a drive transistor, a first reset transistor, a data writing transistor, a light emitting control transistor, a first capacitor including a first electrode plate and a second electrode plate, and a second capacitor including a third electrode plate and a fourth electrode plate. A first electrode of the first reset transistor is connected to a reference signal line, a second electrode of the first reset transistor is connected to a gate electrode of the drive transistor, a first electrode of the light emitting control transistor is connected to a first power supply line, a second electrode of the light emitting control transistor is connected to a first electrode of the drive transistor, a second electrode of the drive transistor is connected to the second electrode plate of the first capacitor, a first electrode of the data writing transistor is connected to the data signal line, a second electrode of the data writing transistor is connected to the fourth electrode plate of the second capacitor, the first electrode plate of the first capacitor is connected with the third electrode plate of the second capacitor; the drive transistor is an oxide transistor, and a width-to-length ratio of the drive transistor is 1.25 to 2.67.

A display apparatus which includes the aforementioned display substrate is also provided in the present disclosure. The display apparatus may be any product or component with a display function, such as a mobile phone, a tablet computer, a television, a display, a laptop computer, a digital photo frame, and a navigator, which is not limited in the embodiments of the present invention.

Although embodiments disclosed in the present disclosure are as above, it should be noted that the above embodiments are exemplary only rather than restrictive. Therefore, the present disclosure is not limited to what is specifically shown and described here. Various modifications, substitutions, or omissions may be made in forms and details of implementations without departing from the scope of the present disclosure.

## Claims

1. A display substrate, comprising a plurality of circuit units, a plurality of data signal lines extending along a second direction, a plurality of first data connection lines extending along a first direction, and a plurality of second data connection lines extending along the second direction, wherein one end of at least one first data connection line is connected to a data signal line of the plurality of data signal lines, and the other end of the at least one first data connection line is connected to a second data connection line of the plurality of second data connection lines, the first direction and the second direction intersect; at least one circuit unit comprises a pixel drive circuit at least comprising a drive transistor, a first reset transistor, a data writing transistor, a light emitting control transistor, a first capacitor comprising a first electrode plate and a second electrode plate, and a second capacitor comprising a third electrode plate and a fourth electrode plate; a first electrode of the first reset transistor is connected to a reference signal line, a second electrode of the first reset transistor is connected to a gate electrode of the drive transistor, a first electrode of the light emitting control transistor is connected to a first power supply line, a second electrode of the light emitting control transistor is connected to a first electrode of the drive transistor, a second electrode of the drive transistor is connected to the second electrode plate of the first capacitor, a first electrode of the data writing transistor is connected to the data signal line, a second electrode of the data writing transistor is connected to the fourth electrode plate of the second capacitor, the first electrode plate of the first capacitor is connected with the third electrode plate of the second capacitor; the drive transistor is an oxide transistor, and a width-to-length ratio of the drive transistor is 1.25 to 2.67.

2. The display substrate according to claim 1, wherein an orthographic projection of the data signal line on a base substrate is not overlapped with orthographic projections of channel regions of the drive transistor, the first reset transistor, the data writing transistor, and the light emitting control transistor on the base substrate.

3. The display substrate according to claim 1, wherein in the at least one circuit unit, the data signal line comprises at least one straight line segment, and at least one bending segment configured to increase an extension length of the data signal line.

4. The display substrate according to claim 1, wherein at least one second data connection line is disposed between two first power supply lines adjacent in the first direction, or at least one second data connection line is disposed between two data signal lines adjacent in the first direction.

5. The display substrate according to claim 1, wherein, in at least one circuit unit and a circuit unit adjacent to the at least one circuit unit in the first direction, first power supply lines of two circuit units are of an interconnected integral structure.

6. The display substrate according to claim 1, wherein the at least one circuit unit further comprises a first power supply connection line extending along the first direction, the first power supply line is in a shape of a straight line or a bend line extending along the second direction, and the first power supply line is connected to the first power supply connection line to form a net-like structure for transmitting a first power supply signal.

7. The display substrate according to claim 1, wherein the at least one circuit unit further comprises a second power supply line having a width larger than a width of the first power supply line, wherein the width is a dimension in the first direction.

8. The display substrate according to claim 7, wherein the display substrate further comprises a plurality of auxiliary cathodes disposed on a side of the second power supply line away from a base substrate, an orthographic projection of at least one auxiliary cathode on the base substrate is at least partially overlapped with an orthographic projection of the second power supply line on the base substrate, the auxiliary cathode is connected to the second power supply line through an auxiliary via, and the auxiliary cathode is configured to be connected to a cathode of a light emitting device.

9. The display substrate according to claim 7, wherein an orthographic projection of the first power supply line on a base substrate is at least partially overlapped with orthographic projections of the first reset transistor and the data writing transistor on the base substrate, and an orthographic projection of the second power supply line on the base substrate is at least partially overlapped with orthographic projections of the drive transistor and the light emitting control transistor on the base substrate.

10. The display substrate according to claim 1, wherein the at least one circuit unit further comprises a data connection electrode connected to the first data connection line, the second data connection line is connected to the data connection electrode through a via; the at least one circuit unit further comprises a dummy electrode to which the second data connection line is connected through a via, and a position and a shape of the dummy electrode in one circuit unit is the same as a position and a shape of the data connection electrode in another circuit unit.

11. The display substrate according to claim 1, wherein in a direction perpendicular to a base substrate, the display substrate at least comprises a first source-drain metal layer and a second source-drain metal layer sequentially disposed along a direction away from the base substrate, the first data connection line is disposed in the first source-drain metal layer; a first fracture is provided on at least one first data connection line, the first fracture severs the at least one first data connection line, and an orthographic projection of the first fracture on the base substrate is at least partially overlapped with an orthographic projection of the second source-drain metal layer on the base substrate.

12. The display substrate according to claim 1, wherein in a direction perpendicular to a base substrate, the display substrate at least comprises a first source-drain metal layer and a second source-drain metal layer sequentially disposed along a direction away from the base substrate, the second data connection line is disposed in the second source-drain metal layer; a second fracture is provided on at least one second data connection line, the second fracture severs the at least one second data connection line, and an orthographic projection of the second fracture on the base substrate is at least partially overlapped with an orthographic projection of the first source-drain metal layer on the base substrate.

13. The display substrate according to any one of claims 1 to 12, wherein the pixel drive circuit further comprises a second reset transistor, a third reset transistor, and a data control transistor; a first electrode of the second reset transistor is connected to the reference signal line, and a second electrode of the second reset transistor is connected to the first electrode plate of the first capacitor and the third electrode plate of the second capacitor; a first electrode of the third reset transistor is connected to an initial signal line, and a second electrode of the third reset transistor is connected to the second electrode of the drive transistor; a first electrode of the data control transistor is connected to the gate electrode of the drive transistor, and a second electrode of the data control transistor is connected to the second electrode of the data writing transistor; the first reset transistor, the second reset transistor, the third reset transistor, the data writing transistor, the light emitting control transistor and the data control transistor are oxide transistors.

14. The display substrate according to claim 13, wherein the first reset transistor at least comprises a first bottom gate electrode and a first top gate electrode, in at least one circuit unit and a circuit unit adjacent to the at least one circuit unit in the first direction, first bottom gate electrodes in two circuit units are of an interconnected integral structure, and first top gate electrodes in the two circuit units are of an interconnected integral structure; and/or, the data writing transistor at least comprises a fourth bottom gate electrode and a fourth top gate electrode, in at least one circuit unit and a circuit unit adjacent to the at least one circuit unit in the first direction, fourth bottom gate electrodes in two circuit units are of an interconnected integral structure, and fourth top gate electrodes in the two circuit units are of an interconnected integral structure; and/or the data control transistor at least comprises a sixth bottom gate electrode and a sixth top gate electrode, in at least one circuit unit and a circuit unit adjacent to the at least one circuit unit in the first direction, sixth bottom gate electrodes in two circuit units are of an interconnected integral structure, and sixth top gate electrodes in the two circuit units are of an interconnected integral structure.

15. The display substrate according to claim 14, wherein a first bottom gate connection block is provided on the first bottom gate electrode, a first top gate connection block is provided on the first top gate electrode, the first bottom gate connection block is configured to be connected to a first scan signal line through a first bottom gate connection via, and the first top gate connection block is configured to be connected to the first scan signal line through a first top gate connection via, in at least one circuit unit and a circuit unit adjacent to the at least one circuit unit in the first direction, two circuit units share the first bottom gate connection via, and the two circuit units share the first top gate connection via; and/or,
a fourth bottom gate connection block is provided on the fourth bottom gate electrode, a fourth top gate connection block is provided on the fourth top gate electrode, the fourth bottom gate connection block is configured to be connected to a third scan signal line through a fourth bottom gate connection via, the fourth top gate connection block is configured to be connected to the third scan signal line through a fourth top gate connection via, in at least one circuit unit and a circuit unit adjacent to the at least one circuit unit in the first direction, two circuit units share the fourth bottom gate connection via, and two circuit units share the fourth top gate connection via; and/or,
a sixth bottom gate connection block is provided on the sixth bottom gate electrode, a sixth top gate connection block is provided on the sixth top gate electrode, the sixth bottom gate connection block is configured to be connected to a fourth scan signal line through a sixth bottom gate connection via, the sixth top gate connection block is configured to be connected to the fourth scan signal line through a sixth top gate connection via, in at least one circuit unit and a circuit unit adjacent to the at least one circuit unit in the first direction, two circuit units share the sixth bottom gate connection via, and two circuit units share the sixth top gate connection via.

16. The display substrate according to claim 13, wherein the second reset transistor at least comprises a second bottom gate electrode and a second top gate electrode, and in at least one circuit unit, a first bottom gate electrode and the second bottom gate electrode are of an interconnected integral structure, and a first top gate electrode and the second top gate electrode are of an interconnected integral structure.

17. The display substrate according to claim 13, wherein the first reset transistor at least comprises a first active layer, and in at least one circuit unit and a circuit unit adjacent to the at least one circuit unit in the first direction, first active layers in two circuit units are of an interconnected integral structure.

18. The display substrate according to claim 17, wherein the reference signal line is connected to a first region of the first active layer through a first active via, and in at least one circuit unit and a circuit unit adjacent to the at least one circuit unit in the first direction, two circuit units share the first active via.

19. The display substrate according to claim 13, wherein the third reset transistor at least comprises a seventh active layer, and in at least one circuit unit and a circuit unit adjacent to the at least one circuit unit in the first direction, seventh active layers in two circuit units are of an interconnected integral structure.

20. The display substrate according to claim 19, wherein the initial signal line is connected to a first region of the seventh active layer through a seventh active via, and in at least one circuit unit and a circuit unit adjacent to the at least one circuit unit in the first direction, two circuit units share the seventh active via.

21. A display apparatus, comprising the display substrate according to any one of claims 1 to 20.

22. A manufacturing method for a display substrate, wherein the display substrate comprises a plurality of circuit units, a plurality of data signal lines extending along a second direction, a plurality of first data connection lines extending along a first direction, and a plurality of second data connection lines extending along the second direction, one end of at least one first data connection line is connected to a data signal line of the plurality of data signal lines and the other end of the at least one first data connection line is connected to a second data connection line of the plurality of second data connection lines, the first direction and the second direction intersect; the manufacturing method comprises:
forming a pixel drive circuit within at least one circuit unit, wherein the pixel drive circuit at least comprises a drive transistor, a first reset transistor, a data writing transistor, a light emitting control transistor, a first capacitor comprising a first electrode plate and a second electrode plate, and a second capacitor comprising a third electrode plate and a fourth electrode plate; a first electrode of the first reset transistor is connected to a reference signal line, a second electrode of the first reset transistor is connected to a gate electrode of the drive transistor, a first electrode of the light emitting control transistor is connected to a first power supply line, a second electrode of the light emitting control transistor is connected to a first electrode of the drive transistor, a second electrode of the drive transistor is connected to the second electrode plate of the first capacitor, a first electrode of the data writing transistor is connected to the data signal line, a second electrode of the data writing transistor is connected to the fourth electrode plate of the second capacitor, the first electrode plate of the first capacitor is connected with the third electrode plate of the second capacitor; the drive transistor is an oxide transistor, and a width-to-length ratio of the drive transistor is 1.25 to 2.67.
